# EUROPEAN PATENT SPECIFICATION

(11) **EP 1 329 956 B1**
(45) Date of publication and mention of the grant of the patent: **26.03.2008**
(21) Application number: 03000642.3
(22) Date of filing: 16.01.2003
(51) Int. Cl.: H01L 27/088, H01L 21/8234, H01L 29/417, H01L 29/78

(54) **Semiconductor device and its manufacturing method**
Halbleiter-Bauelement und Herstellungsverfahren
Dispositif semi-conducteur et son procédé de fabrication

(30) Priority: 16.01.2002 JP 2002008015; 16.10.2002 JP 2002302136
(43) Date of publication of application: 23.07.2003
(73) Proprietor: FUJI ELECTRIC CO., LTD., Kawasaki-shi, Kanagawa 210-0856 (JP)
(72) Inventor: Sugi, Akio, Kawasaki-ku, Kawasaki 210-0856 (JP); Fujishima, Naoto, Kawasaki-ku, Kawasaki 210-0856 (JP); Kitamura, Mutsumi, Kawasaki-ku, Kawasaki 210-0856 (JP); Tabuchi, Katsuya, Kawasaki-ku, Kawasaki 210-0856 (JP); Wakimoto, Setsuko, Kawasaki-ku, Kawasaki 210-0856 (JP)
(74) Representative: Hoffmann, Eckart

(56) References cited:
- WO-A-00/52760
- WO-A-01/41187
- DE-A- 10 211 690
- DE-A- 19 720 193
- US-A- 5 250 450
- US-A- 5 701 026
- US-A- 5 903 034
- US-B1- 6 316 807
- PATENT ABSTRACTS OF JAPAN vol. 2000, no. 06, 22 September 2000 (2000-09-22) -& JP 2000 077532 A (MITSUBISHI ELECTRIC CORP), 14 March 2000 (2000-03-14) -& US 6 359 318 B1 (TERASHIMA TOMOHIDE ET AL) 19 March 2002 (2002-03-19)
- SHEKAR M S ET AL: "Hot electron degradation and unclamped inductive switching in submicron 60-V lateral DMOS" RELIABILITY PHYSICS SYMPOSIUM PROCEEDINGS, 1998. 36TH ANNUAL. 1998 IEEE INTERNATIONAL RENO, NV, USA 31 MARCH-2 APRIL 1998, NEW YORK, NY, USA,IEEE, US, 31 March 1998 (1998-03-31), pages 383-390, XP010275485 ISBN: 0-7803-4400-6
- PATENT ABSTRACTS OF JAPAN vol. 018, no. 372 (E-1577), 13 July 1994 (1994-07-13) -& JP 06 104446 A (TOSHIBA CORP), 15 April 1994 (1994-04-15)
- PATENT ABSTRACTS OF JAPAN vol. 1996, no. 08, 30 August 1996 (1996-08-30) -& JP 08 088283 A (FUJI ELECTRIC CO LTD), 2 April 1996 (1996-04-02)
- FUJISHIMA N ET AL: "A low on-resistance trench lateral power MOSFET in a 0.6/spl mu/m smart power technology for 20-30 V applications" INTERNATIONAL ELECTRON DEVICES MEETING 2002. IEDM. TECHNICAL DIGEST. SAN FRANCISCO, CA, DEC. 8 - 11, 2002, NEW YORK, NY: IEEE, US, 8 December 2002 (2002-12-08), pages 455-458, XP010626081 ISBN: 0-7803-7462-2

## Description

### BACKGROUND OF THE INVENTION

### Field of the Invention

The present invention relates to a semiconductor manufacturing method. In particular, the invention relates to method of manufacturing a semiconductor device in which trench lateral power MOSFETs and planar devices such as planar MOSFETs are integrated on the same semiconductor substrate.

### 2. Description of the Related Art

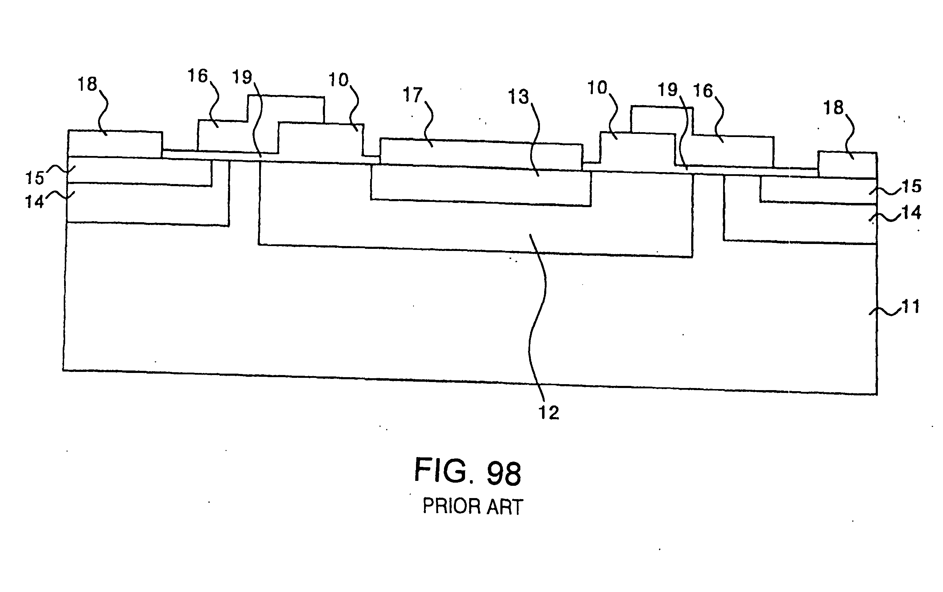

In power MOSFETs, in general, an extended drain region is formed to increase the breakdown voltage. FIG. 98 is a vertical sectional view showing the configuration of a conventional n-channel planar power MOSFET. As shown in FIG. 98, an n-type extended drain region 12 is provided between gate electrodes 16 of adjoining devices that share an n-type drain region 13 and a drain electrode 17, to extend parallel with the surface of a p-type semiconductor substrate 11 and surround the drain region 13. P-type base regions 14, n-type source regions 15, and source electrodes 18 are separated by placement on both sides of the extended drain region 12.

The gate electrodes 16 extend to cover a thick field oxide film 10 that is continuous with a gate oxide film 19 and serve as field plates. It is noted that in this specification the term "planar device" does not include power devices such as the planar power MOSFET.

The planar power MOSFET is manufactured by approximately the same process as planar devices such as BiCMOS. Therefore, a one-chip power IC is readily obtained by forming planar power MOSFETs and planar devices on the same semiconductor substrate. However, such a one-chip power IC including planar power MOSFETs and planar devices has a disadvantage of a low integration density because, as described above, the extended drain region 12 extends parallel with the substrate surface in the planar power MOSFET.

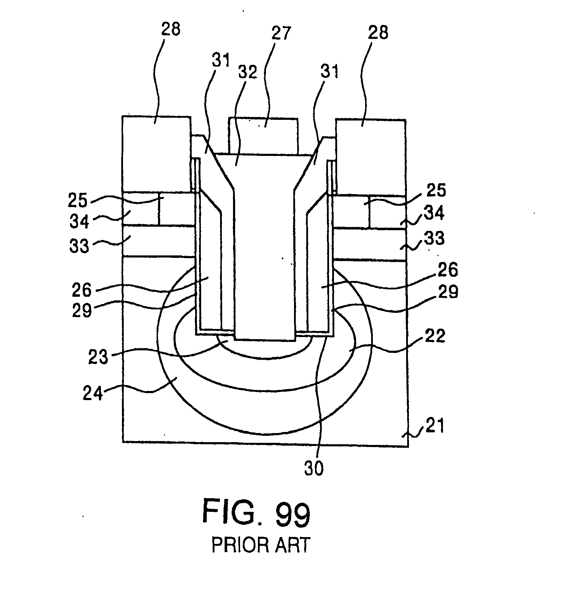

In view of the above, a trench lateral power MOSFET (hereinafter abbreviated as "TLPM") has been proposed which is advantageous since the on-resistance per unit area is lower than the planar power MOSFET. FIG. 99 is a vertical sectional view showing the configuration of a conventional n-channel TLPM. A trench 30 is formed in a p-type semiconductor substrate 21. An n-type extended drain region 22 is provided adjacent to the bottom surface and a bottom portion of the side surface of the trench 30.

A p-type body region 24 is provided outside the extended drain region 22, and an n-type drain region 23 is provided inside the extended drain region 22. Sequentially, a gate oxide film 29, gate electrodes 26, an interlayer insulating film 31, and a drain polysilicon layer 32 are provided inside the trench 30 from the outside. P-type channel regions 33 are provided on both sides of the trench 30, and n-type source regions 25 are provided on the respective p-type channel regions 33. P-type plug regions 34 are provided outside the respective source regions 25. Each source electrode 28 is in contact with both of the associated source region 25 and plug region 34. A drain electrode 27 is electrically connected to the drain region 23 via the drain polysilicon layer 32.

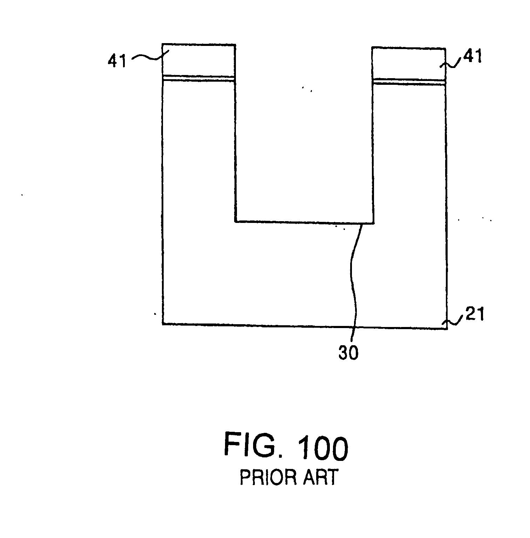

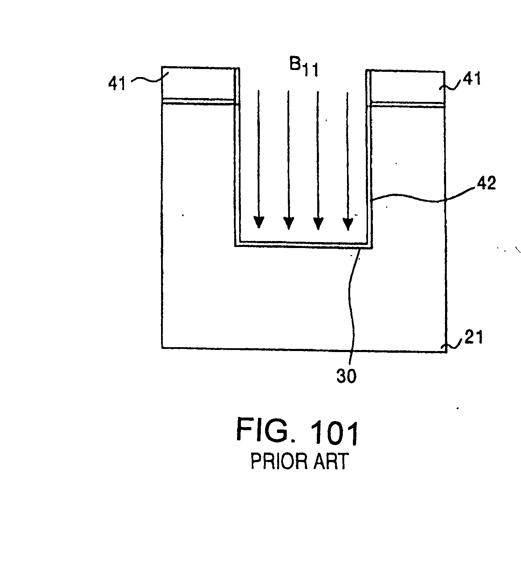

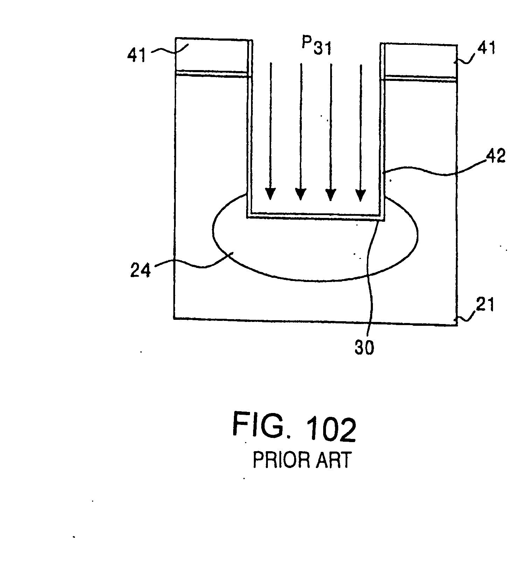

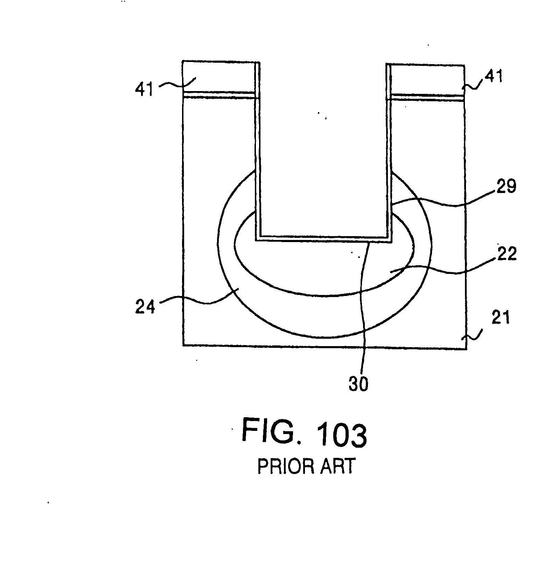

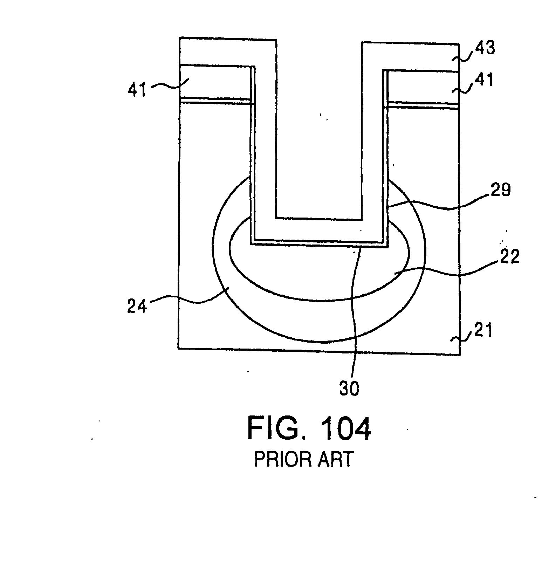

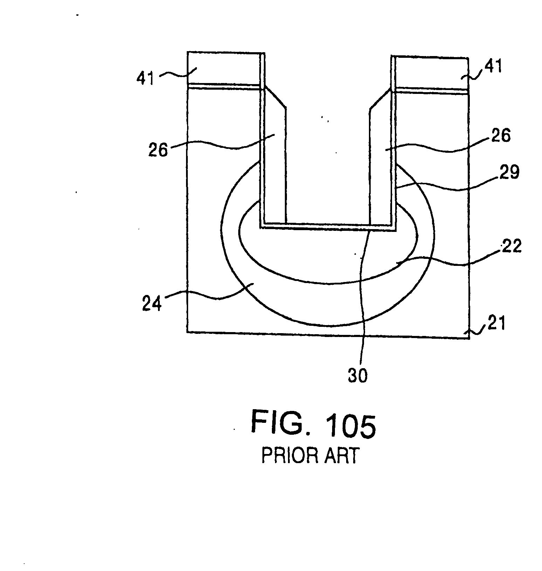

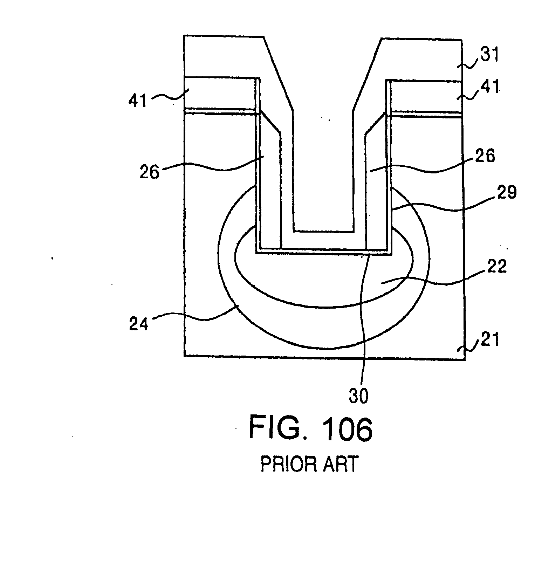

A description of a manufacturing process of the TLPM shown in FIG. 99 follows. FIGS. 100-107 are vertical sectional views showing intermediate states of manufacture of the TLPM of FIG. 99. First, a mask oxide film 41 is formed on the surface of a semiconductor substrate 21, and a trench 30 is formed through an opening of the mask oxide film 41 by RIE (reactive ion etching) (see FIG. 100). After a buffer oxide film 42 is formed on the surface of the trench 30, the semiconductor substrate 21 is doped with B₁₁ (see FIG. 101), whereby a body region 24 is formed. The semiconductor substrate 21 is then doped with P₃₁ (see FIG. 102) to form an extended drain region 22. After removing the buffer oxide film 42, a gate oxide film 29 is formed inside the trench 30 (see FIG. 103).

Subsequently, a polysilicon layer 43 is deposited inside the trench 30 and on the substrate surface (see FIG. 104) and then is etched back to leave only portions (as gate electrodes 26) on both side surfaces of the trench 30 (see FIG. 105). Then, an interlayer insulating film 31 is laid using a film forming method, for example, LPCVD or P-TEOS CVD. The interlayer insulating film 31 is thinner at the bottom of the trench 30 than on the substrate surface (see FIG. 106). The interlayer insulating film 31 is etched back to form a contact hole that penetrates through the interlayer insulating film 31 and the gate oxide film 29 at the bottom of the trench 30.

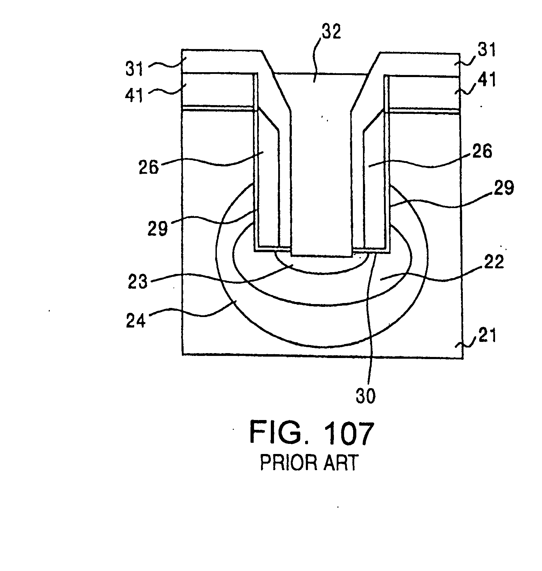

A drain region 23 is formed under the trench 30 through the contact hole that has been formed at the bottom of the trench 30. Then, the central portion of the trench 30 is filled with a drain polysilicon layer 32 (see FIG. 107). Then, contact holes are formed through portions of the interlayer insulating film 31 which cover the substrate surface, and channel regions 33, source regions 25, and plug regions 34 are formed. Finally, source electrodes 28 and a drain electrode 27 are formed by patterning a metal film. A TLPM having the configuration of FIG. 99 is thus completed.

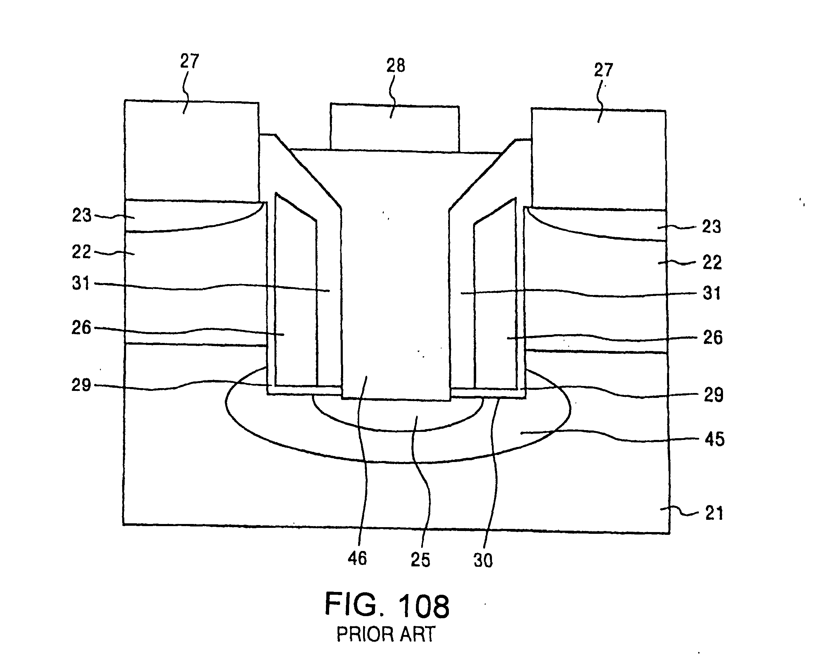

In the above-type (called a "first type") of TLPM, the drain region 23 is provided under the trench 30. Another type (called a "second type") of TLPM is known in which a source region is provided under a trench 30. As shown in FIG. 108, in the second type of TLPM, an n-type source region 25 is provided under a trench 30 that is formed in a p-type semiconductor substrate 21. A p-type base region 45 is provided adjacent to the bottom surface and a bottom portion of the side surface of the trench 30 to surround the source region 25.

N-type extended drain regions 22 are provided on both sides of the trench 30. N-type drain regions 23 are positioned in surface layers of the extended drain regions 22, respectively. A gate oxide film 29, gate electrodes 26, an interlayer insulating film 31, and a source polysilicon layer 46 are positioned sequentially inside the trench 30 from the outside. The source electrode 28 is electrically connected with the source region 25 via the source polysilicon layer 46. Drain electrodes 27 are in contact with the respective drain regions 23.

As described above, in the first type of TLPM, the gate electrodes 26 are provided outside the drain polysilicon layer 32 with the interlayer insulating film 31 interposed between, and the extended drain region 22 is provided outside the gate electrodes 26 with the gate oxide film 29 interposed between. Therefore, in the first type of TLPM, gate-drain feedback capacitance, which is a factor of impairing the switching characteristic, exists not only between the extended drain region 22 and the gate electrodes 26, but also between the drain polysilicon layer 32 and the gate electrodes 26. On the other hand, in the second type of TLPM, gate-drain feedback capacitance exists only between the extended drain regions 22 and the gate electrodes 26. Therefore, the second type of TLPM is advantageous over the first type of TLPM since the switching characteristic is improved greatly.

However, the process that was described above for the first type of TLPM is a process for manufacturing a TLPM itself and is not compatible with manufacturing processes of planar devices such as the general CMOS and the BiCMOS. A manufacturing method of the second type TLPM, which was not described above, is approximately the same as the manufacturing method of the first type TLPM and is not compatible with manufacturing processes of planar devices, for example, the general CMOS and the BiCMOS. Therefore, conventionally, to construct a one-chip power IC using TLPMs and planar devices, TLPMs and planar devices are manufactured by separate processes and are connected to a common printed circuit board by wire bonding to attain electrical connections between the TLPMs and the planar devices.

This causes not only a cost increase, but also disadvantages such as reduction in integration density and an increase in on-resistance by the bonding wire, offsetting the advantages of the TLPM that enable a high integration density and a low on-resistance per unit area.

US 6,316,807 B1 discloses a high-voltage and low on-resistance semiconductor device having a trench structure that provides improved switching characteristics. In a preferred embodiment, a Trench Lateral Power MISFET of the above-mentioned second type is provided having a gate, channel and drift regions that are built on the side-walls of the trench. The process used to form the MISFET involves a self-aligned trench bottom contact hole to contact a source provided at the bottom of the trench to achieve minimum pitch and very low on-resistance.

JP 2000-077532 discloses a semiconductor device integrating a DMOS transistor and a bipolar transistor, US 6359318 discloses a semiconductor device integrating a DMOS transistor and CMOS transistors and a bipolar transistor.

### SUMMARY OF THE INVENTION

An object of the invention is to provide a manufacturing method of a semiconductor device capable of manufacturing, at a low cost, an IC chip that has TLPMs and planar devices on a same semiconductor substrate and is small in size and low in on-resistance.

This object is achieved by a method as claimed in claim 1. Preferred embodiments of the invention are defined in the dependent claims.

To attain various of the above aspects, according to the invention, the gate electrodes of a TLPM and the gate electrodes of planar devices are formed by patterning the same polysilicon layer, and the drain electrode(s) and the source electrode(s) of the TLPM and the drain electrodes and the source electrodes of the planar devices are formed by patterning the same metal layer. Therefore, the TLPM and the planar devices are connected electrically to each other by resulting metal wiring layers constituting the drain electrodes and by the source electrodes and resulting polysilicon layers constituting the gate electrodes.

### BRIEF DESCRIPTION OF THE DRAWINGS

These and other aspects and advantages of the invention will become apparent and more readily appreciated from the following description of the embodiments, taken in conjunction with the accompanying drawings of which:

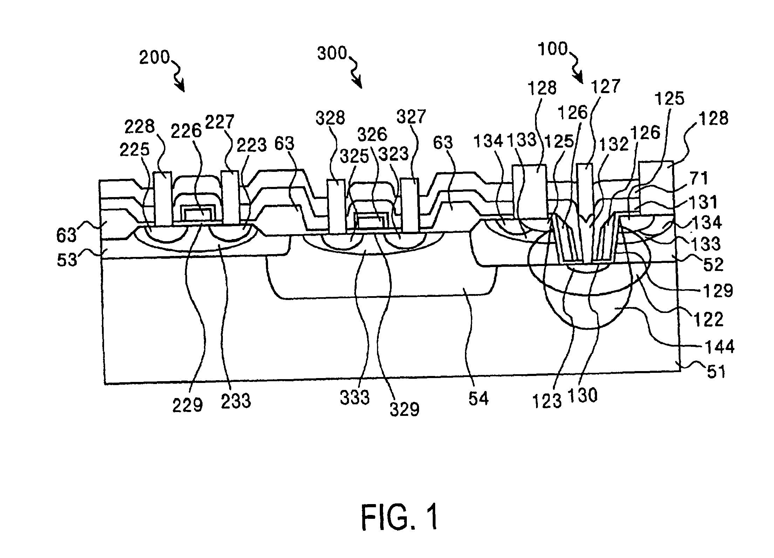

- FIG. 1: is a vertical sectional view showing the configuration of a semiconductor device according to a first embodiment of the invention;

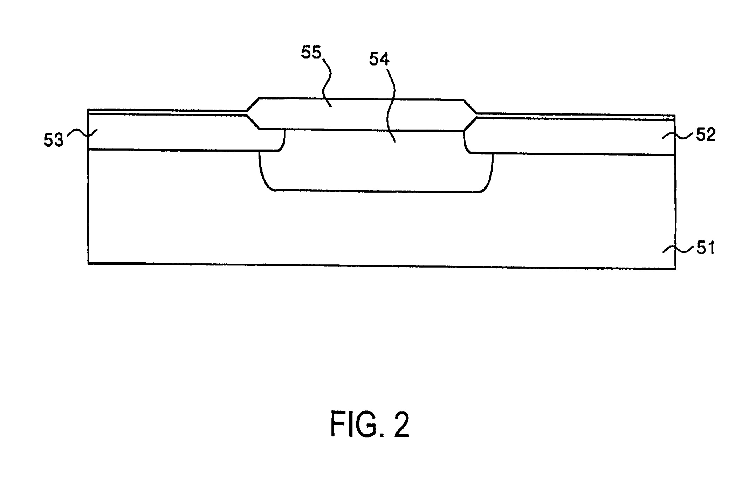

- FIG. 2-27: are vertical sectional views showing intermediate states of manufacture of the embodiment of the semiconductor device shown in FIG. 1;

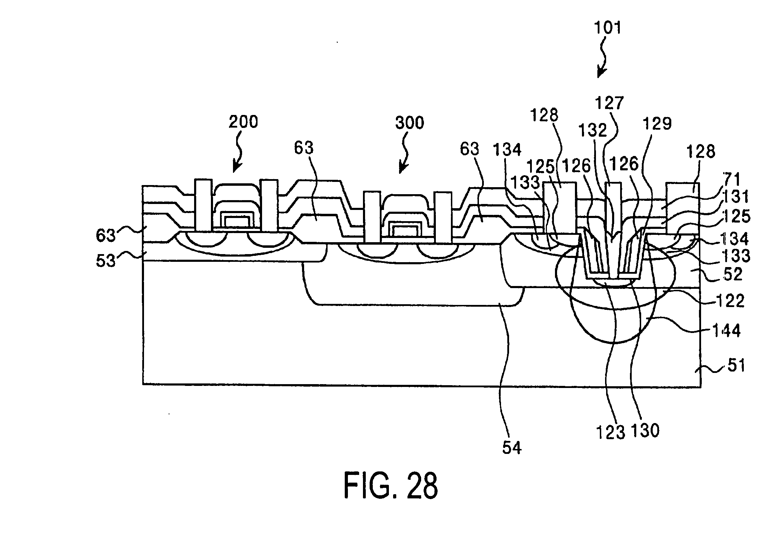

- FIG. 28-31: are vertical sectional views of respective modifications of the embodiment of the semiconductor device of FIG. 1;

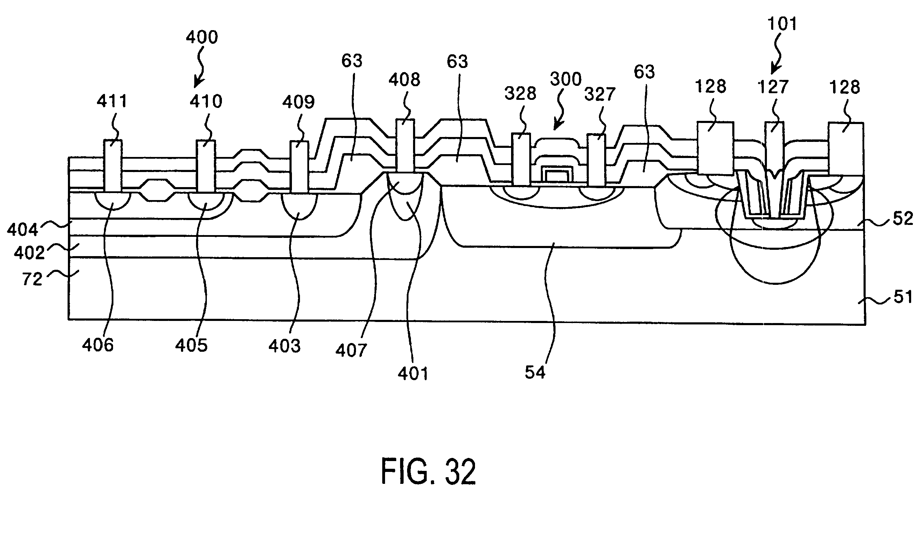

- FIG. 32: is a vertical sectional view of an example in which a bipolar transistor and the semiconductor device according to the first embodiment are integrated;

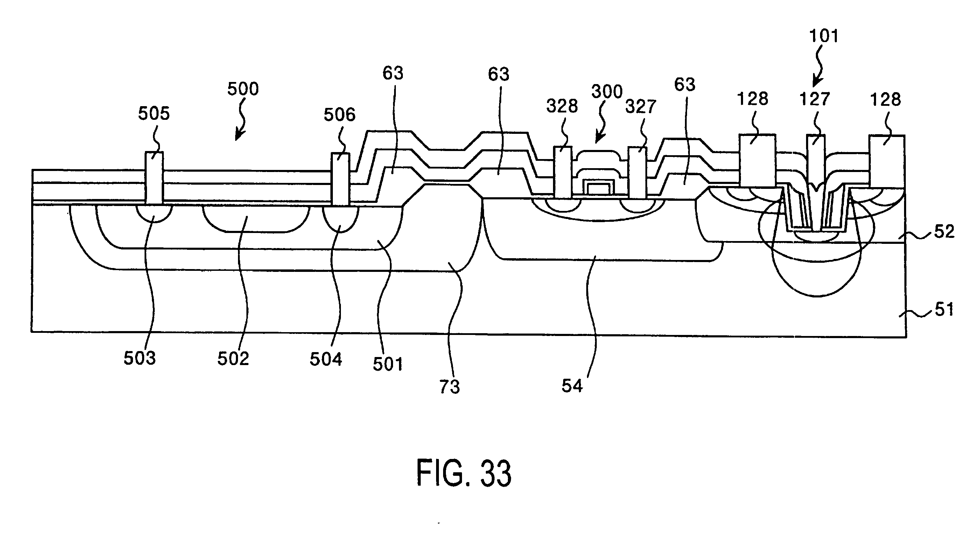

- FIG. 33: is a vertical sectional view of an example in which a resistance element and the semiconductor device according to the first embodiment are integrated;

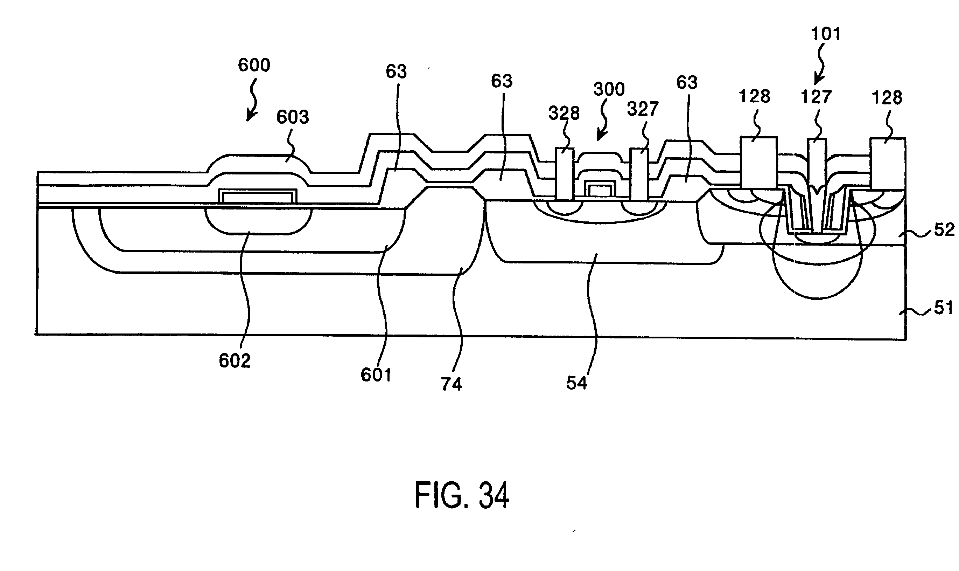

- FIG. 34: is a vertical sectional view of an example in which a capacitance element and the semiconductor device according to the first embodiment are integrated;

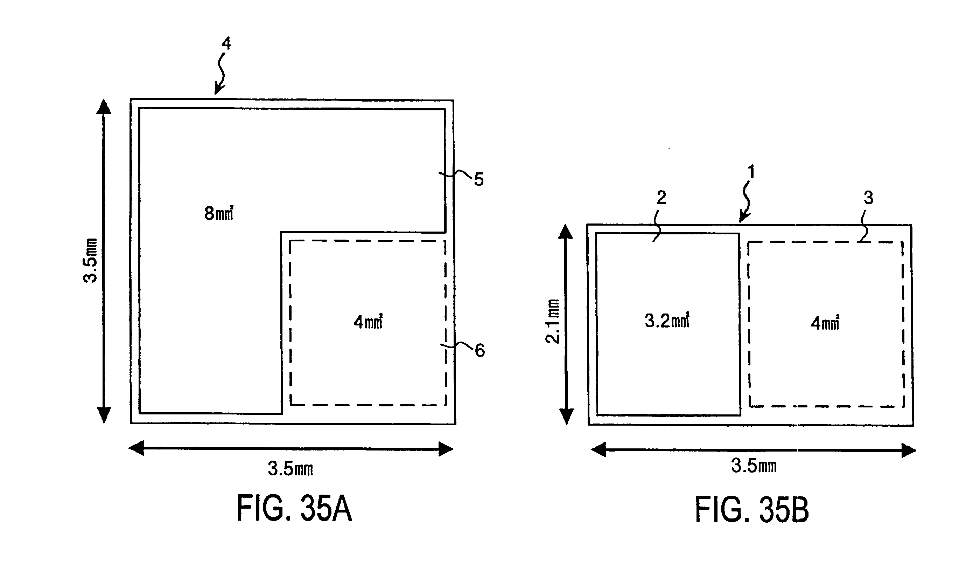

- FIG. 35A: and 35B schematically compare the sizes of a power module using the semiconductor device according to the first embodiment with a power module using conventional planar power MOSFETs;

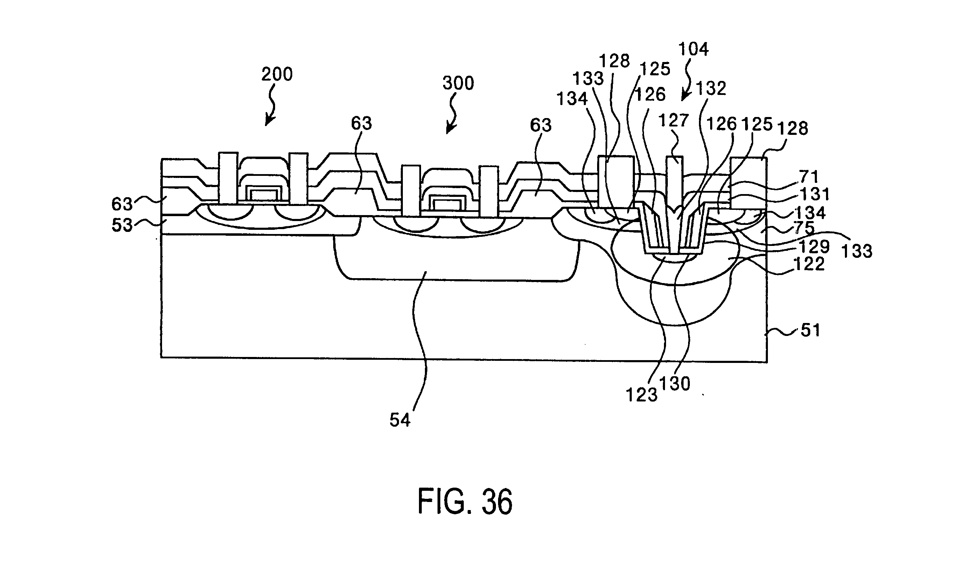

- FIG. 36: is a vertical sectional view showing the configuration of a semiconductor device according to a second embodiment of the invention;

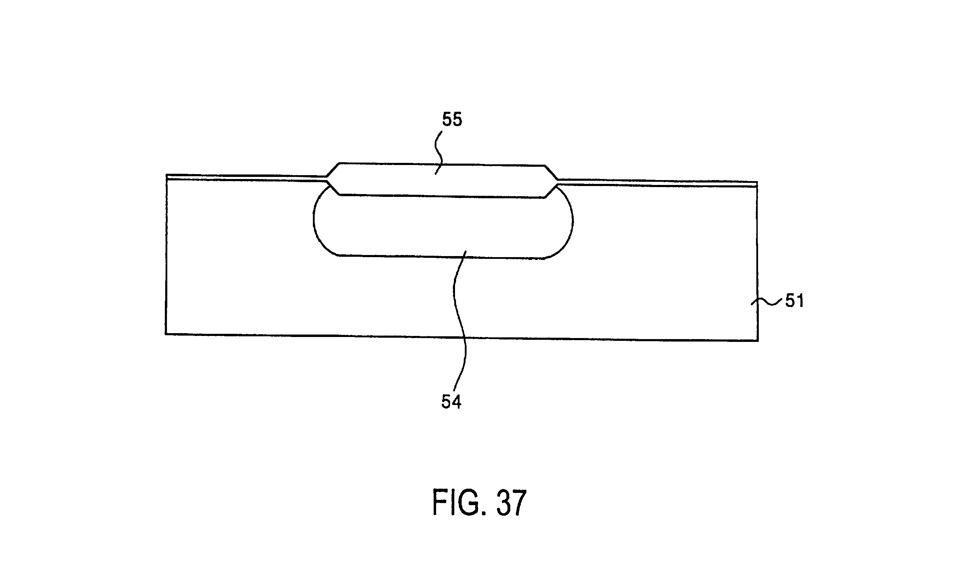

- FIG.37-47: are vertical sectional views showing intermediate states of manufacture of the embodiment of the semiconductor device shown in FIG. 36;

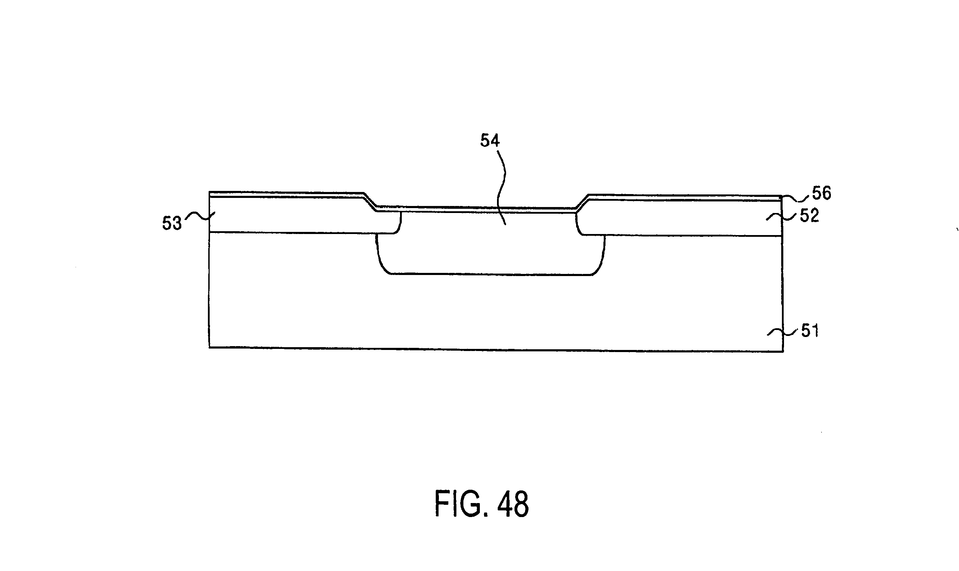

- FIG. 48-61: are vertical sectional views showing intermediate states of manufacture of a semiconductor device according to a third embodiment of the invention;

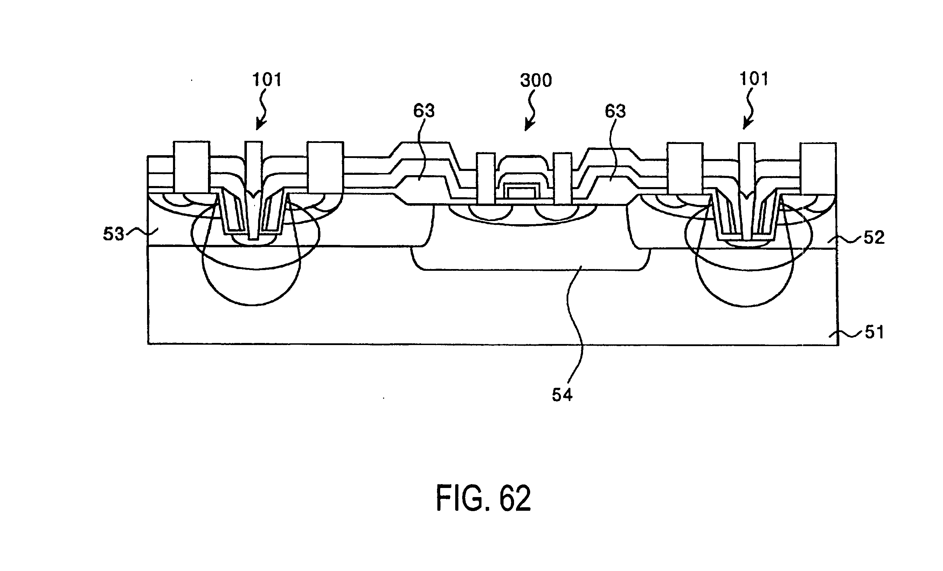

- FIG. 62: is a vertical sectional view showing the configuration of a semiconductor device according to a fourth embodiment of the invention;

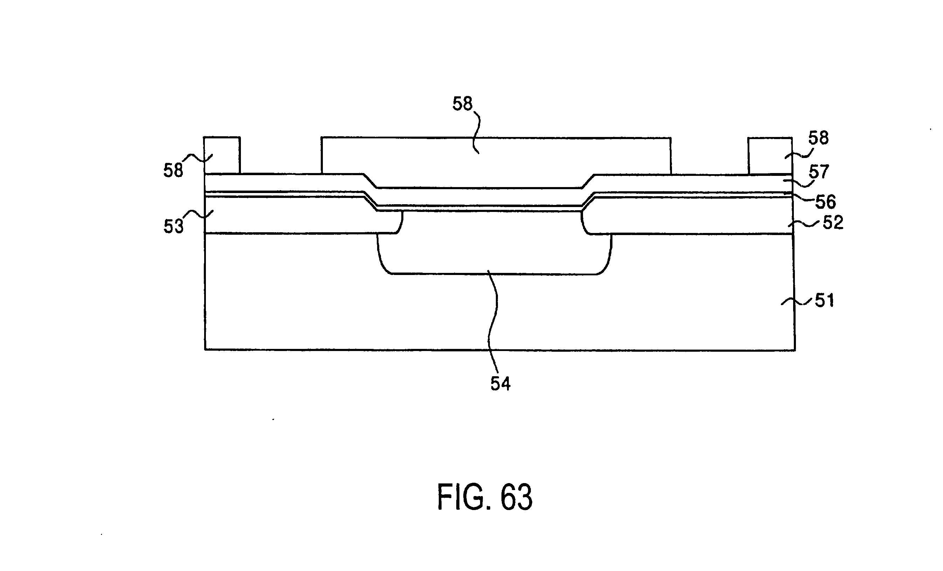

- FIG.63-70: are vertical sectional views showing intermediate states of manufacture of the embodiment of the semiconductor device shown in FIG. 62;

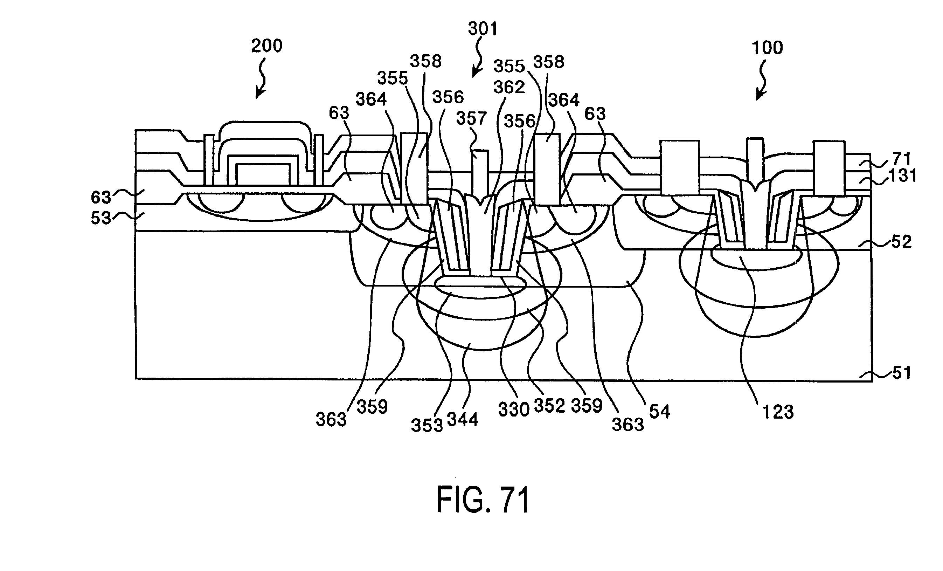

- FIG. 71: is a vertical sectional view showing the configuration of a semiconductor device according to a fifth embodiment of the invention;

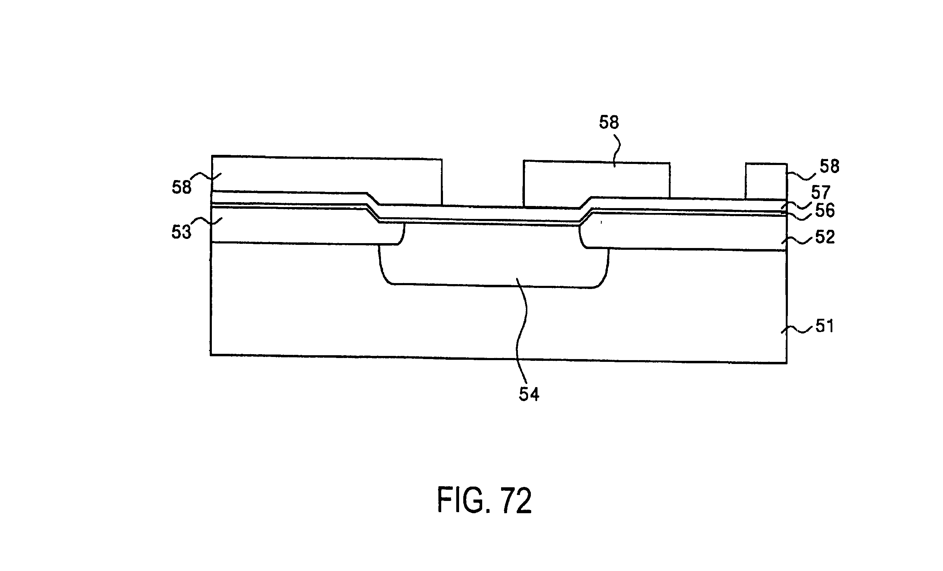

- FIG.72-90: are vertical sectional views showing intermediate states of manufacture of the embodiment of the semiconductor device shown in FIG. 71;

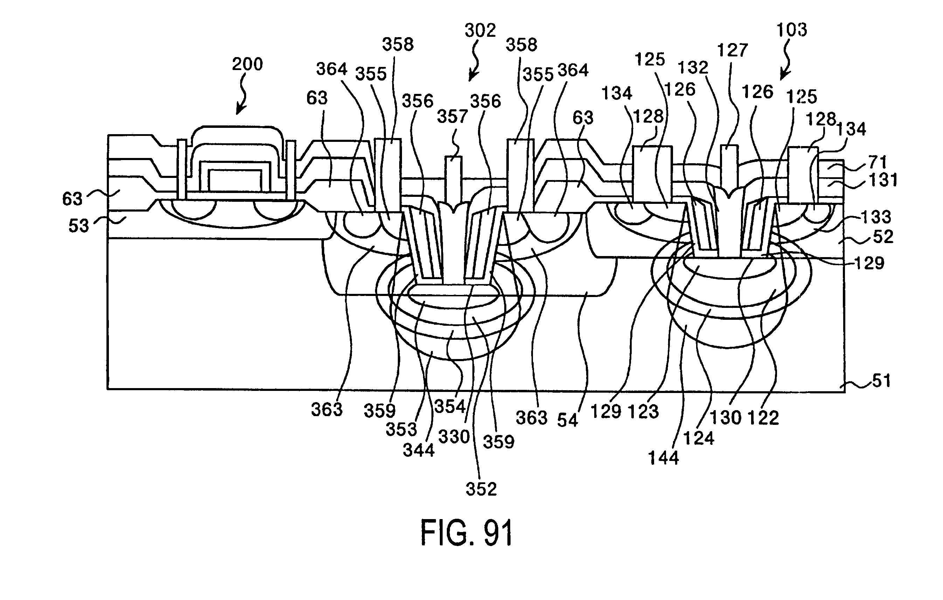

- FIG. 91: is a vertical sectional view of a modification of the semiconductor device according to the fifth embodiment of the invention;

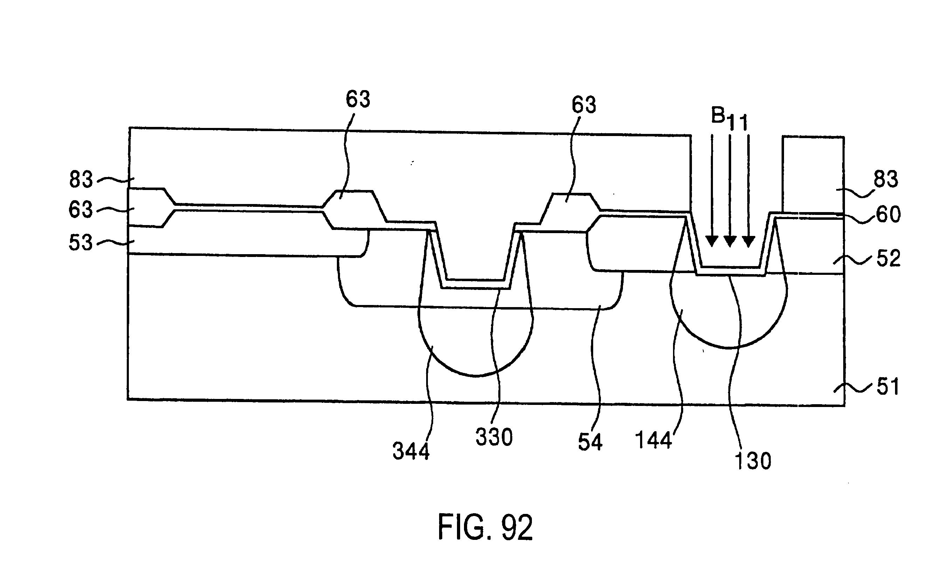

- FIG.92-97: are vertical sectional views showing intermediate states of manufacture of the embodiment of the semiconductor device shown in FIG. 91;
- FIG. 98: is a vertical sectional view showing the configuration of a conventional n-channel planar power MOSFET;
- FIG. 99: is a vertical sectional view showing the configuration of a conventional TLPM having a drain contact at the bottom of a trench;
- FIG. 100-107: are vertical sectional views showing intermediate states of manufacture of the TLPM shown in FIG. 99; and
- FIG. 108: is a vertical sectional view showing the configuration of a conventional TLPM having a source contact at the bottom of a trench.

### DETAILED DESCRIPTION OF THE EMBODIMENTS

Embodiments of the present invention will be hereinafter described in detail with reference to the accompanying drawings.

FIG. 1 is a vertical sectional view showing the configuration of a semiconductor device according to a first embodiment of the invention. As shown in FIG. 1, p-well regions 52 and 53 and an n-well region 54 are formed in a surface layer of a p-type semiconductor substrate 51. A TLPM 100 of such a type that drain contact is made at the bottom of a trench is formed in the one p-well region 52. An n-channel MOSFET (hereinafter abbreviated as "NMOS") 200 is formed in the other p-well region 53. A p-channel MOSFET (hereinafter abbreviated as "PMOS") 300 is formed in the n-well region 54.

in the foiiowing description, for the sake of convenience, the p-well regions 52 and 53 will be discriminated from each other by referring to the p-well region 52 where the TLPM 100 is formed as "first p-well region 52" and the p-well region 53 where the NMOS 200 is formed as "second p-well region 53." The TLPM 100, the NMOS 200, and the PMOS 300 are isolated from each other by selective oxidation (LOCOS) films 63. Also, for the sake of convenience, the terminology "on a semiconductor substrate" and "on the semiconductor substrate" are used throughout to describe the generally encountered state of "in/on a/the semiconductor substrate," that is, the terminology "on a semiconductor substrate" and "on the semiconductor substrate" are inclusive of being "in" and "on" the semiconductor substrate.

First, the TLPM 100 will be described. A trench 130 is formed in the first p-well region 52 approximately at the same depth as the depth of the first p-well region 52. The side surface and the bottom surface of the trench 130 are surrounded by a p-type field region 144. An n-type extended drain region 122 that is shallower than the field region 144 is provided adjacent to the side surface and the bottom surface of the trench 130. An n-type drain region 123 is provided inside the extended drain region 122. A gate oxide film 129, gate electrodes 126, an oxide film (part of shadow oxide films 68 (described later)), an interlayer insulating film 131, and a drain polysilicon layer 132 are formed inside the trench 130 sequentially from the outside.

P-type channel regions 133 are provided on both sides of the trench 130 in a substrate surface layer, and n-type source regions 125 are provided in surface layers of the p-type channel regions 133, respectively. P-type plug regions 134 are provided outside the respective source regions 125. Each source electrode 128 penetrates through the interlayer insulating film 131 and a passivation film 71 and is in contact with both of the associated source region 125 and plug region 134. The structure that the source region 125, the plug region 134, and the source electrode 128 are in electrical contact with each other provides good grounding of the substrate 51 and hence prevents reduction in breakdown voltage even at the occurrence of a large current. A drain electrode 127 penetrates through the passivation film 71 and is in electrical contact with the drain region 123 via the drain polysilicon layer 132.

Next, the NMOS 200 will be described. A p-type channel region 233 is formed in a surface layer of the second p-well region 53, and an n-type drain region 223 and an n-type source region 225 are formed in the p-type channel region 233. A gate oxide film 229 is formed on the substrate surface between the drain region 223 and the source region 225, and a gate electrode 226 is formed on the gate oxide film 229. A drain electrode 227 and a source electrode 228 penetrate through the interlayer insulating film 131 and the passivation film 71 and are in contact with the drain region 223 and the source region 225, respectively.

Next, the PMOS 300 will be described. An n-type channel region 333 is formed in a surface layer of the n-well region 54, and a p-type drain region 323 and a p-type source region 325 are formed in the p-type channel region 333. A gate oxide film 329 is formed on the substrate surface between the drain region 323 and the source region 325, and a gate electrode 326 is formed on the gate oxide film 329. A drain electrode 327 and a source electrode 328 penetrate through the interlayer insulating film 131 and the passivation film 71 and are in contact with the drain region 323 and the source region 325, respectively.

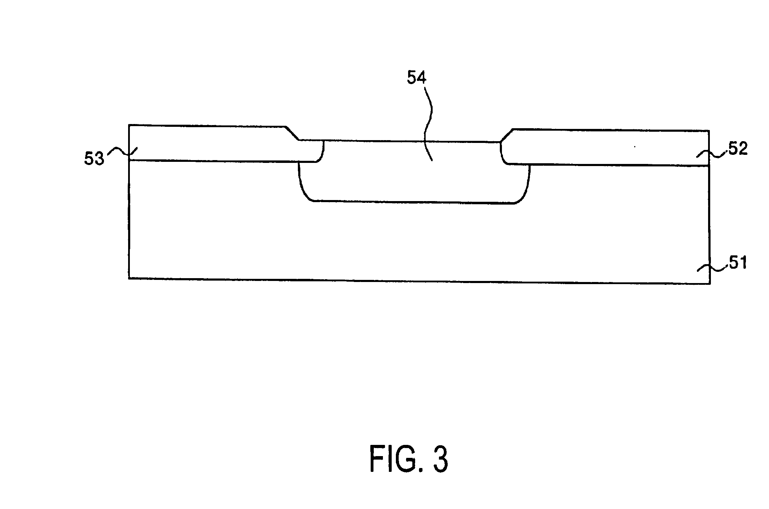

A manufacturing process of the semiconductor device shown in FIG. 1 is described below. FIGS. 2-27 are vertical sectional views showing intermediate states of manufacture of the embodiment of the semiconductor device shown in FIG. 1. First, an n-well region 54 is formed selectively in a surface layer of a semiconductor substrate 51, and a first p-well region 52 and a second p-well region 53 are formed by using, as a mask, a selective oxidation film 55 that is formed on the substrate surface (see FIG. 2). Then, the selective oxidation film 55 is removed completely (see FIG. 3).

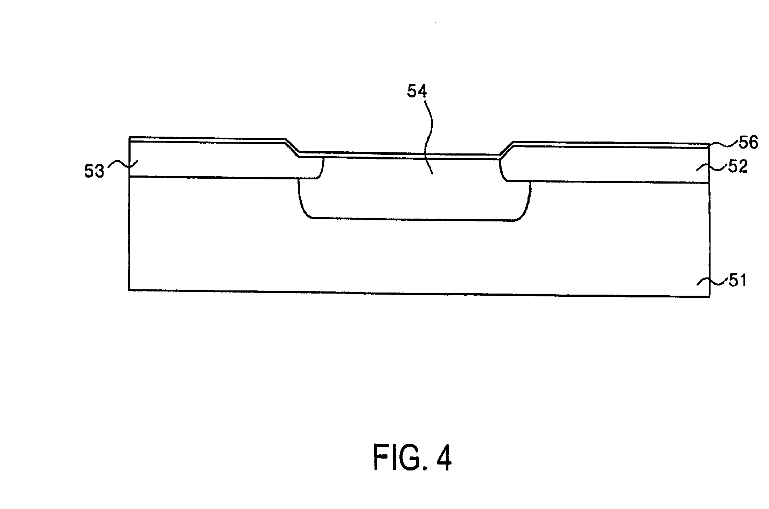

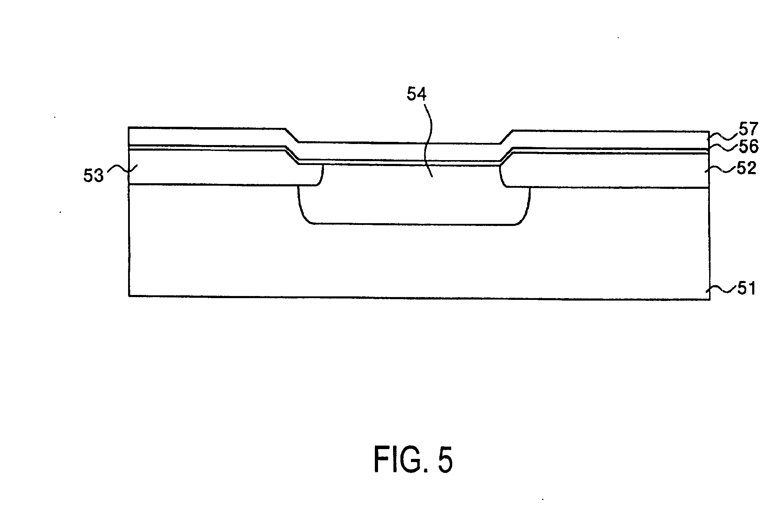

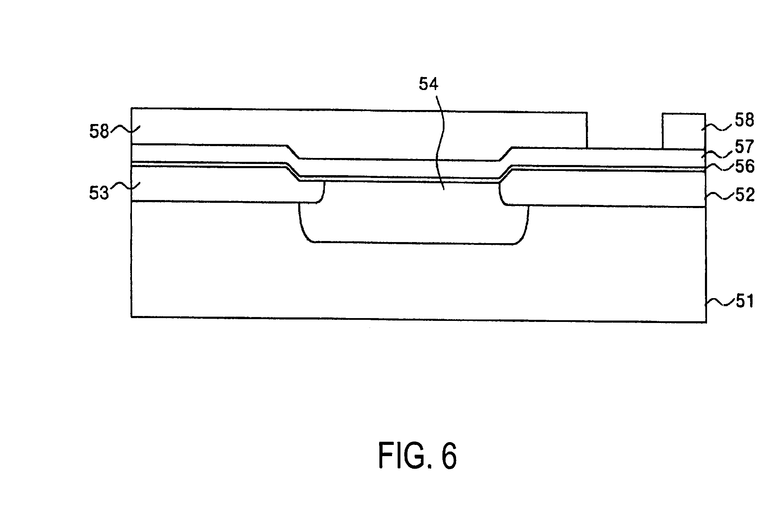

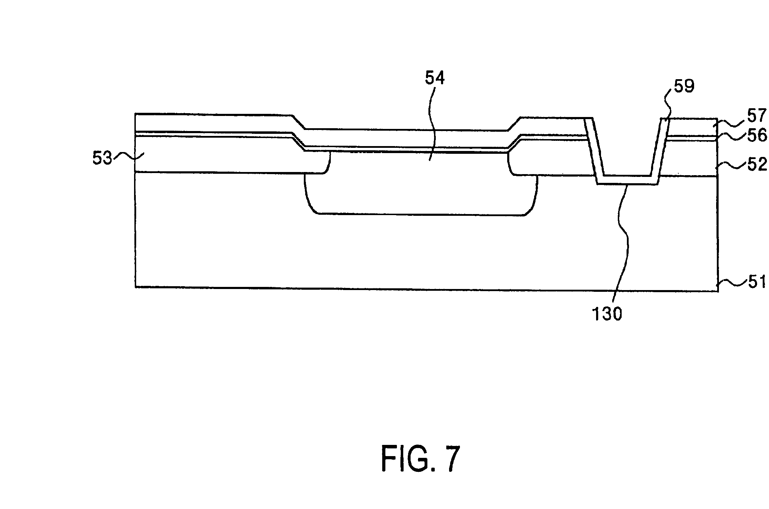

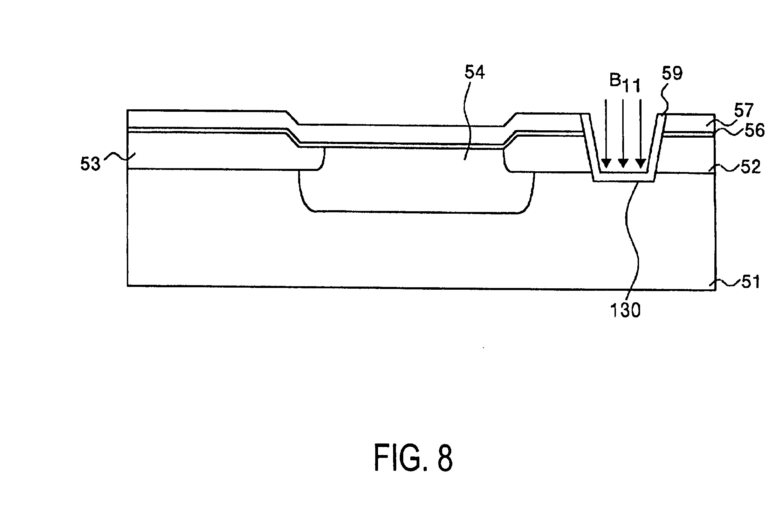

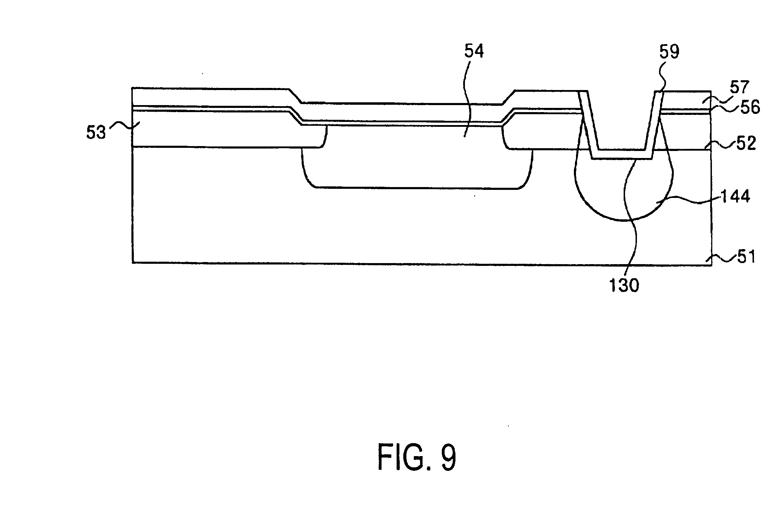

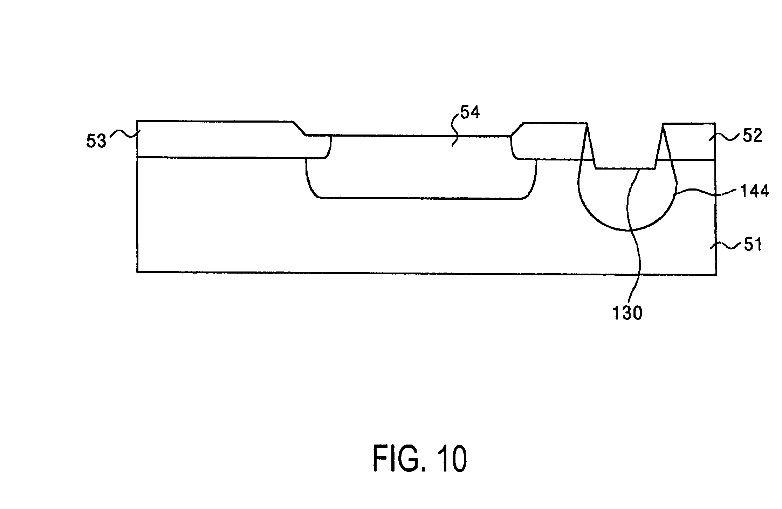

Subsequently, a buffer oxide film 56 is formed on the substrate surface (see FIG. 4), and a mask oxide film 57 is formed thereon (see FIG. 5). Then, a mask 58 having an opening in a trench forming area is formed on the mask oxide film 57 (see FIG. 6). The mask oxide film 57 is patterned by using the mask 58. After the mask 58 is removed, a trench 130 is formed in the first p-well region 52 by performing trench etching (RIE). A buffer oxide film 59 is formed on the surface of the trench 130 (see FIG. 7), and a field region 144 is formed (see FIG. 9) by doping the substrate 51 with B₁₁ under the bottom surface of the trench 130 (see FIG. 8). Then, the mask oxide film 57 and the buffer oxide films 56 and 59 are removed completely (see FIG. 10).

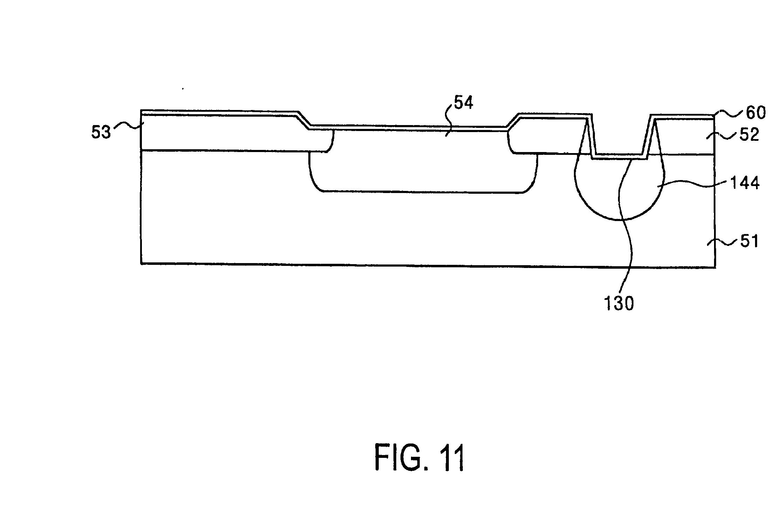

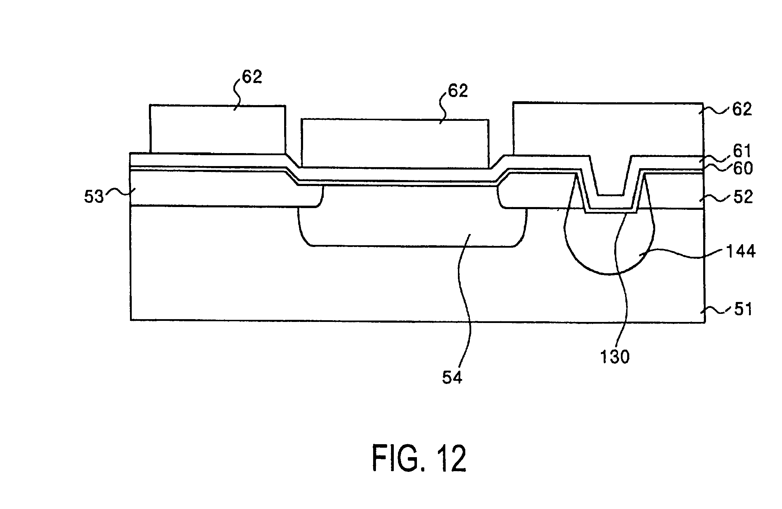

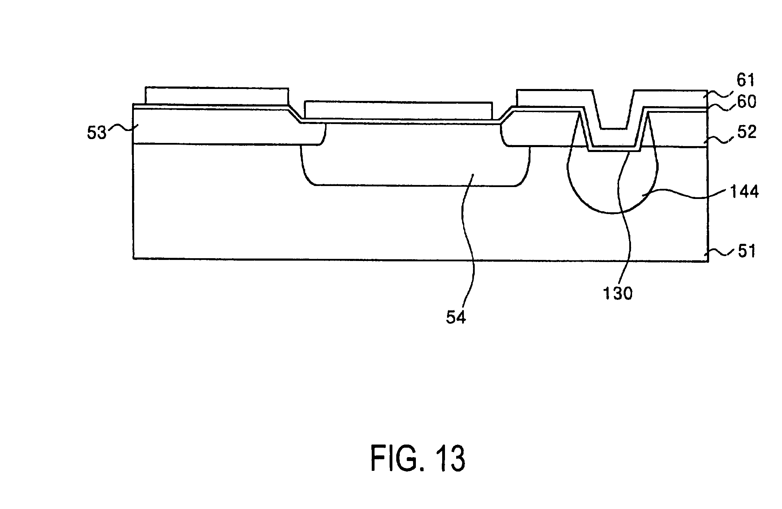

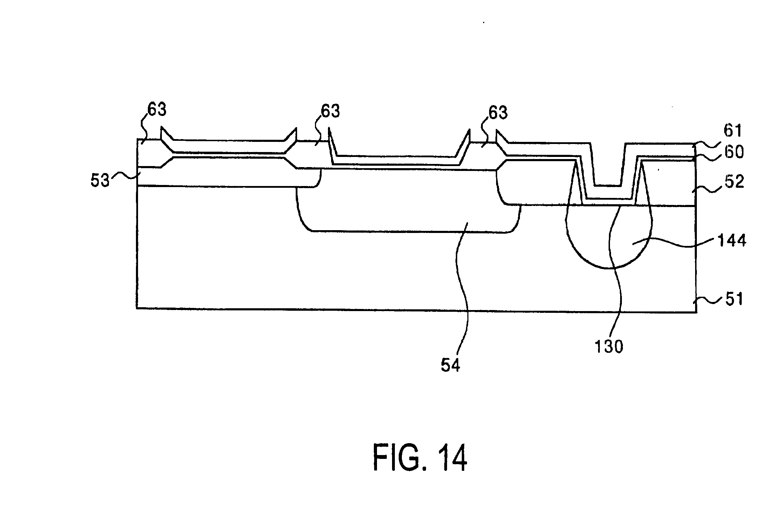

Subsequently, a buffer oxide film 60 is formed on the substrate surface and the surface of the trench 130 (see FIG. 11), and a silicon nitride film 61 is formed thereon. A mask 62 having openings in device isolation areas is formed on the silicon nitride film 61 (see FIG. 12). The silicon nitride film 61 is patterned by using the mask 62, and the mask 62 is removed thereafter (see FIG. 13). Thermal oxidation is performed by using, as a mask, the silicon nitride film 61 remaining on the substrate surface, whereby selective oxidation films 63 for device isolation are formed (see FIG. 14).

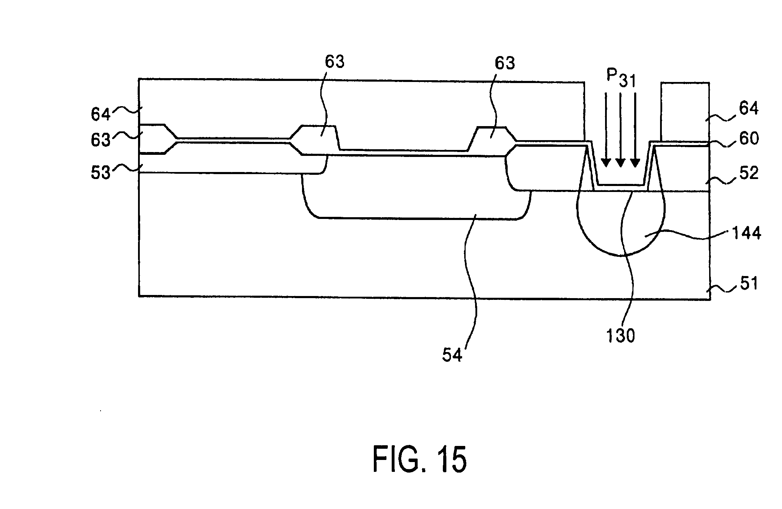

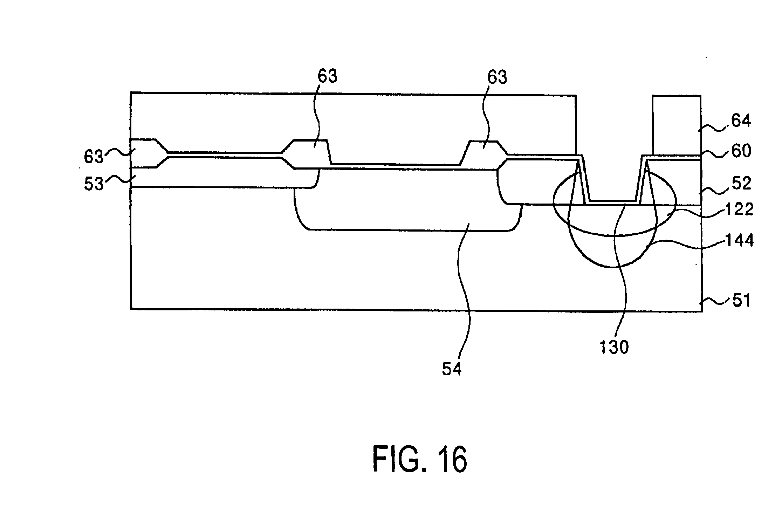

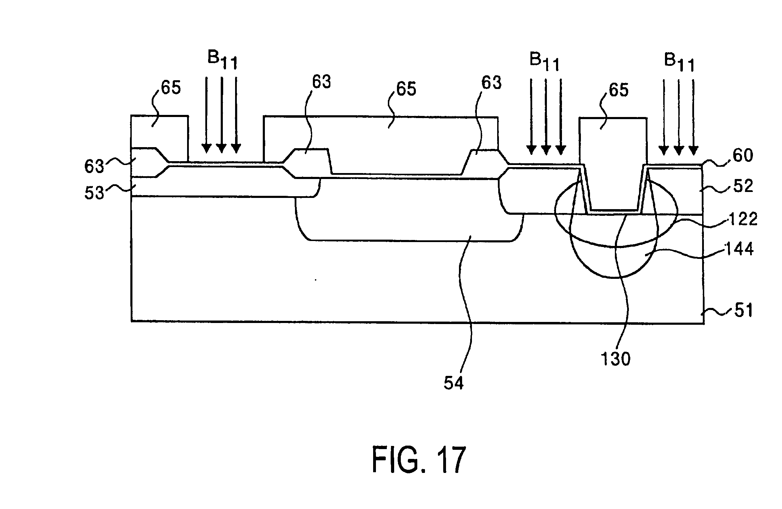

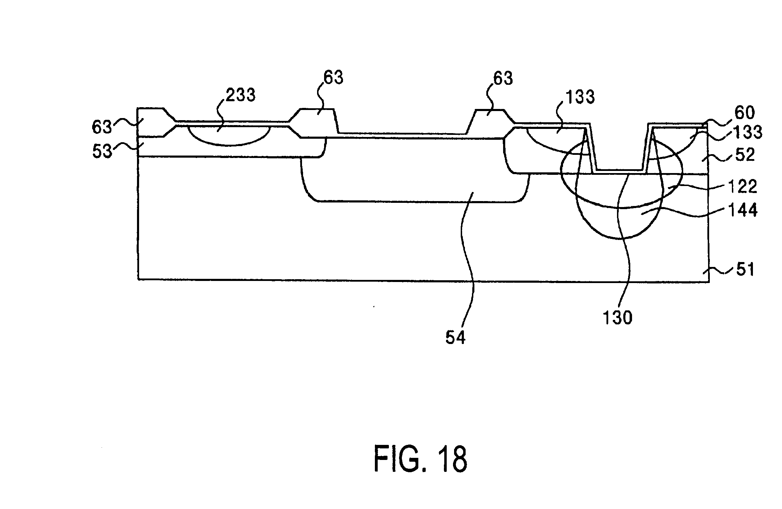

Subsequently, a mask 64 having an opening over the trench 130 is formed on the substrate surface and the substrate 51 is doped with P₃₁ (see FIG. 15), whereby an extended drain region 122 is formed (see FIG. 16). Then, a mask 65 having openings in areas corresponding to future channel regions of the intended TLPM and NMOS is formed on the substrate surface. The substrate 51 is doped with B₁₁ (FIG. 17), whereby channel regions 133 of the intended TLPM are formed in the first p-well region 52 and, simultaneously, a channel region 233 of the intended NMOS is formed in the second p-well region 53. The mask 65 is removed thereafter (see FIG. 18). The operations of FIGS. 15 and 16 and the operations of FIGS. 17 and 18 may be reversed.

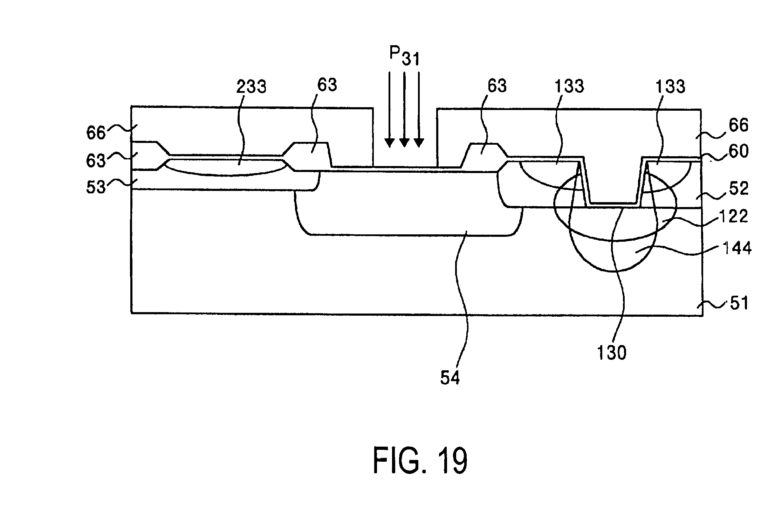

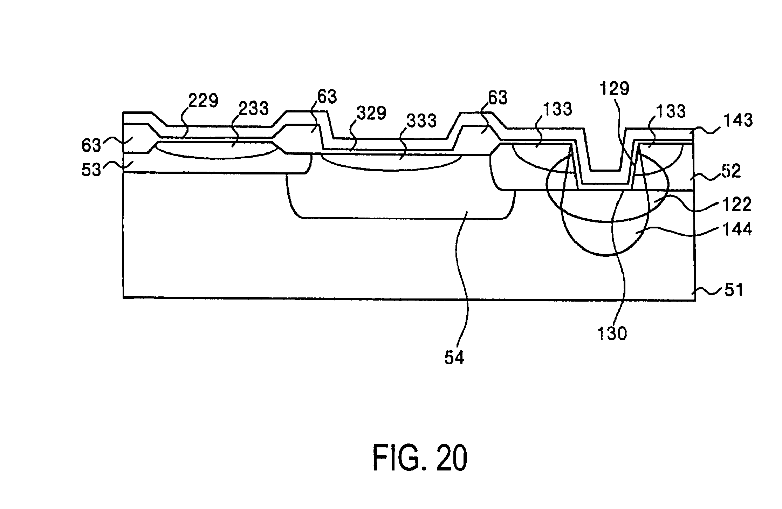

Subsequently, after a mask 66 having an opening in an area corresponding to a future channel region of the intended PMOS is formed on the substrate surface, the substrate 51 is doped with P₃₁ (see FIG. 19), whereby a channel region 333 of the intended PMOS is formed in the n-well region 54. The buffer oxide film 60 is removed thereafter. A common thin oxide film to become gate oxide films 129, 229, and 329 of the intended TLPM, NMOS, and PMOS, respectively, is formed on the substrate surface and inside the trench 130, and a polysilicon layer 143 is laid thereon (see FIG. 20).

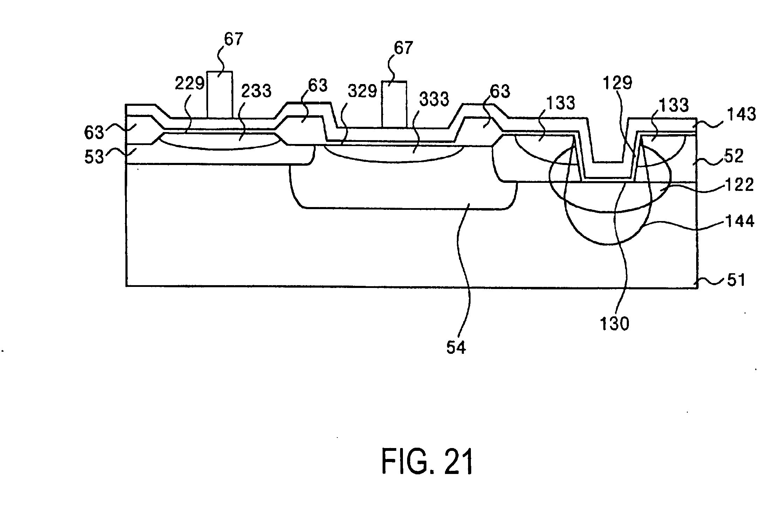

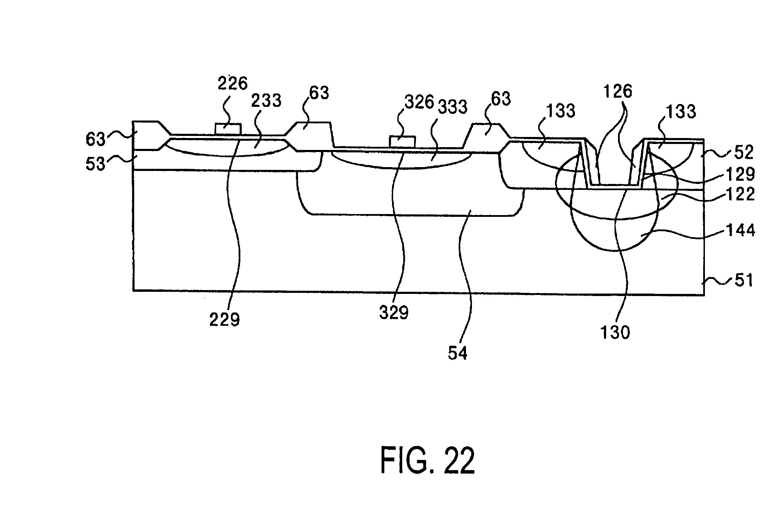

A mask 67 is formed on the polysilicon layer 143 only in areas corresponding to future gate electrodes of the intended NMOS and PMOS (see FIG. 21). The polysilicon layer 143 is etched by using the mask 67, whereby gate electrodes 126 of the intended TLPM are formed inside the trench 130 by self-alignment and, simultaneously, gate electrodes 226 and 326 of the intended NMOS and PMOS, respectively, are formed. The mask 67 is removed thereafter (see FIG. 22).

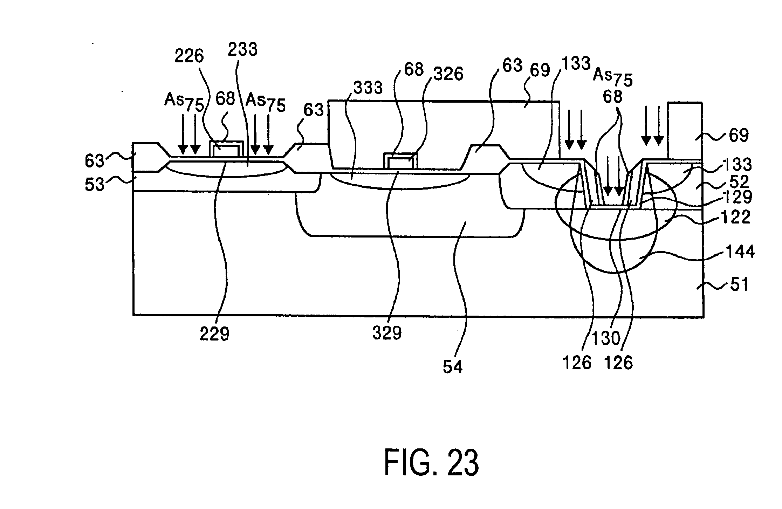

Then, shadow oxide films 68 are formed to cover the gate electrodes 126 of the intended TLPM and the gate electrodes 226 and 326 of the intended NMOS and PMOS. Then, a mask 69 having openings in areas corresponding to a future drain region and source regions of the intended TLPM and an area in which the intended NMOS is formed on the substrate surface. The substrate 51 is doped with As₇₅ (see FIG. 23), whereby a drain region 123 of the intended TLPM is formed under the bottom surface of the trench 130, source regions 125 of the intended TLPM are formed on both sides of the trench 130, and a source region 225 and a drain region 223 of the intended NMOS are formed in the channel region 233 simultaneously. The mask 69 is removed thereafter.

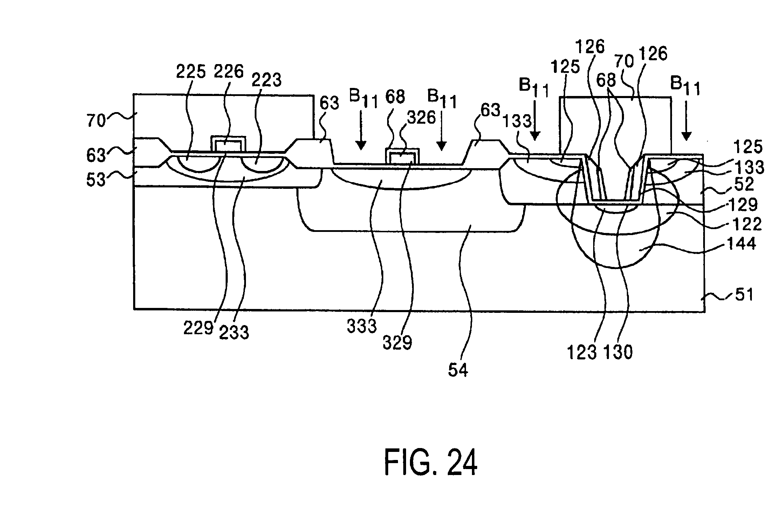

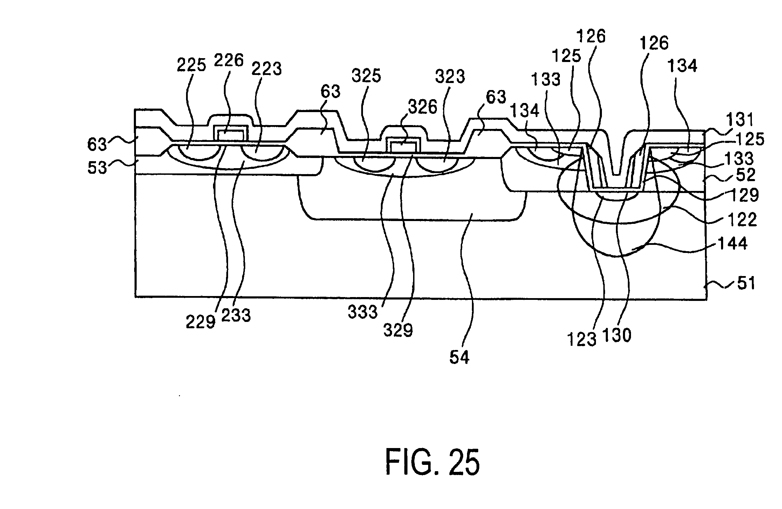

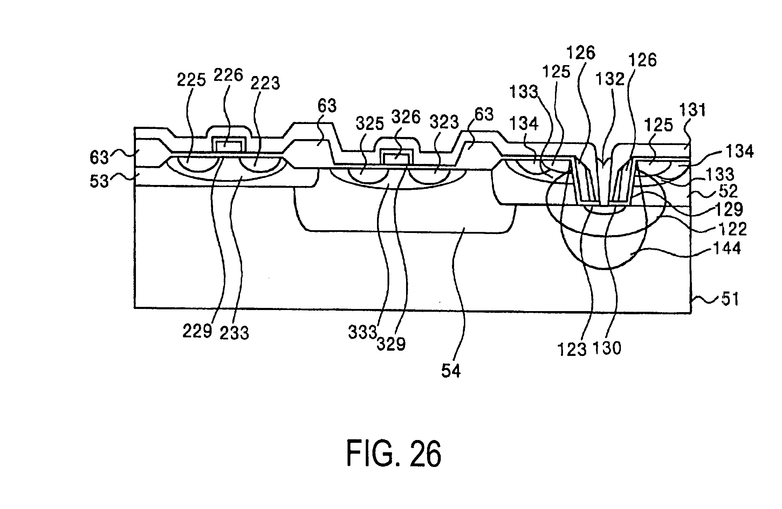

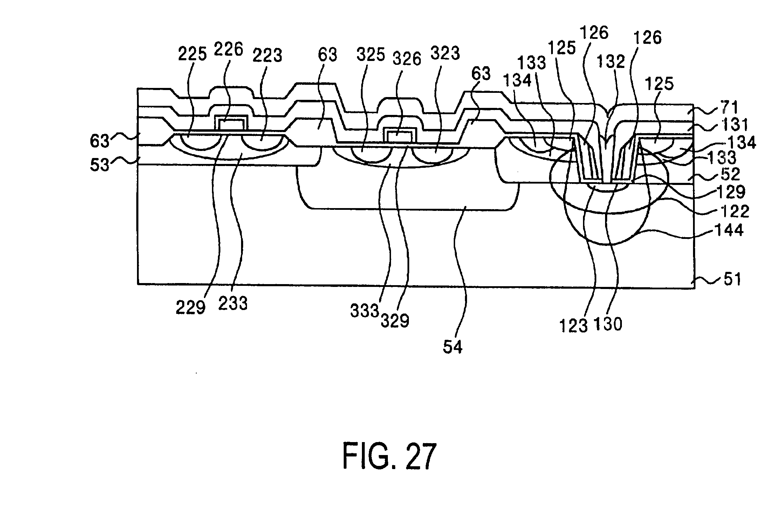

Subsequently, a mask 70 having openings in areas corresponding to future plug regions of the intended TLPM and an area in which the intended PMOS is formed on the substrate surface. The substrate 51 is doped with B₁₁ (see FIG. 24), whereby plug regions 134 are formed outside the respective source regions 125 of the intended TLPM and, simultaneously, a source region 325 and a drain region 323 of the intended PMOS are formed in the channel region 333. After the mask 70 is removed, an interlayer insulating film 131 is laid over the substrate surface (see FIG. 25). A portion of the interlayer insulating film 131 inside the trench 130 is etched away by self-alignment to form a contact hole, which is then filled with a drain polysilicon layer 132 (see FIG. 26). A passivation film 71 is formed over the substrate surface (see FIG. 27). The operations of FIG. 23 and FIG. 24 may be reversed.

Subsequently, the passivation film 71 is patterned to form contact holes. A metal film is formed on the passivation film 71 and then patterned, whereby a drain electrode 127 of the intended TLPM that is in contact with the drain polysilicon layer 132, source electrodes 128 of the intended TLPM each of which are in contact with both of the associated source region 125 and plug region 134, a drain electrode 227 and a source electrode 228 of the intended NMOS that are in contact with the drain region 223 and the source region 225, respectively, and a drain electrode 327 and a source electrode 328 of the intended PMOS that are in contact with the drain region 323 and the source region 325, respectively, are formed at the same time. In this manner, a semiconductor device is completed in which the TLPM 100, the NMOS 200, and the PMOS 300 are integrated on the same semiconductor substrate 51 as shown in FIG. 1.

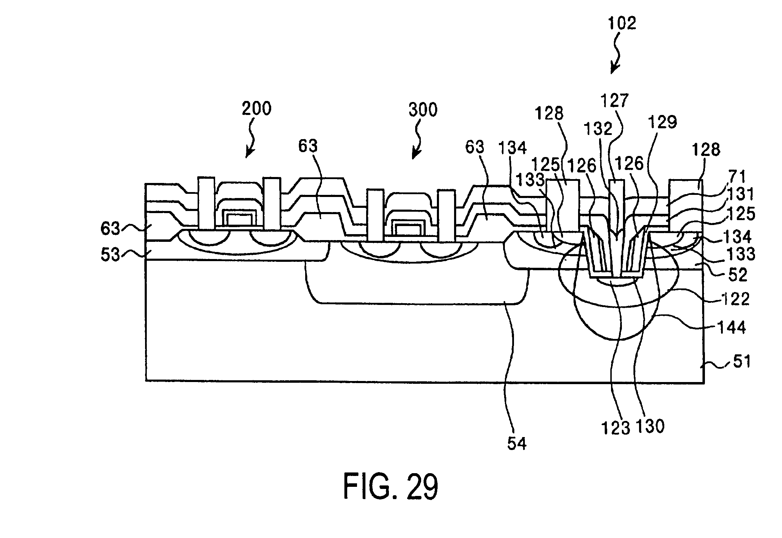

In the TLPM 100 shown in FIG. 1, the trench 130 has approximately the same depth as the first p-well region 52. FIG. 28 shows another TLPM 101 in which the first p-well region 52 is deeper than in the TLPM 100 of FIG. 1, and the drain region 123 is formed inside the first p-well region 52. Conversely, as shown in FIG. 29, another TLPM 102 may be constructed in which the first p-well region 52 is shallower than in the TLPM 100 of FIG. 1, and the trench 130 projects from the first p-well region 52.

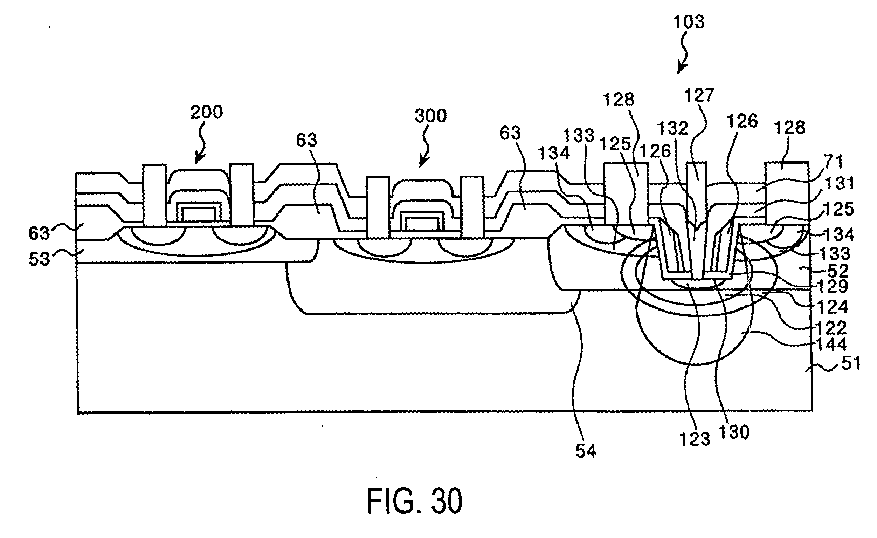

FIG. 30 shows another TLPM 103 in which a p-type body region 124 is formed to surround the extended drain region 122. This structure can be obtained by forming the extended drain region 122 after forming a body region 124, instead of forming the extended drain region 122 by doping the substrate 51 with P₃₁ under the bottom surface of the trench 130 in the operations of FIG. 15. The structure of FIG. 30 provides an advantage that the TLPM has a high breakdown voltage and a low on-resistance even if the dose of the n-type impurity is relatively high.

Similarly, in FIG. 28, even where the impurity concentration of the extended drain region 122 is increased to lower the on-resistance, the breakdown voltage can be kept high by making the first p-well region 52 deeper than the extended drain region 122.

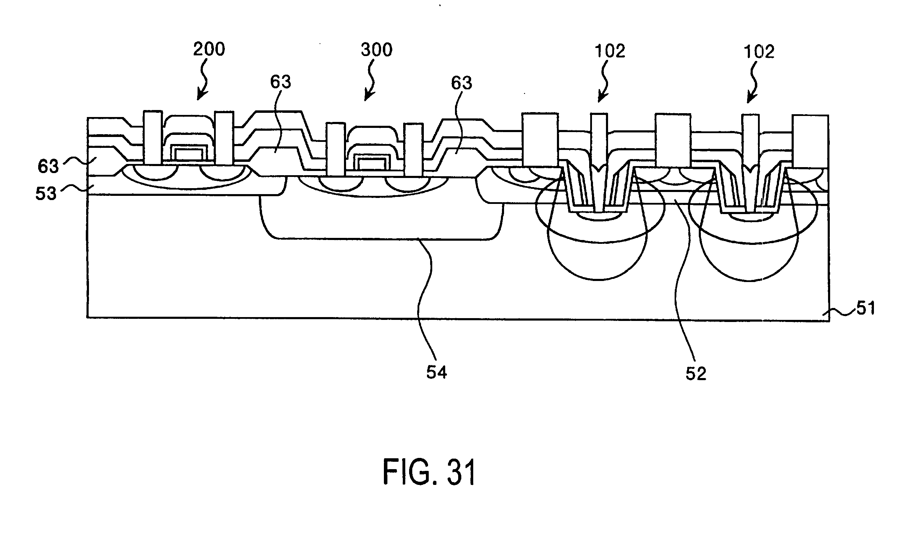

FIG. 31 shows still another configuration in which a plurality of (in FIG. 31, two) TLPMs 102 of the same conductivity type channel are provided in the same well region 52. This structure can be obtained by forming a plurality of trenches in the same well region 52 in the operations of FIGS. 6 and 7 and executing the processes that are executed on the trench 130 in the operations of FIG. 8 and the following operations on the plurality of trenches at the same time. This structure makes it possible to provide large-current devices in the TLPMs 102. TLPMs 100 or 101 may be provided instead of the TLPMs 102.

FIG. 32 shows another configuration in which a bipolar transistors 400 and the TLPM 101 are integrated on the same semiconductor substrate 51. In the example of FIG. 32, the bipolar transistor 400 is formed in a third p-well region 72. A first p-type offset region 401 and an n-well region 402 are formed in the third p-well region 72. An n-type collector region 403 and a second p-type offset region 404 are formed in the n-type well region 402. A p-type base region 405 and an n-type emitter region 406 are formed in the second p-type offset region 404. A substrate pickup electrode 408 is electrically connected to the first p-type offset region 401 via a high-concentration p-type contact region 407.

A collector electrode 409, a base electrode 410, and an emitter electrode 411 are in contact with the collector region 403, the base region 405, and the emitter region 406, respectively. The substrate pickup electrode 408, the collector electrode 409, the base electrode 410, and the emitter electrode 411 are formed at the same time as the drain electrodes 127, 327, and 227 and the source electrodes 128, 328, and 228 of the TLPM 101, the PMOS 300, and the NMOS 200 (not shown in FIG. 32). The TLPM 100, 102, or 103 may be provided instead of the TLPM 101.

FIG. 33 shows yet another configuration in which a resistance element 500 and the TLPM 101 are integrated on the same semiconductor substrate 51. In the example of FIG. 33, a resistance element 500 is formed in a fourth p-well region 73. An n-well region 501 is formed in fourth p-well region 73. High-concentration n-type contact regions 503 and 504, which are separated from each other by a p-type offset region 502, are formed in the n-well region 501. Electrodes 505 and 506 are in contact with the respective n-type contact regions 503 and 504. The electrodes 505 and 506 are formed at the same time as the drain electrodes 127, 327, and 227 and the source electrodes 128, 328, and 228 of the TLPM 101, the PMOS 300, and the NMOS 200 (not shown in FIG. 33). The TLPM 100, 102, or 103 may be provided instead of the TLPM 101.

FIG. 34 shows a further configuration in which a capacitance element 600 and the TLPM 101 are integrated on the same semiconductor substrate 51. In the example of FIG. 34, the capacitance element 600 is formed in a fifth p-well region 74. An n-well region 601 is formed in the fifth p-well region 74. A high-concentration n-type contact region 602 is formed in the n-well region 601. An electrode 603 is in contact with the n-type contact region 602. The electrode 603 is formed at the same time as the gate electrodes 126, 326, and 226 of the TLPM 101, the PMOS 300, and the NMOS 200 (not shown in FIG. 33). The TLPM 100, 102, or 103 may be provided instead of the TLPM 101.

FIGS. 35A and 35B schematically compare the size of a power module using the semiconductor device according to the first embodiment with the size of a power module using conventional planar power MOSFETs. As shown in FIG. 35B, in the power module 1 using the semiconductor device according to the first embodiment, an IC chip measures 2.1 mm by 3.5 mm. A power section 2 that is composed of the above-described TLPMs 101, 102, or 103 etc. has an area of 3.2 mm². A control section 3 that is composed of the NMOSs 200, the PMOSs 300, the bipolar transistors 400, the resistance elements 500, the capacitance elements 600, etc. has an area of 4 mm².

In contrast, as shown in FIG. 35A, in the power module 4 using conventional planar power MOSFETs, an IC chip measures 3.5 mm by 3.5 mm. A power section 5 that is composed of the planar power MOSFETs etc. has an area of 8 mm², and a control section 6 has an area of 4 mm².

In the above-described first embodiment, the gate electrodes 126 of the TLPM 100, 101, 102, or 103, the gate electrode 226 of the NMOS 200, and the gate electrode 326 of the PMOS 300 are formed by patterning the same polysilicon layer 143. The drain electrode 127 and the source electrodes 128 of the TLPM 100, 101, 102, or 103, the drain electrode 227 and the source electrode 228 of the NMOS 200, and the drain electrode 327 and the source electrode 328 of the PMOS 300 are formed by patterning the same metal wiring layer. Therefore, the TLPM 100, the NMOS 200, and the PMOS 300 can be connected to each other electrically via the metal wiring layer and the polysilicon layer 143. Since, unlike conventional cases, it is not necessary to perform wire bonding on a printed circuit board, a one-chip power IC can be obtained that is small in size and low in on-resistance and cost.

In the first embodiment, the channel regions 133 of the TLPM 100 and the channel region 233 of the NMOS 200 are formed at the same time, the gate electrodes 126 of the TLPM 100, the gate electrode 226 of the NMOS 200, and the gate electrode 326 of the PMOS 300 are formed at the same time, the drain region 123 and the source regions 125 of the TLPM 100 and the drain region 223 and the source region 225 of the NMOS 200 are formed at the same time, the plug regions 134 of the TLPM 100 and the drain region 323 and the source region 325 of the PMOS 300 are formed at the same time, and the drain electrode 127 and the source electrodes 128 of the TLPM 100, the drain electrode 227 and the source electrode 228 of the NMOS 200, and the drain electrode 327 and the source electrode 328 of the PMOS 300 are formed at the same time. This can prevent cost increase due to an increase in the number of manufacturing operations.

FIG. 36 is a vertical sectional view showing the configuration of a semiconductor device according to a second embodiment of the invention. The semiconductor device according to the second embodiment is different from the semiconductor device of FIG. 1 according to the first embodiment in that a TLPM 104 of the former does not have a field region and is formed in a p-well region 75 having a generally constant depth including under the trench 130. The other part of the configuration of the TLPM 104 is the same as of the TLPM 100 of the semiconductor device shown in FIG. 1 and hence will not be described. Regions, electrodes, etc. of the semiconductor device according to the second embodiment having the same names in the semiconductor device according to the first embodiment are given the same reference numerals as the latter and will not be described.

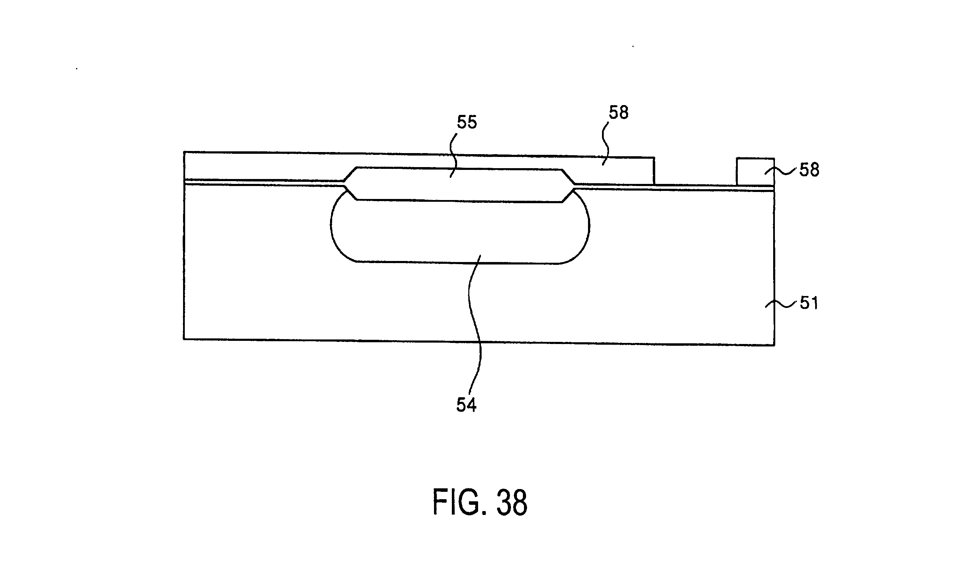

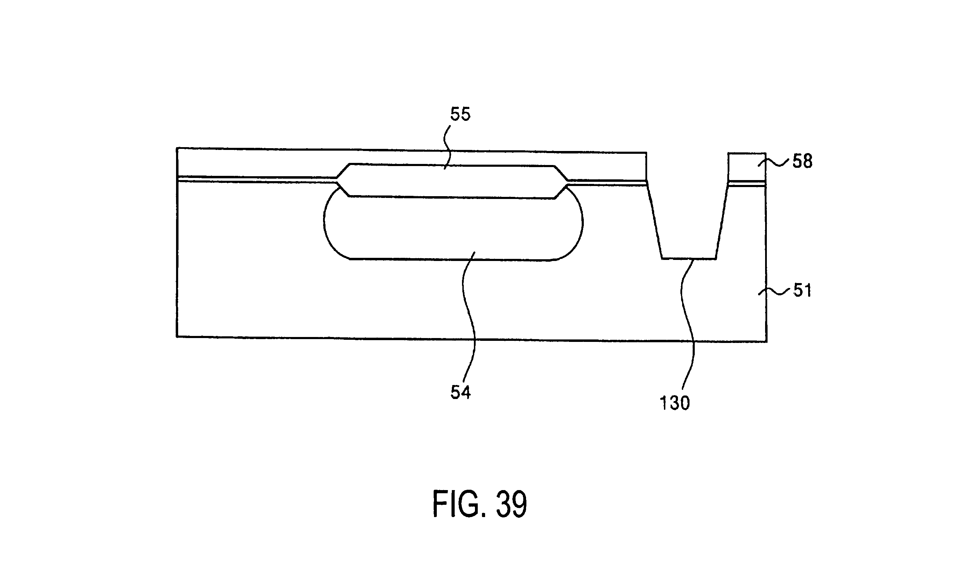

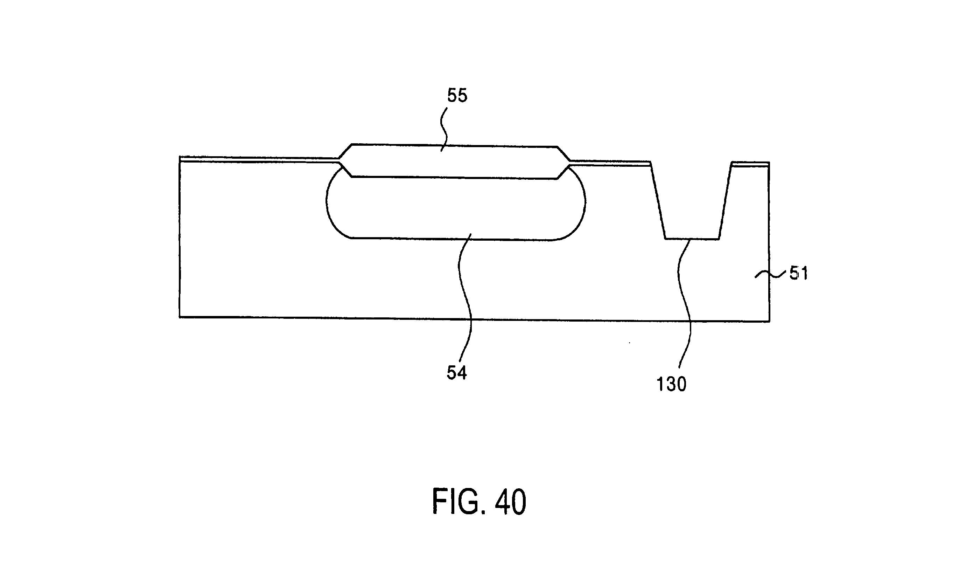

A manufacturing process of the semiconductor device shown in FIG. 36 is described below. FIGS. 37-47 are vertical sectional views showing intermediate states of manufacture of the semiconductor device shown in FIG. 36. First, an n-well region 54 is formed selectively in a surface layer of a semiconductor substrate 51, and a selective oxidation film 55 is formed on the surface of the n-well region 54 by diffusive oxidation (see FIG. 37). Then, a mask 58 having an opening in a trench forming area is formed on the substrate surface (see FIG. 38). A trench 130 is formed by trench etching using the mask 58 (see FIG. 39). The mask 58 is removed thereafter (see FIG. 40).

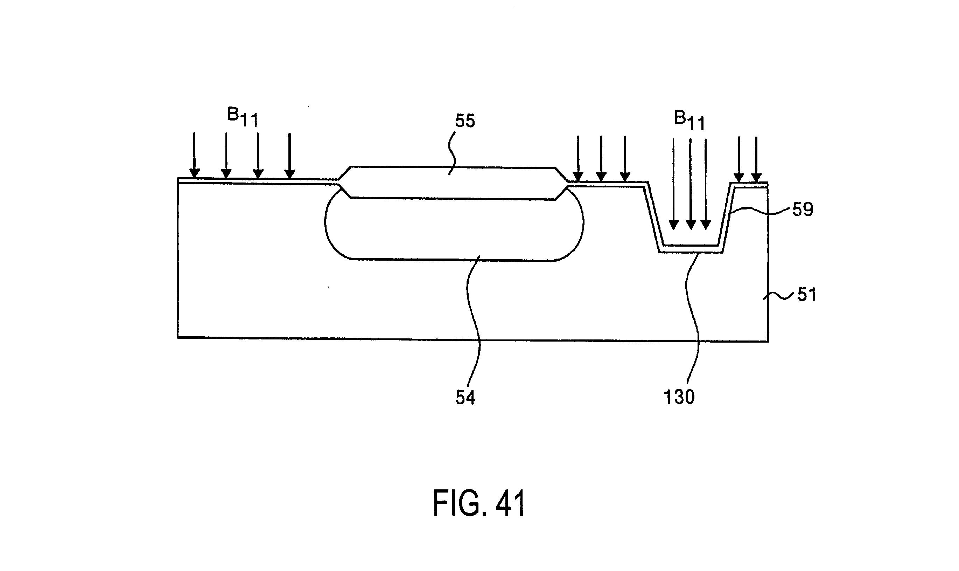

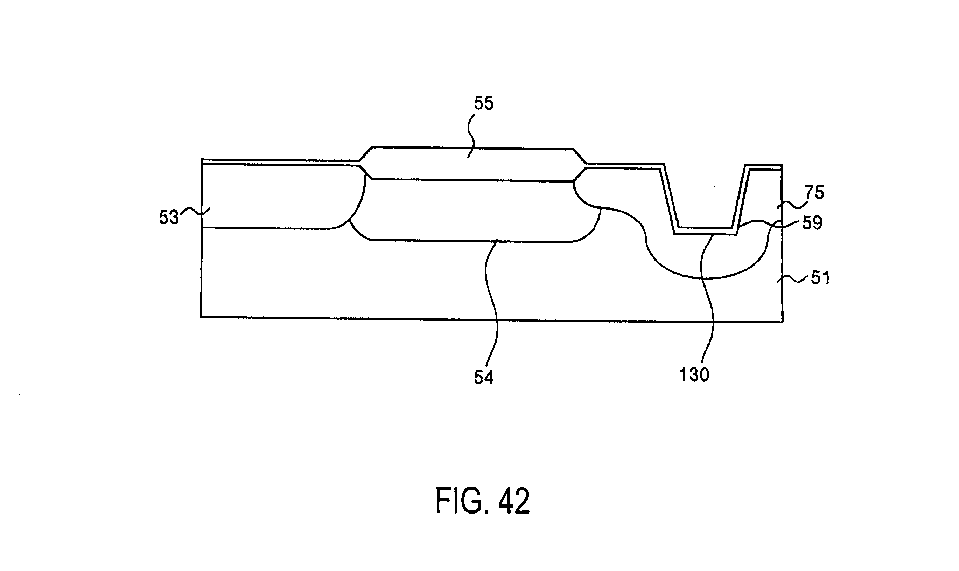

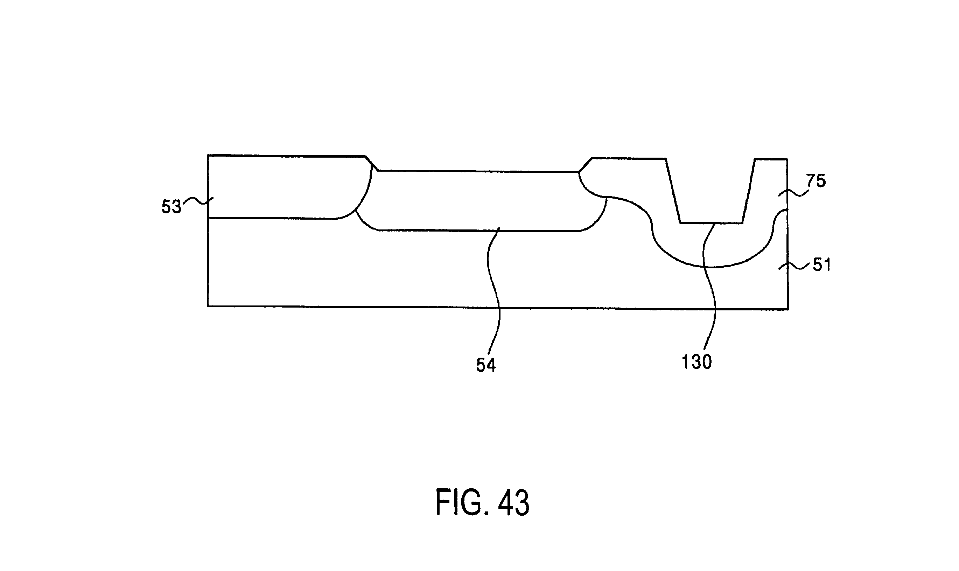

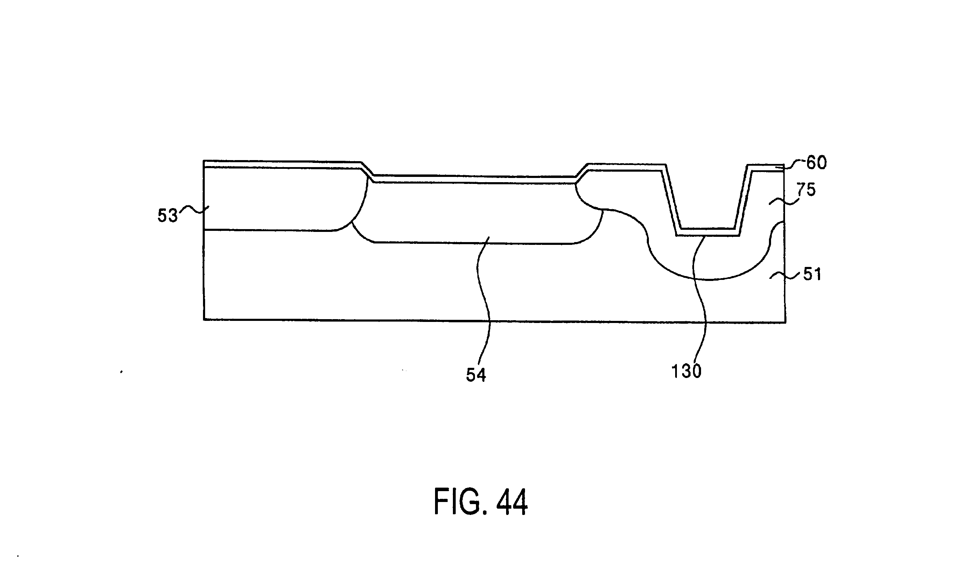

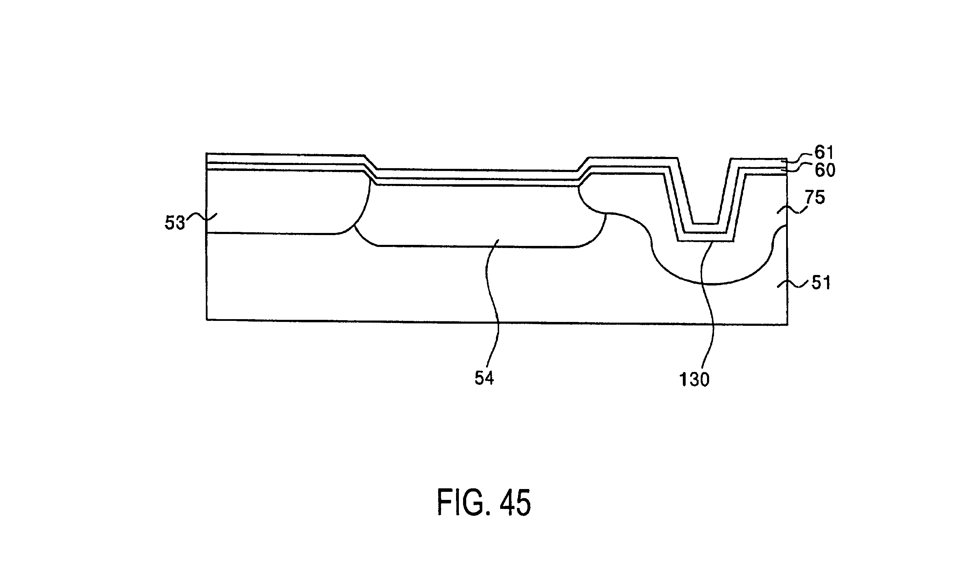

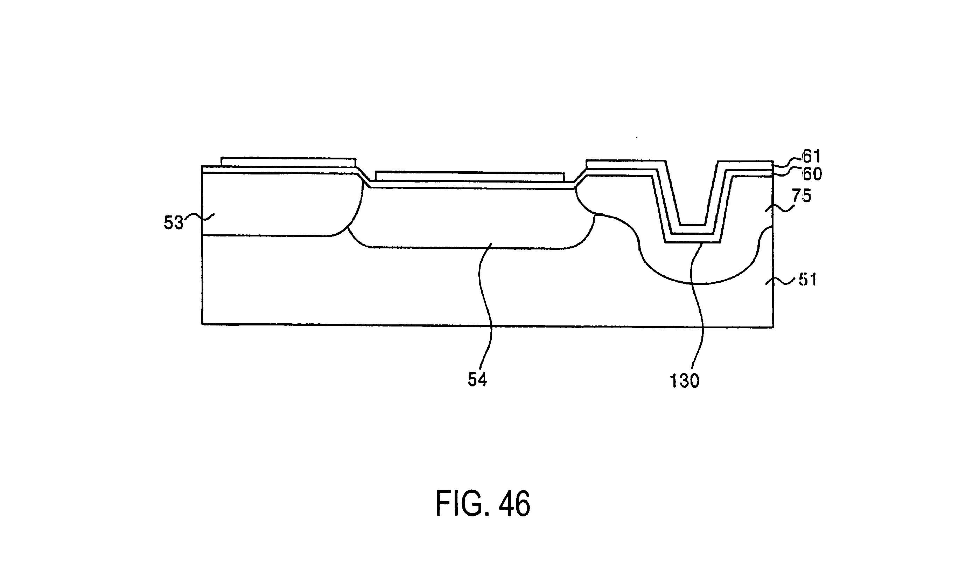

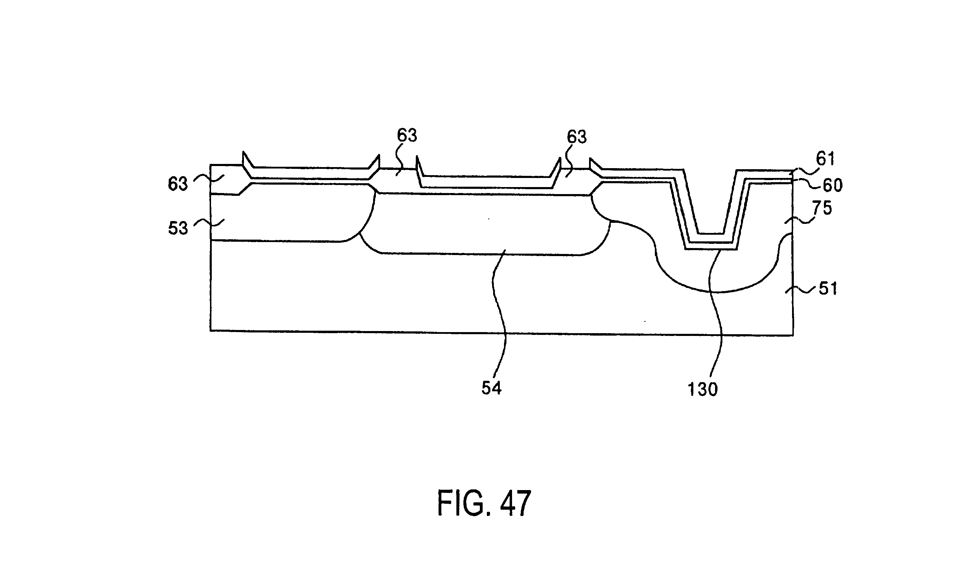

Subsequently, after a buffer oxide film 59 is formed on the side surfaces of the trench 130, the substrate 51 is doped with B₁₁ on both sides the trench 130, under the bottom surface of the trench 130, and in an NMOS forming region, by using the selective oxidation film 55 as a mask (see FIG. 41), whereby a first p-well region 75 and a second p-well region 53 is formed (see FIG. 42). After the selective oxidation film 55 and the buffer oxide film 59 are removed completely (see FIG. 43), a buffer oxide film 60 is formed on the substrate surface and the surface of the trench 130 (see FIG. 44). A silicon nitride film 61 is formed on the buffer oxide film 60 (see FIG. 45) and patterned, whereby a mask having openings in device isolation areas is formed (see FIG. 46). Selective oxidation films 63 for device isolation are formed by thermal oxidation (see FIG. 47).

The operations of the first embodiment shown in FIGS. 15-27 are thereafter executed in order and then a passivation film 71 is formed and drain electrodes and source electrodes are formed, wherein a semiconductor device having the configuration of FIG. 36 is completed.

In addition to the same advantage of the first embodiment that a one-chip power IC that is small in size and low in on-resistance and cost can be obtained, the second embodiment provides an advantage that a TLPM 104 of an arbitrary output stage that is free of the punch-through phenomenon even without a field region can be obtained because the p-well region 75 has a generally constant depth, including under the trench 130.

A semiconductor device according to a third embodiment of the invention is constructed by forming the trench 130 after the selective oxidation films 63 for device isolation are formed and after formation of the p-well region 52 and 53 and the n-well region 54. Therefore, a completed semiconductor device has the same configuration in a vertical cross-section as the semiconductor device of the first embodiment shown in FIG. 1, and hence will not be illustrated or described. Regions, electrodes, etc. of the semiconductor device according to the third embodiment having the same names in the semiconductor device according to the first embodiment are given the same reference numerals as the latter.

FIGS. 48-61 are vertical sectional views showing intermediate states of manufacture of the semiconductor device according to the third embodiment of the invention. First, after an n-well region 54 and p-well regions 52 and 53 are formed selectively in a surface layer of a semiconductor substrate 51 in the same manner as in the operations of FIGS. 2 and 3 of the first embodiment, a buffer oxide film 56 is formed on the substrate surface (see FIG. 48).

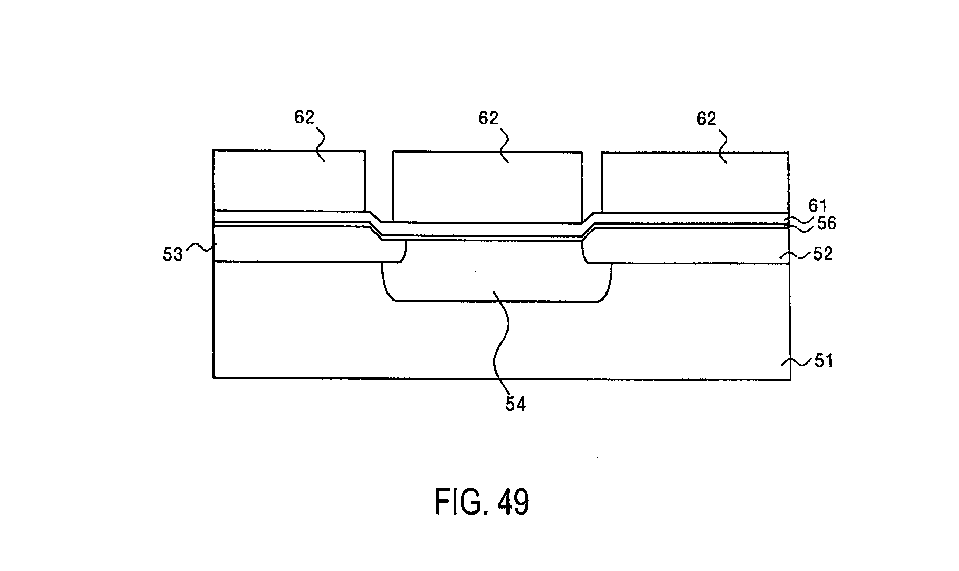

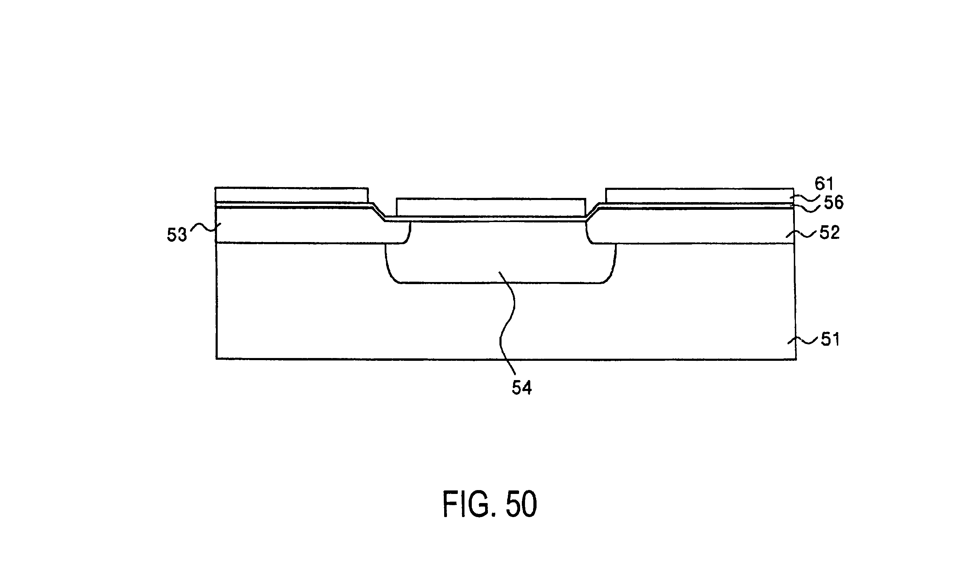

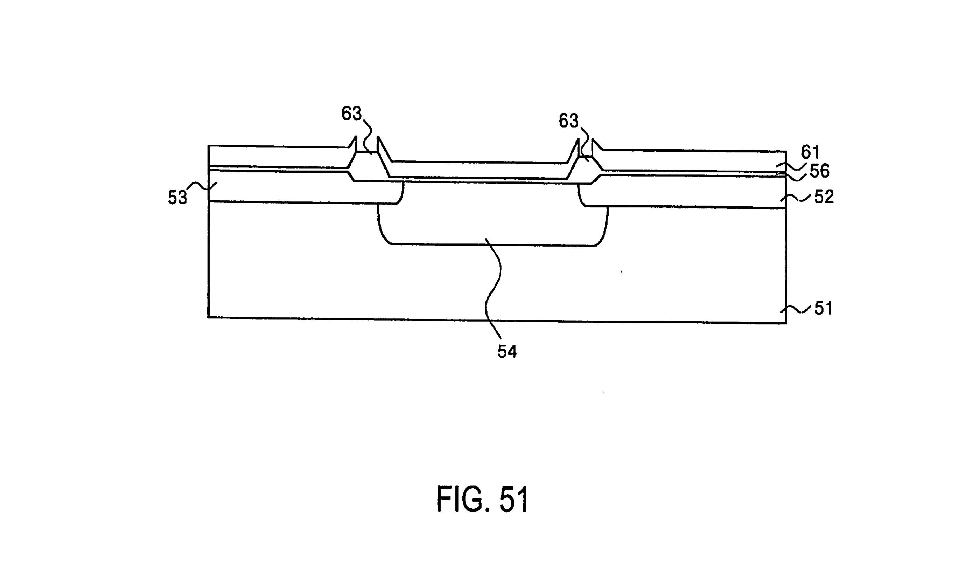

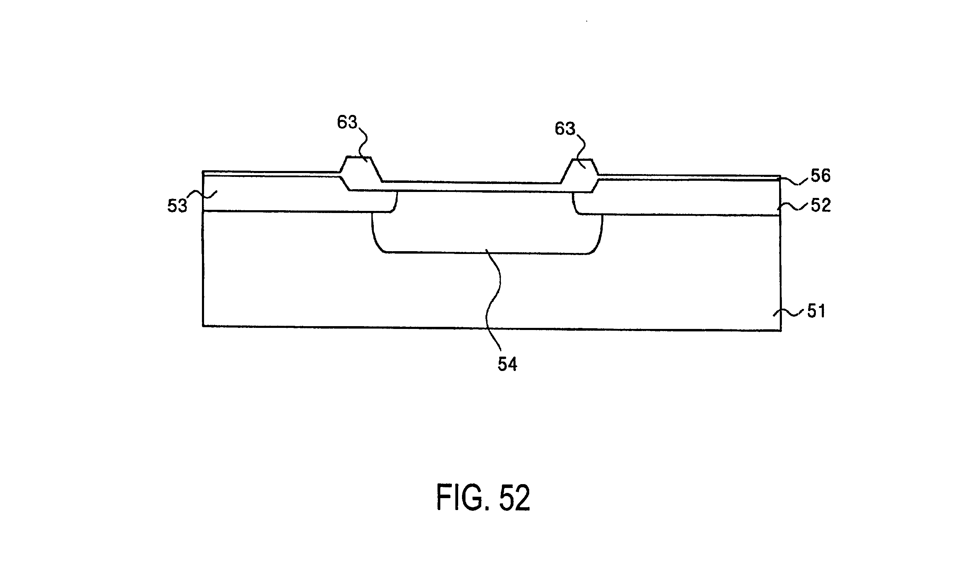

A silicon nitride film 61 is formed on the buffer oxide film 56, and a mask 62 having openings in device isolation areas is formed thereon (see FIG. 49). The silicon nitride film 61 is patterned by using the mask 62 and the mask 62 is removed (see FIG. 50). Thermal oxidation is performed by using, as a mask, the silicon nitride film 61 remaining on the substrate surface, whereby selective oxidation films 63 for device isolation are formed (see FIG. 51). The silicon nitride film 61 is removed thereafter (see FIG. 52).

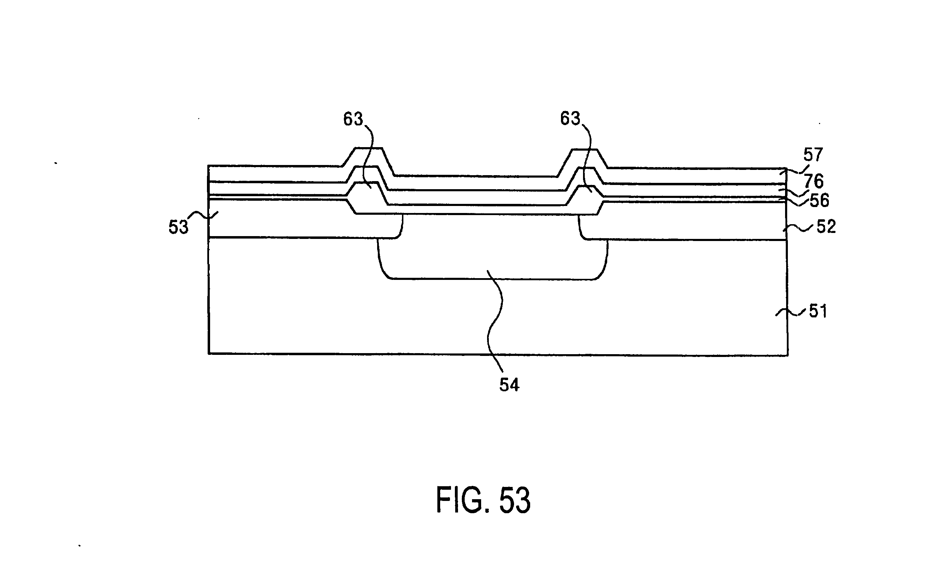

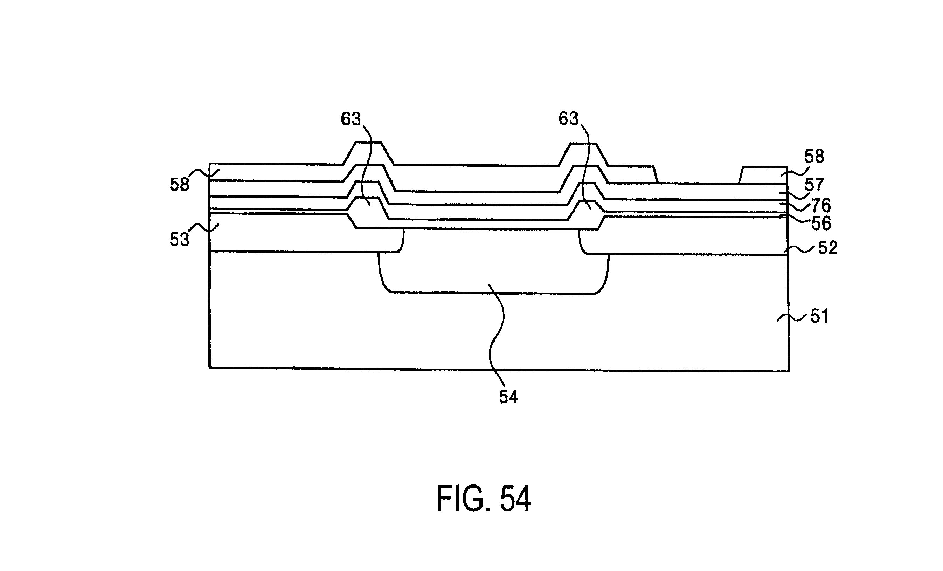

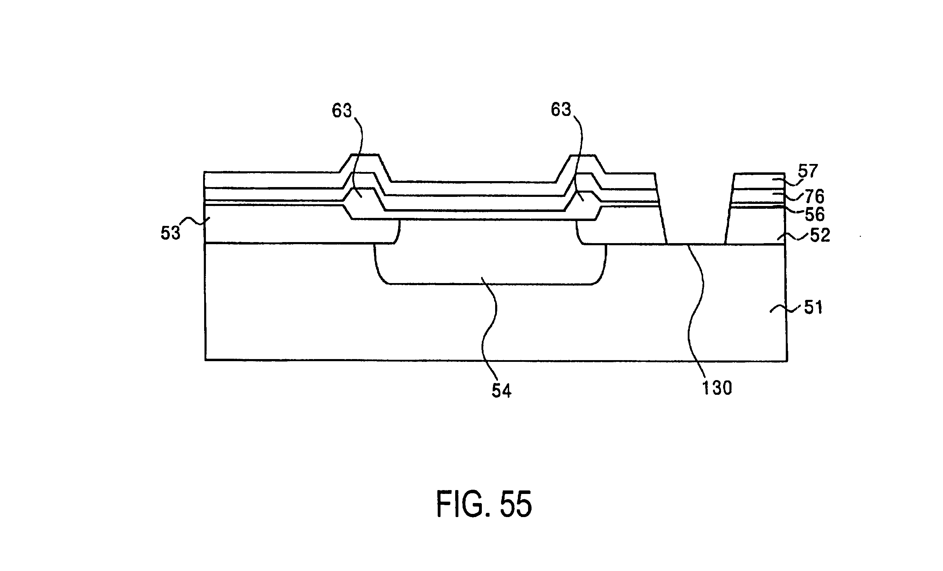

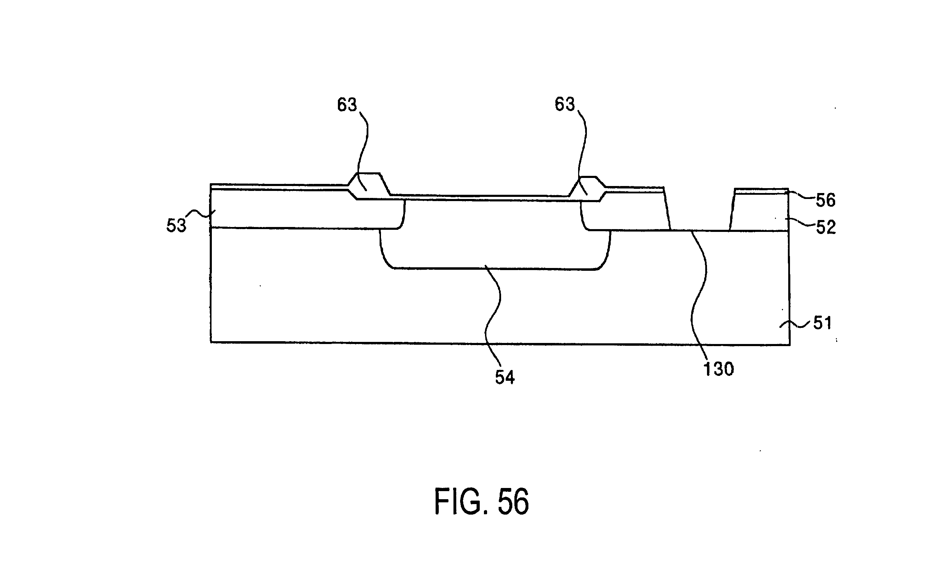

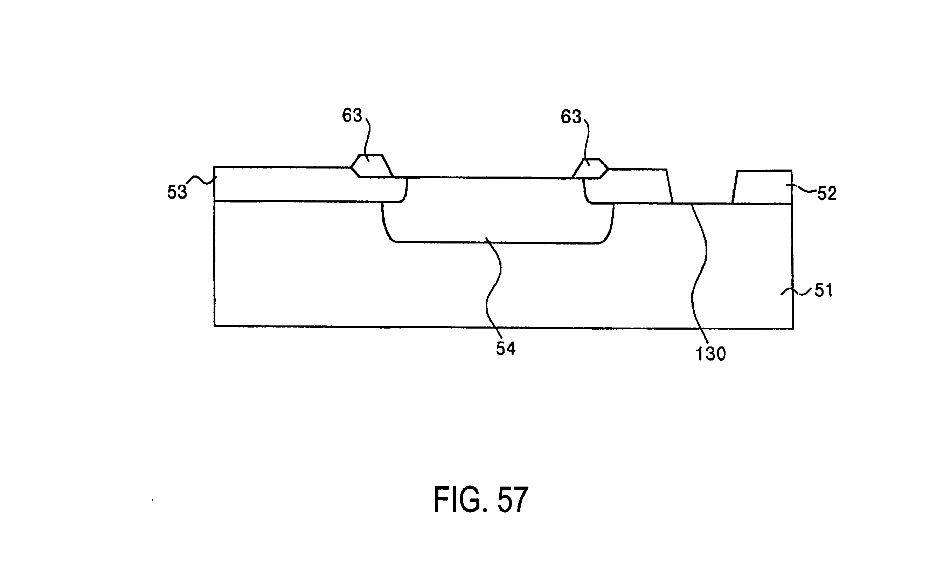

A silicon nitride film 76 is formed again on the substrate surface and a mask oxide film 57 is laid thereon (see FIG. 53). A mask 58 having an opening in a trench forming area is formed on the mask oxide film 57 (see FIG. 54). The mask oxide film 57 is patterned by using the mask 58. After the mask 58 is removed, a trench 130 is formed by trench etching (see FIG. 55). The mask oxide film 57 and the silicon nitride film 76 are removed (see FIG. 56), and the buffer oxide film 56 is removed while the selective oxidation films 63 are left (see FIG. 57).

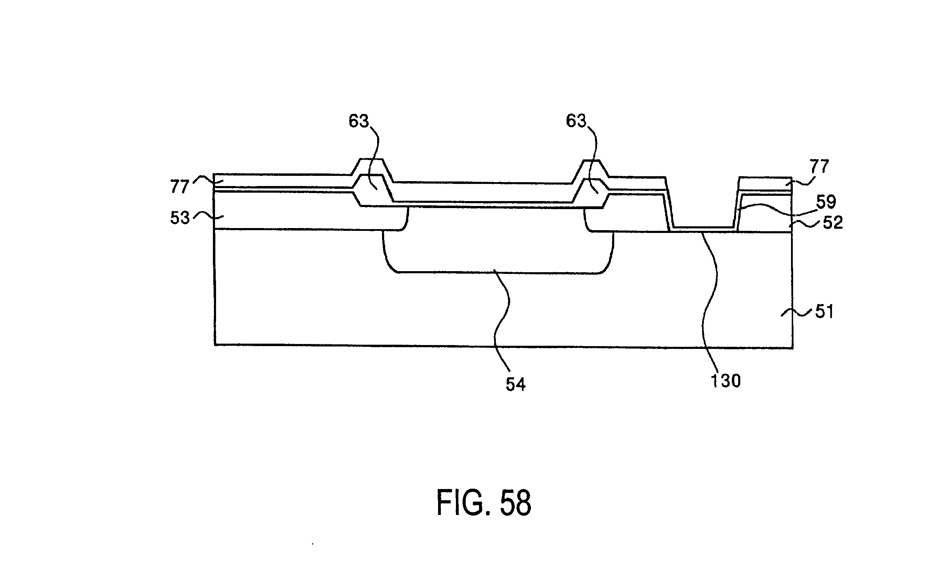

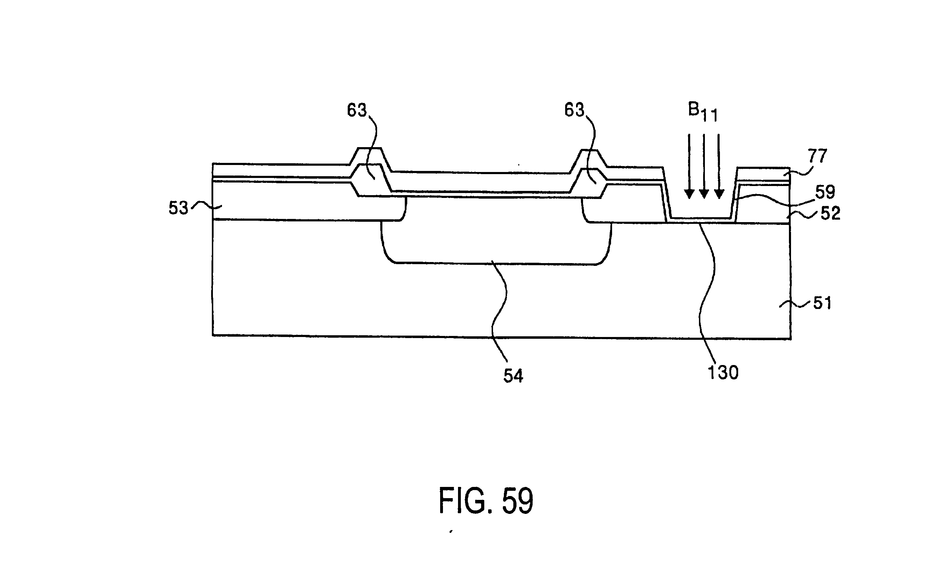

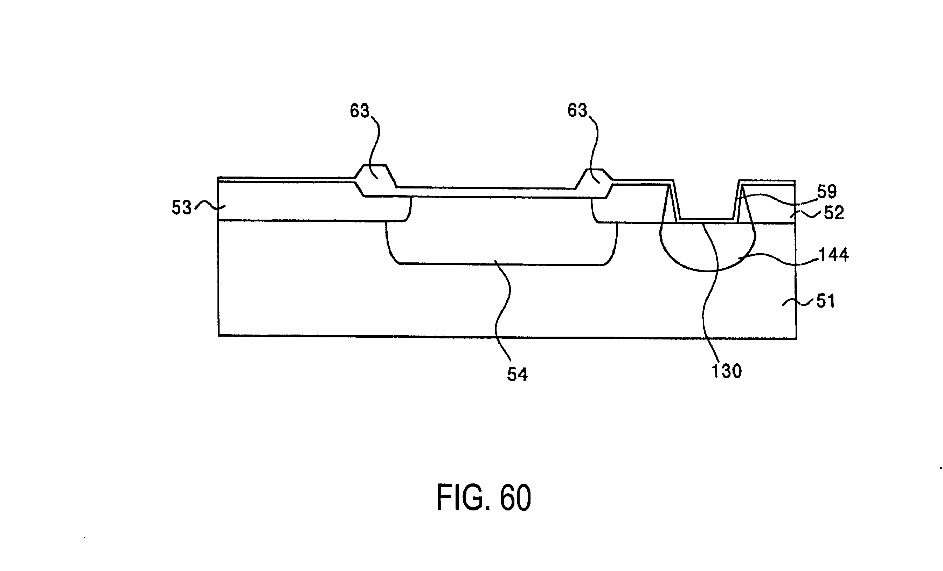

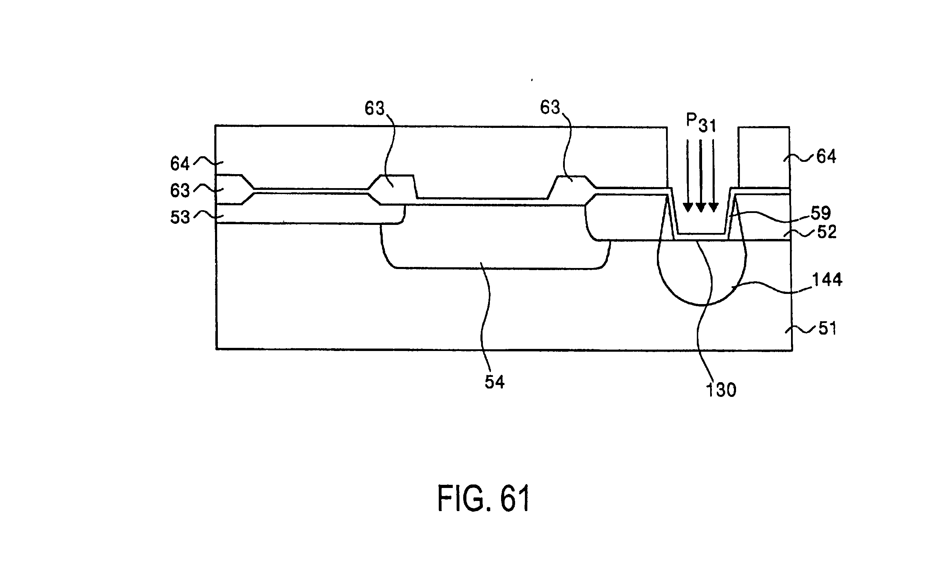

Subsequently, a buffer oxide film 59 is formed on the surface of the trench 130 and a mask 77 is formed so as to cover the substrate surface except the trench 130 (see FIG. 58). The substrate 51 is doped with B₁₁ under the bottom surface of the trench 130 by using the mask 77 (see FIG. 59), whereby a field region 144 is formed. The mask 77 is removed thereafter (see FIG. 60). Then, a mask 64 having an opening over the trench 130 is formed on the substrate surface and the substrate 51 is doped with P₃₁ (see FIG. 61).

As a result, an extended drain region 122 is formed as shown in FIG. 16. The operations of the first embodiment shown in FIGS. 17-27 are thereafter executed in order and then a passivation film is formed and drain electrodes and source electrodes are formed, to complete a semiconductor device. Like the first embodiment, the third embodiment provides the advantage that a one-chip power IC that is small in size and low in on-resistance and cost can be obtained.

FIG. 62 is a vertical sectional view showing the configuration of a semiconductor device according to a fourth embodiment of the invention. The semiconductor device according to the fourth embodiment is different from the semiconductor device of FIG. 1 according to the first embodiment in that a TLPM 101 (see FIG. 28), rather than the NMOS 200, is formed in the second p-well region 53 and a TLPM 101, rather than the TLPM 100, is formed in the first p-well region 52. The configuration of the TLPM 101 will not be described to avoid redundancy. Regions, electrodes, etc. of the semiconductor device according to the fourth embodiment having the same names in the semiconductor device according to the first embodiment are given the same reference numerals as the latter and will not be described.

A manufacturing process of the semiconductor device shown in FIG. 62 will be described below. FIGS. 63-70 are vertical sectional views showing intermediate states of manufacture of the embodiment of the semiconductor device shown in FIG. 62. First, an n-well region 54 and p-well regions 52 and 53 are formed selectively in a surface layer of a semiconductor substrate 51 and a buffer oxide film 56 and a mask oxide film 57 are formed on the substrate surface in this order in the same manner as in the operations of FIGS. 2-5 of the first embodiment. A mask 58 having openings in trench forming areas is formed on the mask oxide film 57 (see FIG. 63).

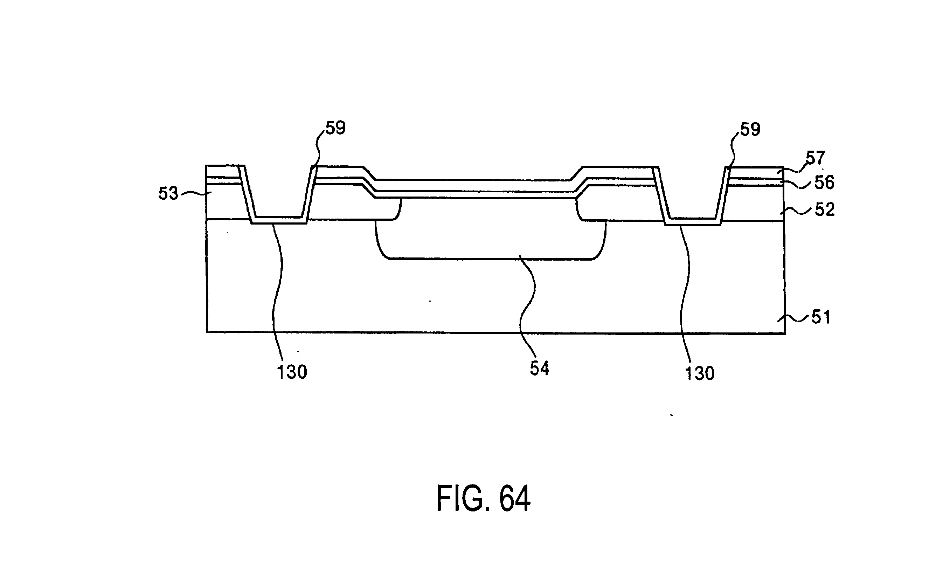

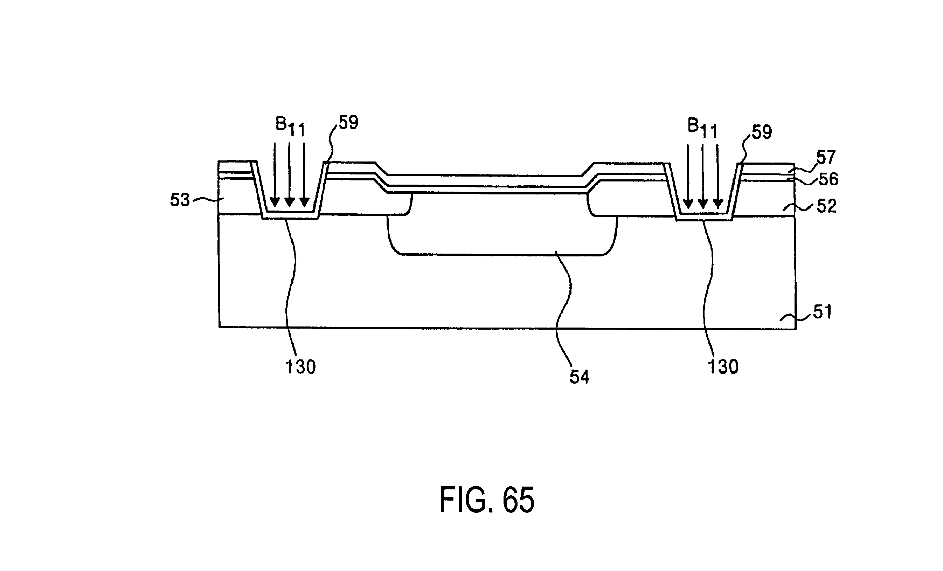

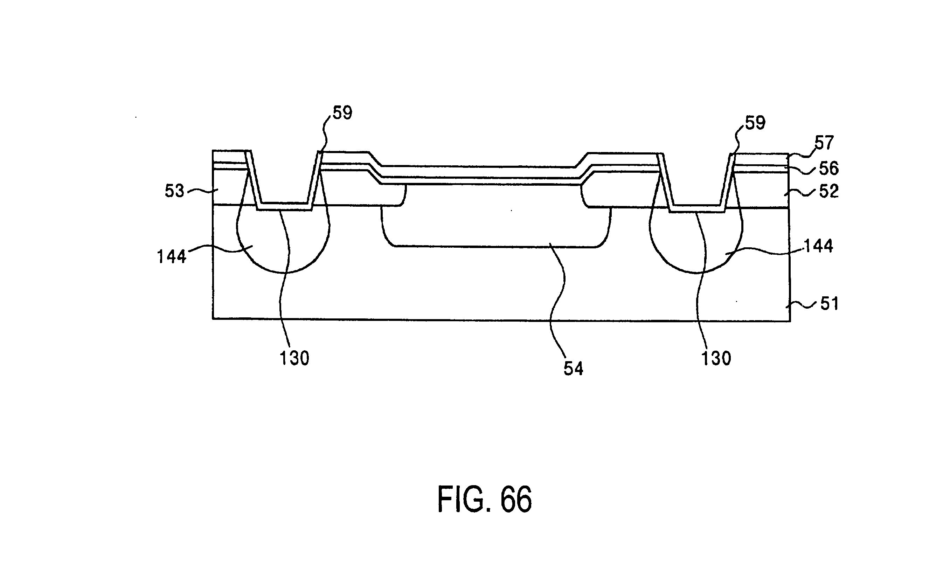

The mask oxide film 57 is patterned, the mask 58 is removed, and trench etching is performed, whereby trenches 130 are formed in the first p-well region 52 and the second p-well region 53, respectively. Buffer oxide films 59 are formed on the surfaces of the trenches 130, respectively (see FIG. 64), and the substrate 51 is doped with B₁₁ under the bottom surfaces of the trenches 130 (see FIG. 65), whereby field regions 144 are formed for the respective trenches 130 (see FIG. 66).

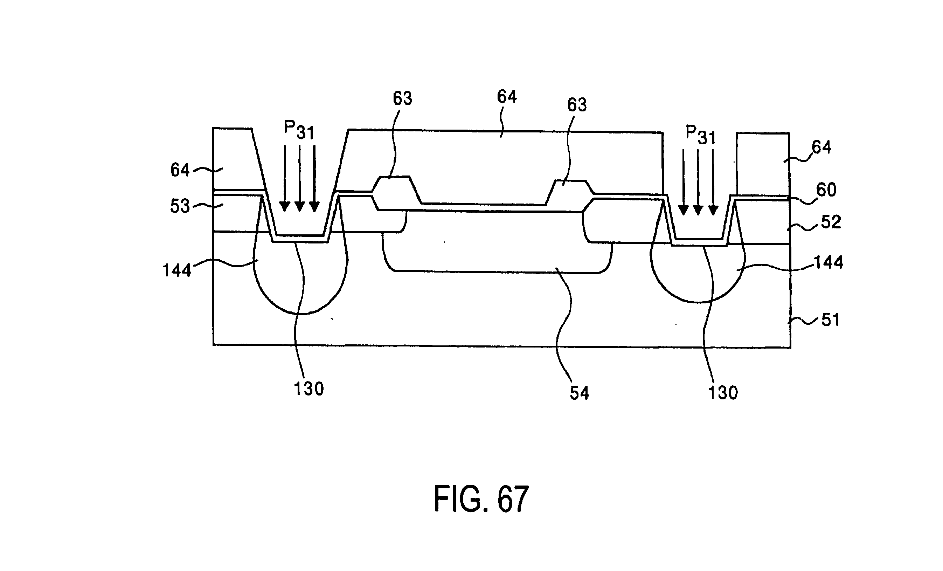

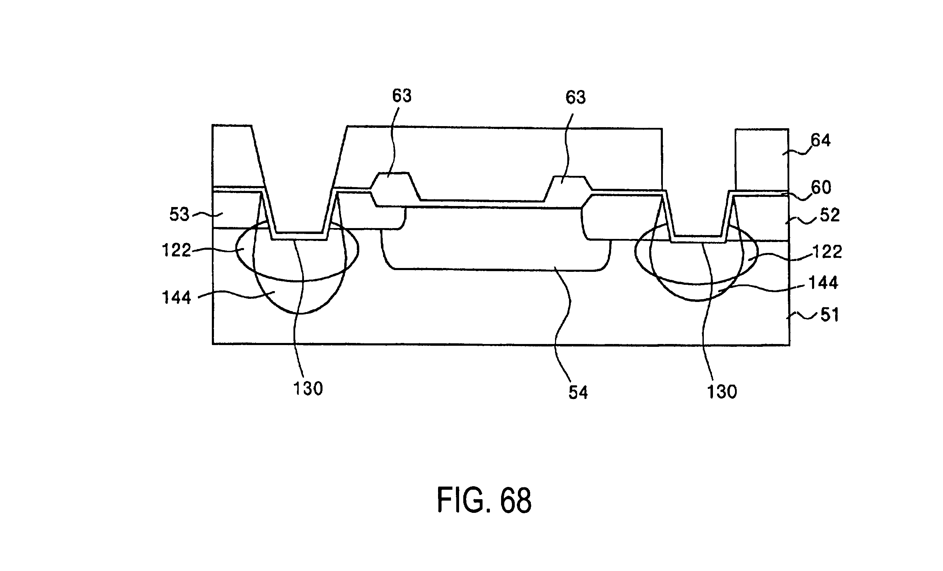

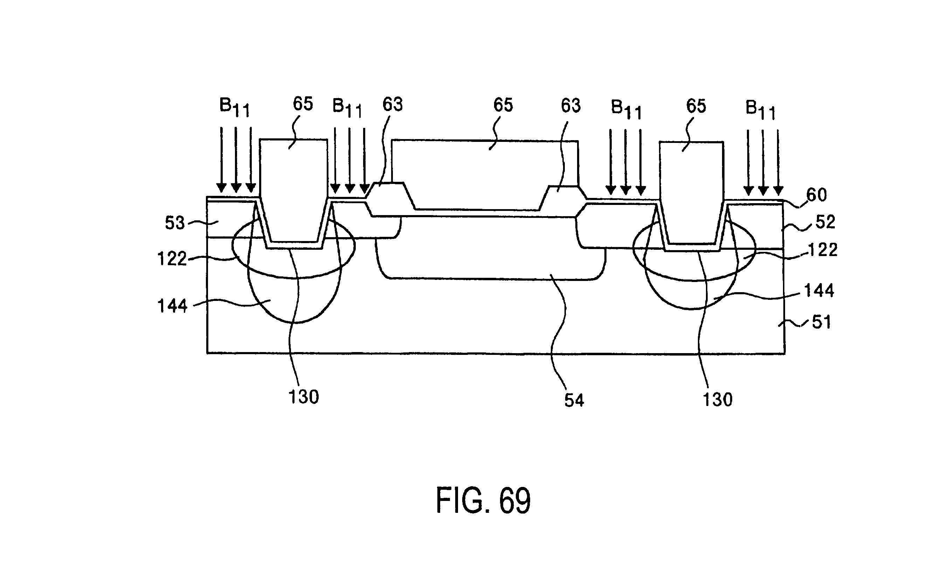

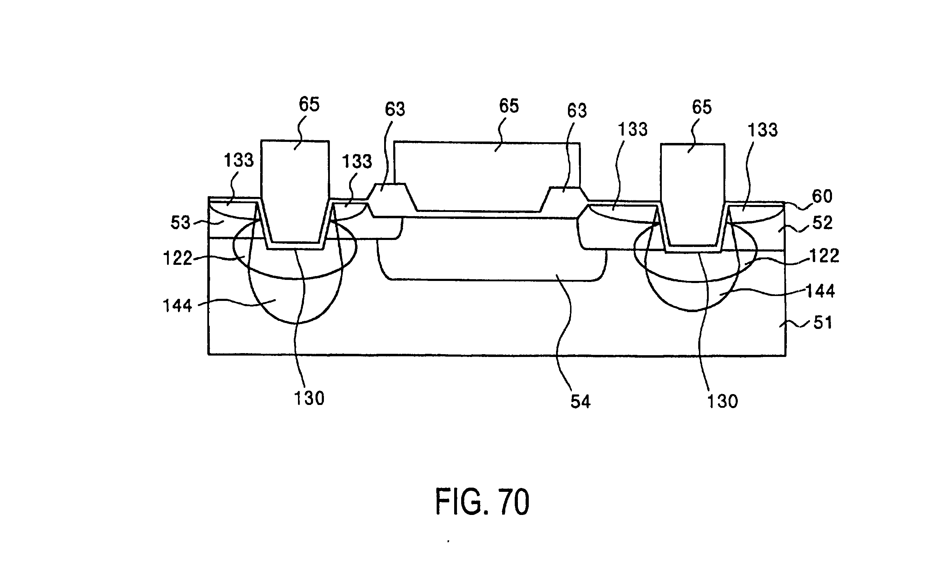

After the mask oxide film 57 and the buffer oxide films 56 and 59 are removed, selective oxidation films 63 for device isolation are formed in the same manner as in the operations of FIGS. 10-14 of the first embodiment. Then, a mask 64 having openings over the respective trenches 130 is formed on the substrate surface and the substrate 51 is doped with P₃₁ (see FIG. 67), to form extended drain regions 122 for the respective trenches 130 (see FIG. 68). Then, a mask 65 having openings in future channel regions of the intended TLPMs is formed on the substrate surface, and the substrate 51 is doped with B₁₁ (see FIG. 69), to form channel regions 133 of the intended TLPMs in the first p-well region 52 and the second p-well region 53 (see FIG. 70).

After the mask 65 is removed, the operations of FIGS. 15-27 of the first embodiment are executed on the TLPMs in order and then a passivation film 71 is formed and drain electrodes and source electrodes are formed, to complete a semiconductor device having the configuration of FIG. 62. To lower the on-resistance by increasing the impurity concentration of the extended drain region 122, a TLPM in which the p-well regions 52 and 53 are deeper than the extended drain region 122 and the extended drain region 122 is formed in the p-well regions 52 and 53 may be employed instead of the TLPN 101 shown in Fig. 62. The TLPM 101 in Fig. 62 may be replaced by the TLPM 100 in Fig. 1, the TLPM 103 in Fig. 30, or the TLPM 102 in Fig. 29. Like the first embodiment, the fourth embodiment provides the advantage that a one-chip power IC that is small in size and low in on-resistance and cost can be obtained.

FIG. 71 is a vertical sectional view showing the configuration of a semiconductor device according to a fifth embodiment of the invention. The semiconductor device according to the fifth embodiment is different from the semiconductor device of FIG. 1 according to the first embodiment in that a TLPM 301, rather than the PMOS 300, is formed in the n-well region 54. The n-type drain region 123 of the TLPM 100 formed in the first p-well region 52 in FIG. 71 is the same as that of the TLPM 100 shown in FIG. 1 except that the shape is slightly different. Regions, electrodes, etc. of the semiconductor device according to the fifth embodiment having the same names in the semiconductor device according to the first embodiment are given the same reference numerals as the latter and will not be described.

The TLPM 301 will be described below. A trench 330 is formed in the n-well region 54. The side surface and the bottom surface of the trench 330 are surrounded by a field region 344, and a p-type extended drain region 352 that is shallower than the field region 344 is provided adjacent to the side surface and the bottom surface of the trench 330. A p-type drain region 353 is provided inside the extended drain region 352. A gate oxide film 359, gate electrodes 356, an oxide film (part of shadow oxide films 68 (described later)), an interlayer insulating film 131, and a drain polysilicon layer 362 are formed inside the trench 330 in this order from the outside.

N-type channel regions 363 are provided on both sides of the trench 330 in a substrate surface layer and p-type source regions 355 are provided in surface layers of the n-type channel regions 363, respectively. N-type plug regions 364 are provided outside the respective source regions 355. Each source electrode 358 penetrates through the interlayer insulating film 131 and a passivation film 71 and is in contact with both of the associated source region 355 and plug region 364 to improve grounding of the substrate 51 and prevent reduction in breakdown voltage even when a large current occurs. A drain electrode 357 penetrates through the passivation film 71 and is in electrical contact with the drain region 353 via the drain polysilicon layer 362.

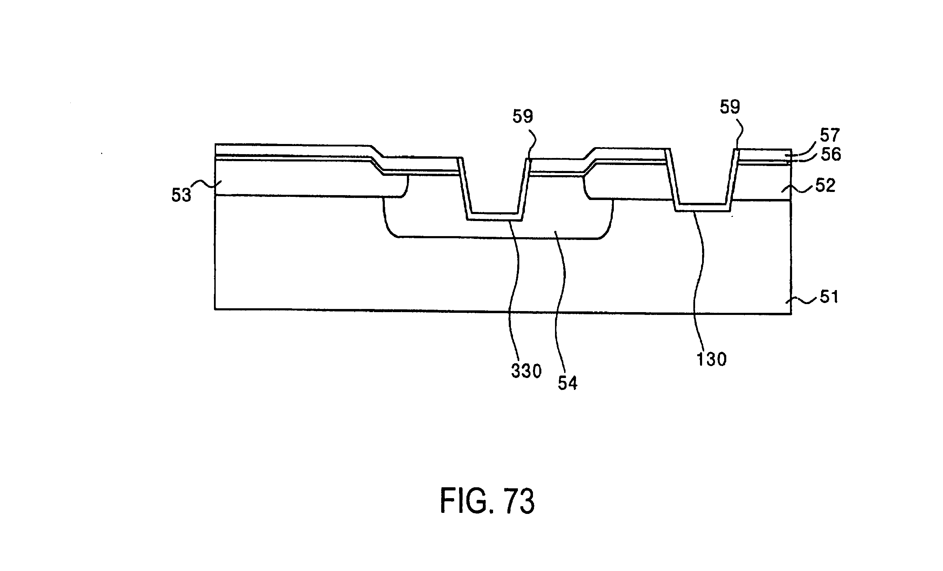

A manufacturing process of the semiconductor device shown in FIG. 71 is described below. FIGS. 72-90 are vertical sectional views showing intermediate states of manufacture of the embodiment of the semiconductor device of FIG. 71. First, an n-well region 54 and p-well regions 52 and 53 are formed selectively in a surface layer of a semiconductor substrate 51 and a buffer oxide film 56 and a mask oxide film 57 are formed on the substrate surface in this order in the same manner as in the operations of FIGS. 2-5 of the first embodiment. Then, a mask 58 having openings in trench forming areas is formed on the mask oxide film 57 (see FIG. 72). The mask oxide film 57 is patterned, the mask 58 is removed, and trench etching is performed, whereby a trench 130 is formed in the first p-well region 52 and a trench 330 is formed in the n-well region 54. Buffer oxide films 59 are formed on the surfaces of the trenches 130 and 330, respectively (see FIG. 73).

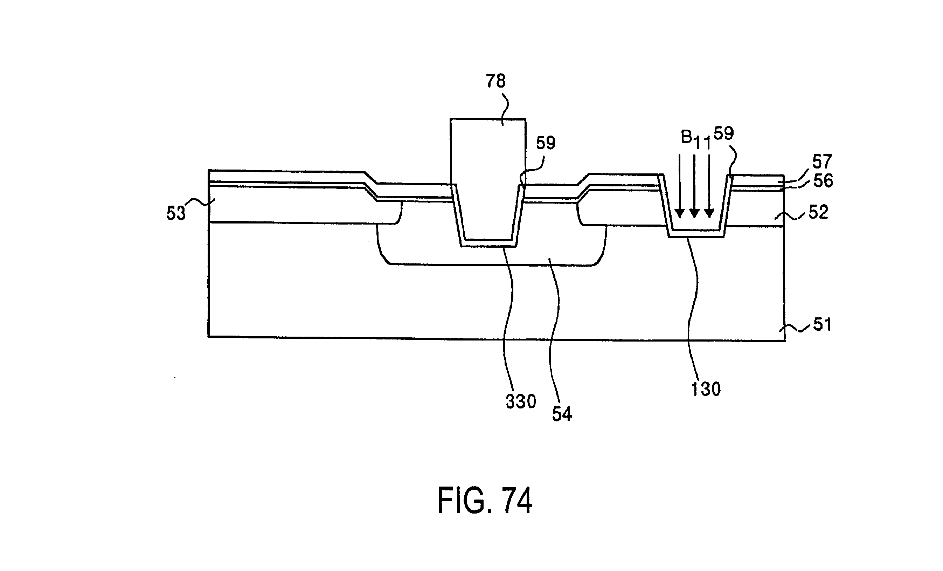

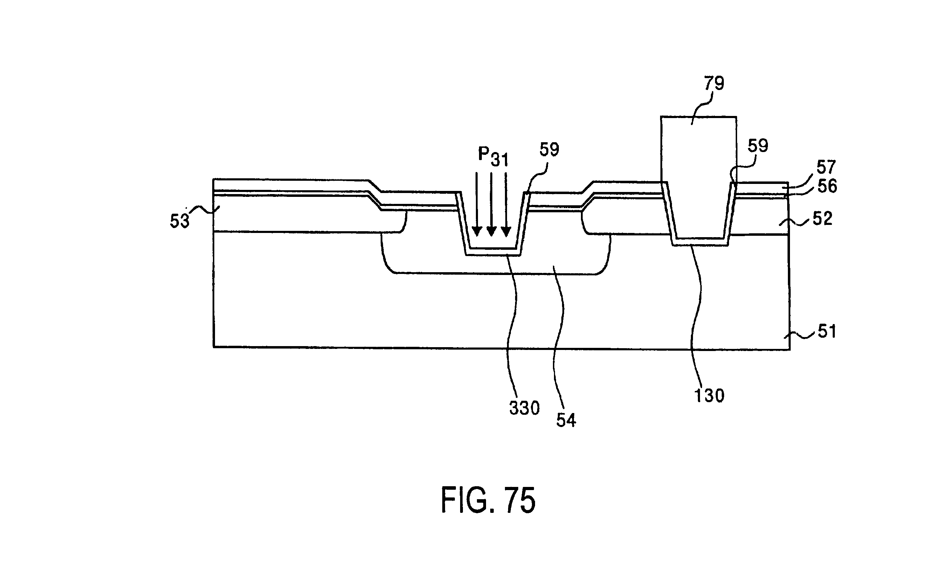

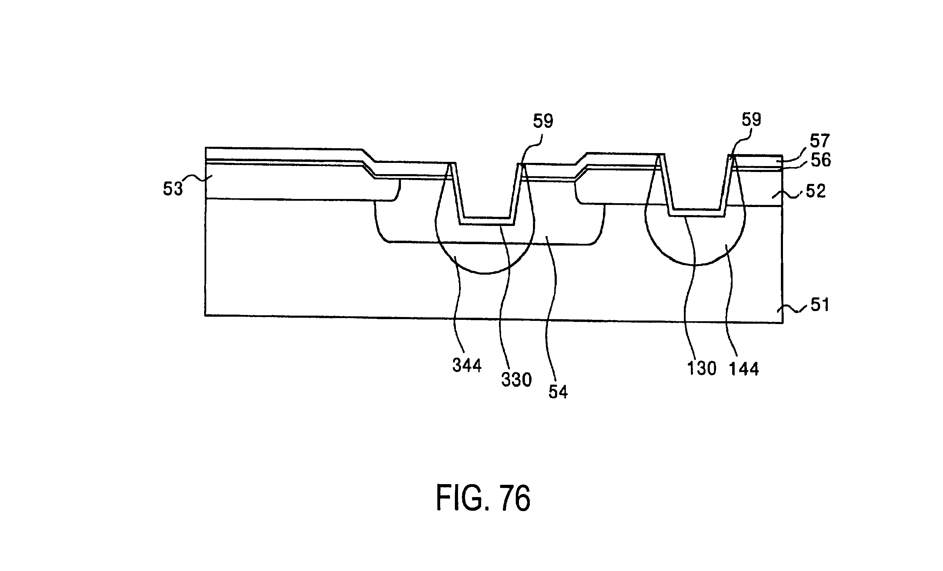

Subsequently, the trench 330 in the n-well region 54 is covered with a mask 78 and the substrate 51 is doped with B₁₁ under the bottom surface of the trench 130 in the first p-well region 52 (see FIG. 74). After the mask 78 is removed, the trench 130 in the first p-well region 52 is covered with a mask 79 and the substrate 51 is doped with P₃₁ under the bottom surface of the trench 330 in the n-well region 54 (see FIG. 75). The mask 79 is removed and thermal diffusion is performed, to form field regions 144 and 344 for the respective trenches 130 and 330 (see FIG. 76). The operations of FIG. 74 and the operations of FIG. 75 may be reversed.

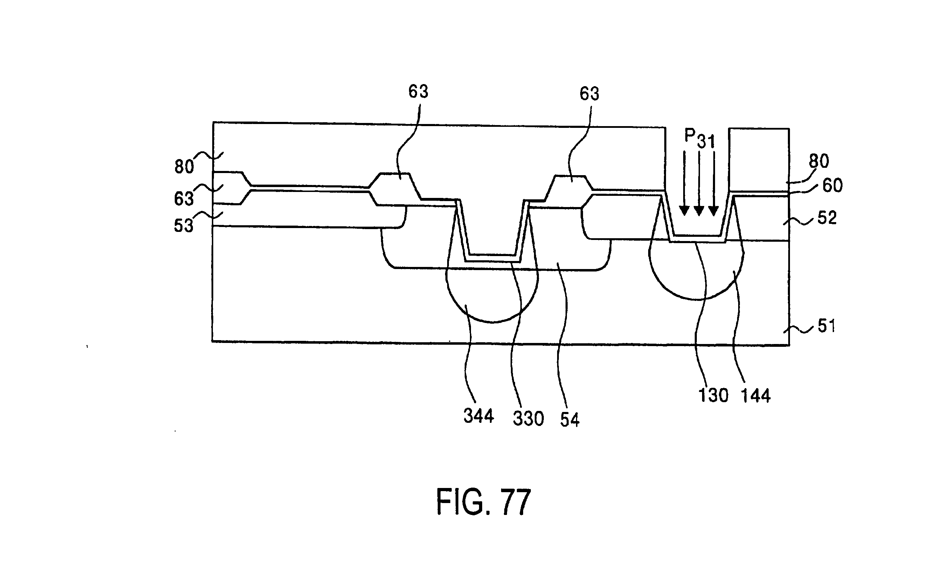

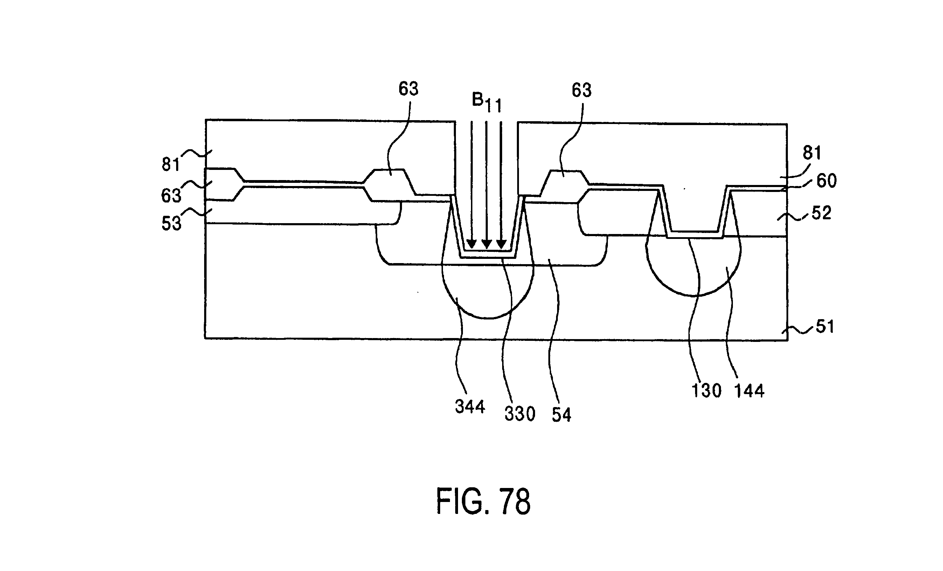

After the mask oxide film 57 and the buffer oxide films 56 and 59 are removed, selective oxidation films 63 for device isolation are formed in the same manner as in the operations of FIGS. 10-14 of the first embodiment. Then, a mask 80 having an opening over the trench 130 in the first p-well region 52 is formed on the substrate surface and the substrate 51 is doped with P₃₁ (see FIG. 77). After the mask 80 is removed, a mask 81 having an opening over the trench 330 in the n-well region 54 is formed on the substrate surface and the substrate 51 is doped with B₁₁ (see FIG. 78). The mask 81 is removed and thermal diffusion is performed, to form extended drain regions 122 and 352 for the respective trenches 130 and 330

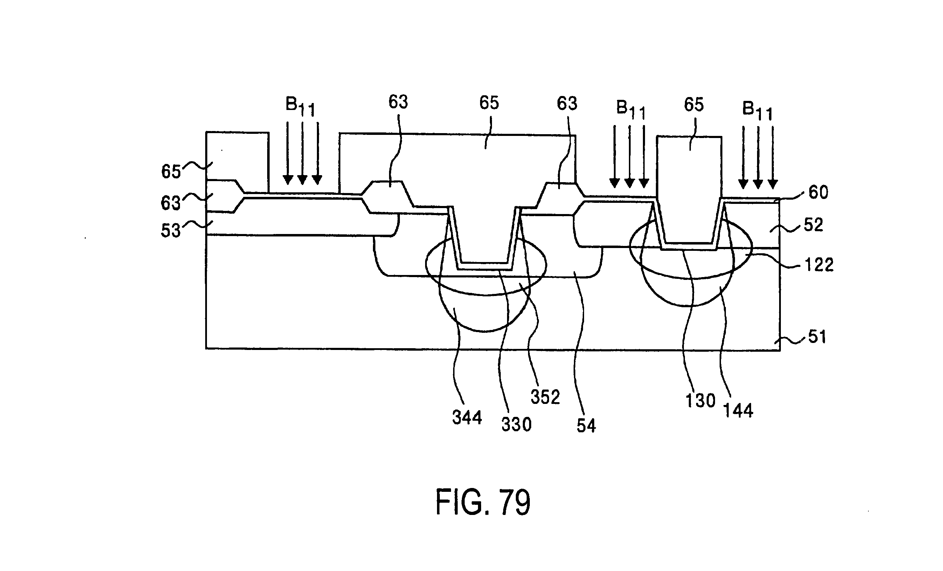

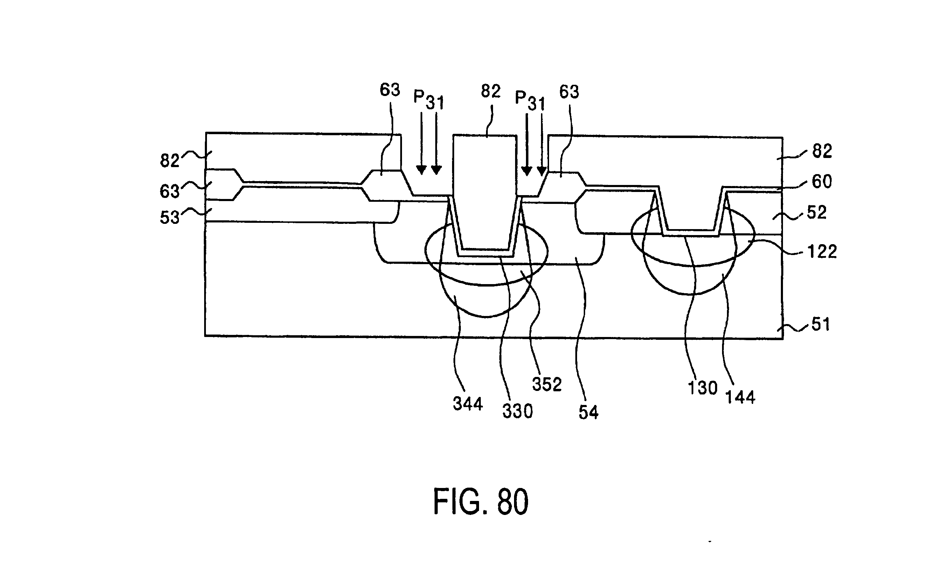

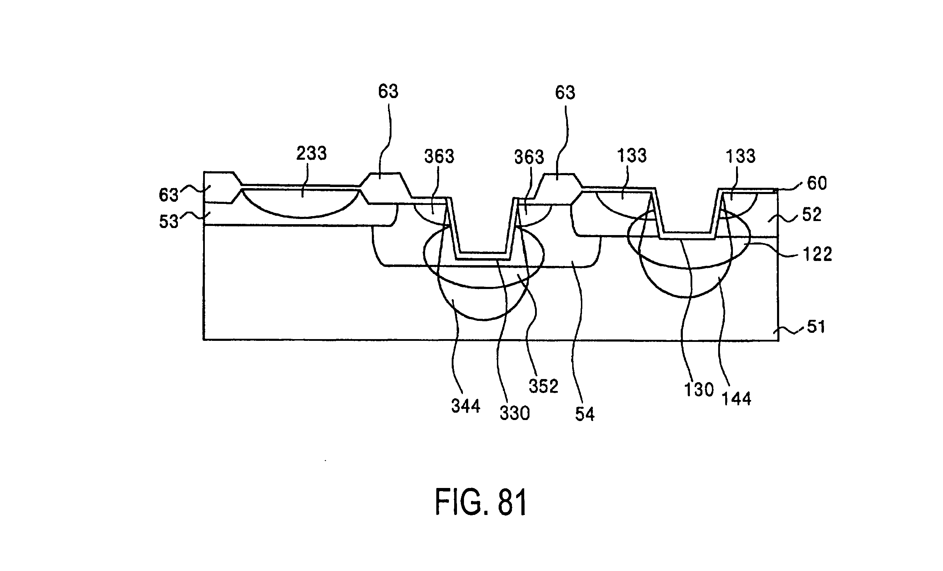

Then, a mask 65 having openings in areas corresponding to future channel regions of the TLPM to be formed in the first p-well region 52 and an area corresponding to the NMOS to be formed in the second p-well region 53 is formed on the substrate surface, and the substrate 51 is doped with B₁₁ (FIG. 79). After the mask 65 is removed, a mask 82 having openings in areas corresponding to future channel regions of the TLPM to be formed in the n-well region 54 is formed on the substrate surface and the substrate 51 is doped with P₃₁ (see + 80). The mask 82 is removed and thermal diffusion is performed, whereby channel regions 133 of the intended TLPM are formed in the first p-well region 52, a channel region 233 of the intended NMOS is formed in the second p-well region 53, and channel regions 363 of the intended TLPM are formed in the n-well region 54 (see FIG. 81). The operations of FIG. 79 and FIG. 80 may be revered.

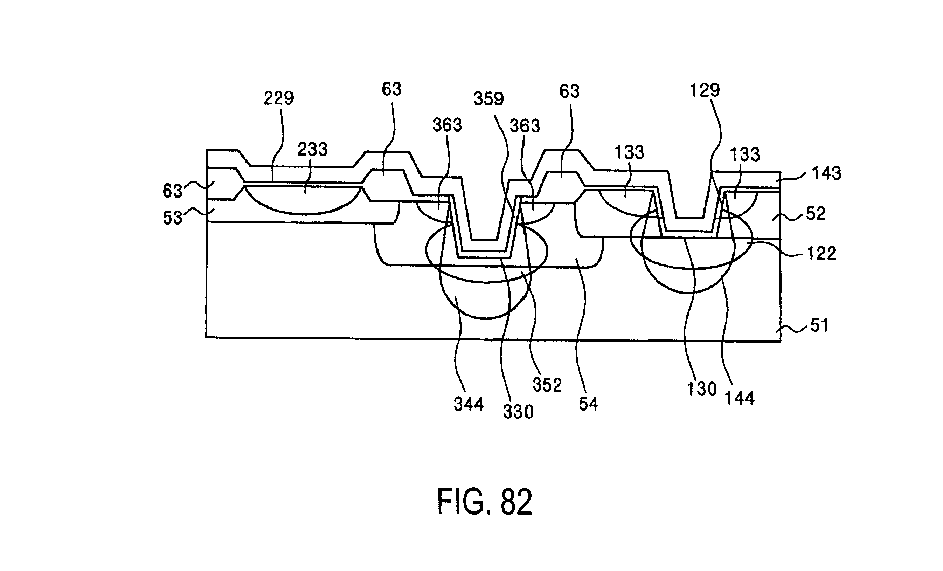

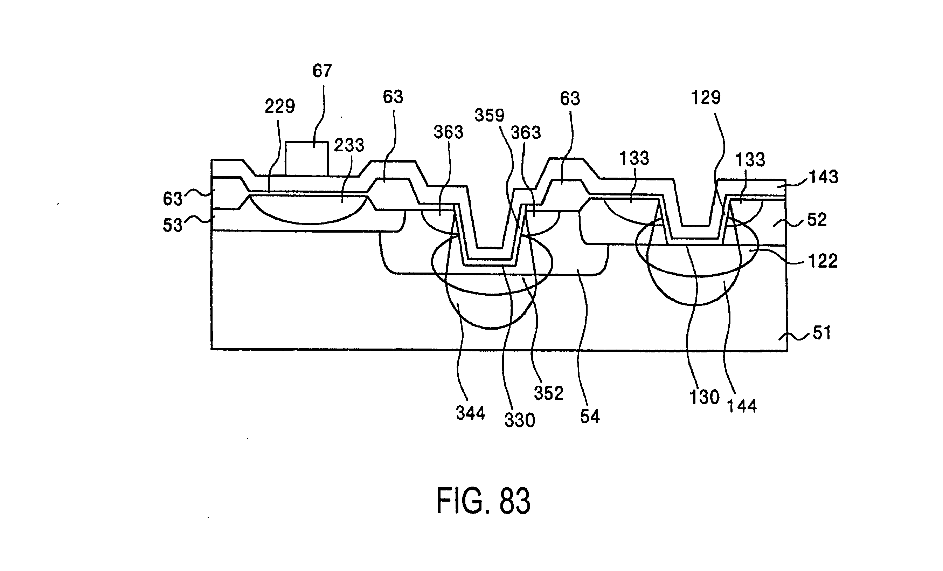

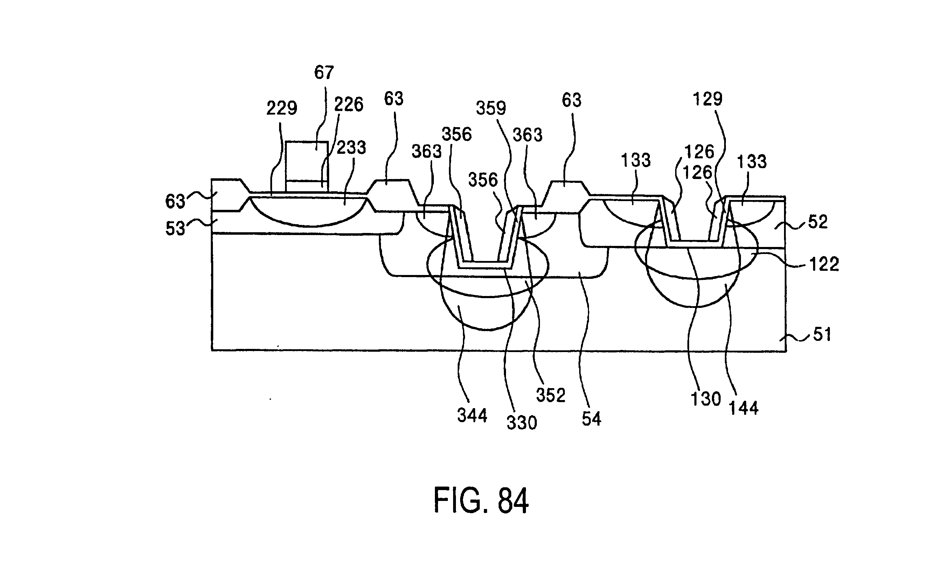

After the buffer oxide film 60 is removed, a common thin oxide film to become gate oxide films 129, 359, and 229 of the intended TLPMs and NMOS, respectively, is formed on the substrate surface and a polysilicon layer 143 is laid thereon (see FIG. 82). A mask 67 is formed on the polysilicon layer 143 only in an area corresponding to a future gate electrode of the intended NMOS (see FIG. 83). The polysilicon layer 143 is etched by using the mask 67, whereby gate electrodes 126 and 356 of the intended TLPMs are formed inside the trenches 130 and 330 by self-alignment and, at the same time, a gate electrode 226 of the intended NMOS is formed (see FIG. 84).

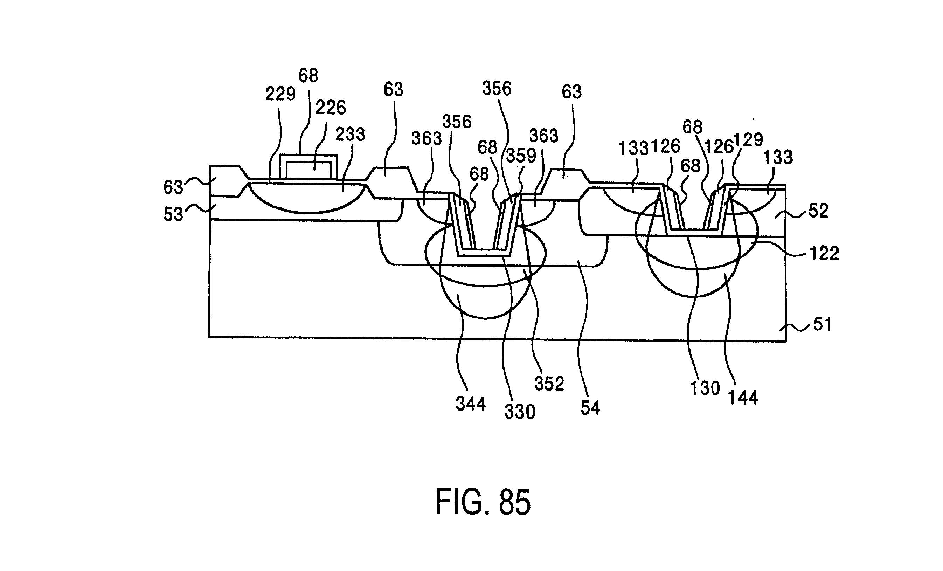

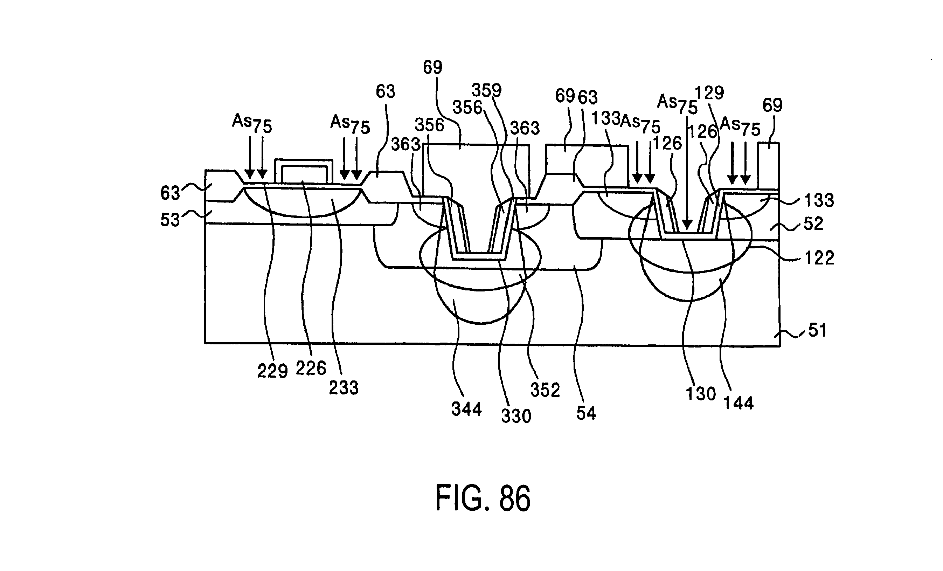

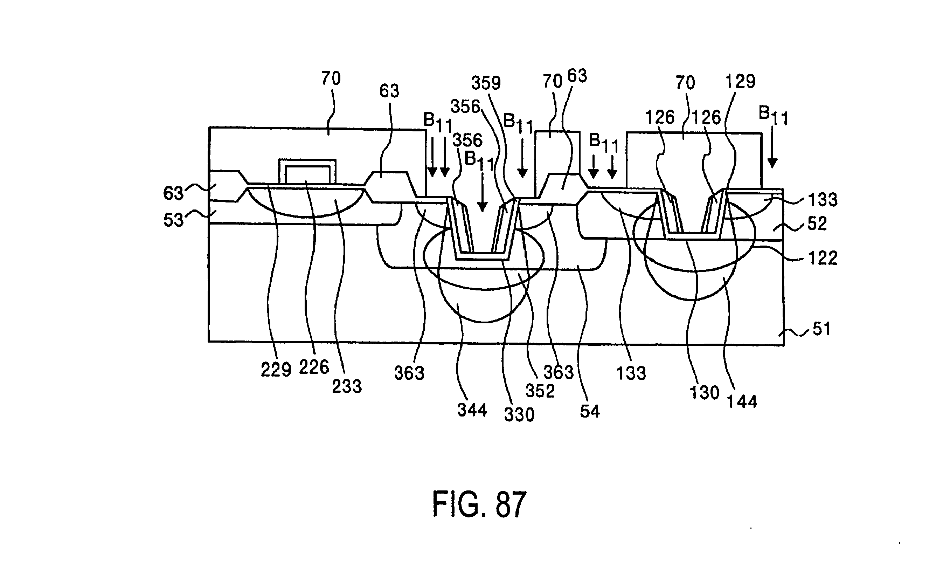

The mask 67 is removed and shadow oxide films 68 are formed to cover the gate electrodes 126 and 356 of the intended TLPMs and the gate electrode 226 of the intended NMOS (see FIG. 85). Then, a mask 69 having openings in areas corresponding to a future drain region and source regions of the TLPM to be formed in the first p-well region 52 and an area in which the intended NMOS is formed on the substrate surface, and the substrate 51 is doped with As₇₅ (see FIG. 86). After the mask 69 is removed, a mask 70 having openings in areas corresponding to future plug regions of the TLPM to be formed in the first p-well region 52 and a future drain region and source regions of the TLPM to be formed in the n-well region 54 is formed on the substrate surface and the substrate 51 is doped with B₁₁ (see FIG. 87).

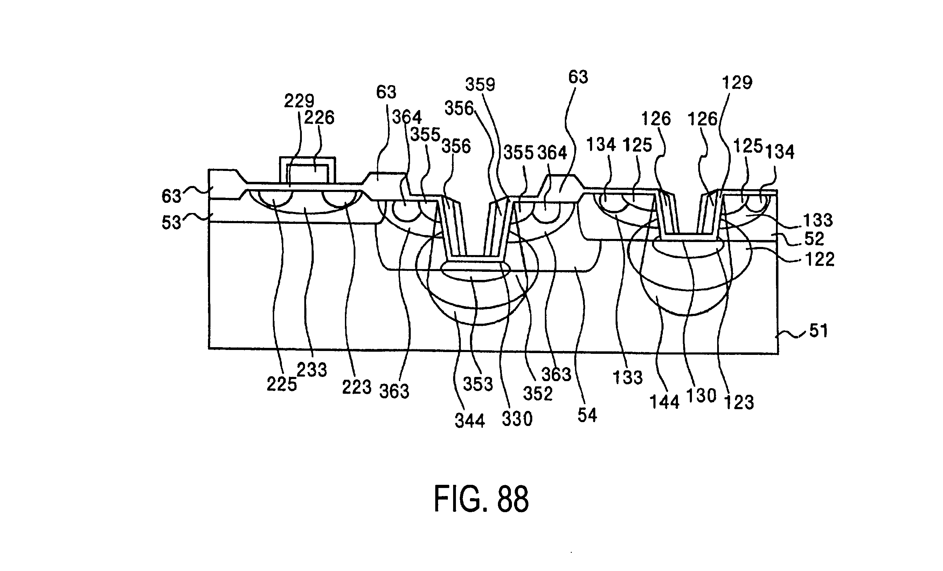

The mask 70 is removed and thermal diffusion is performed. Thus, a drain region 123, source regions 125, and plug regions 134 of the TLPM to be formed in the first p-well region 52, a source region 225 and a drain region 223 of the intended NMOS, and a drain region 353, source regions 355, and plug regions 364 of the TLPM to be formed in the n-well region 54 are formed at the same time. (see FIG. 88). The operations of FIG. 86 and FIG. 87 may be reversed.

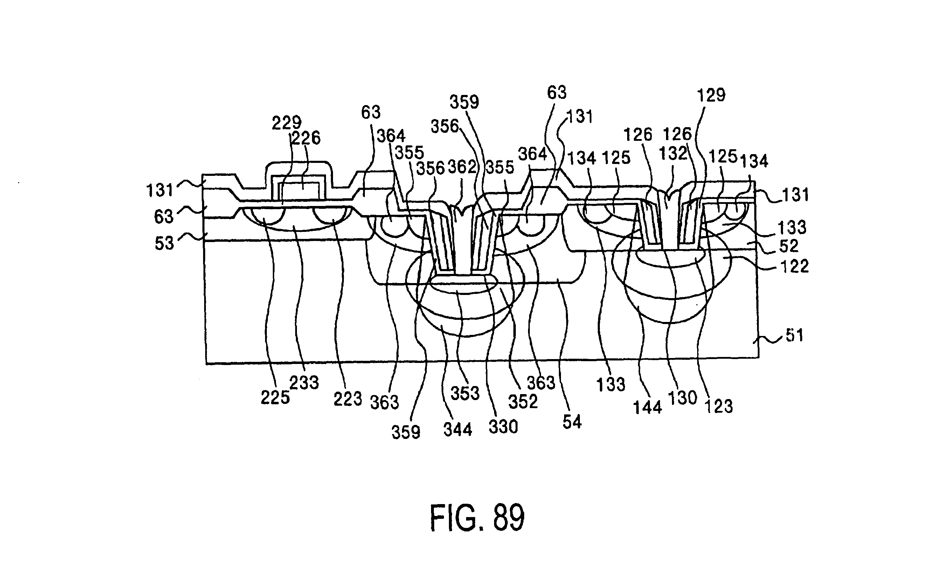

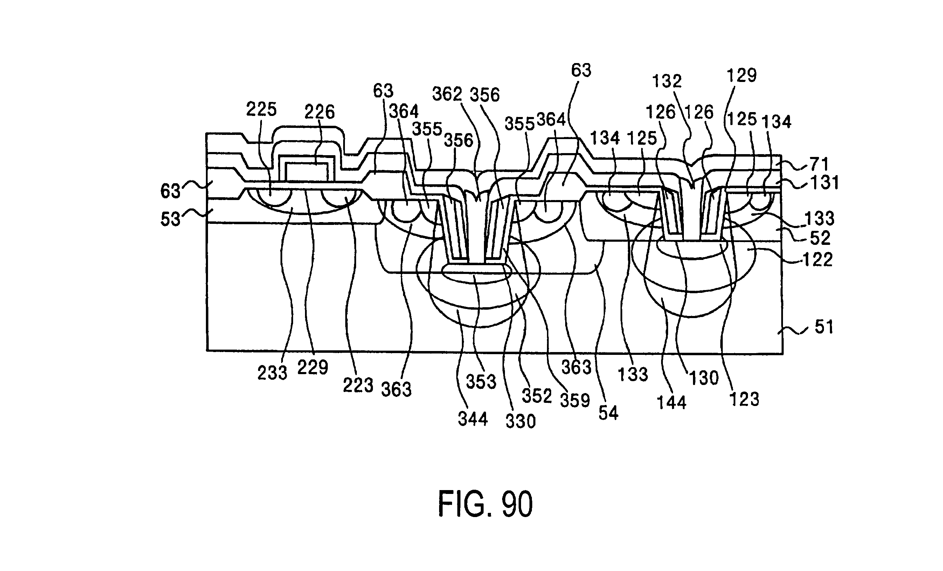

Subsequently, an interlayer insulating film 131 is laid over the substrate surface, and portions of the interlayer insulating film 131 inside the respective trenches 130 and 330 are etched away by self-alignment to form contact holes, which are then filled with respective drain polysilicon layers 132 and 362 (see FIG. 89). A passivation film 71 is formed over the substrate surface (see FIG. 90).

Subsequently, the passivation film 71 is patterned to form contact holes. A metal film is formed on the passivation film 71 and then patterned, whereby a drain electrode 127 and source electrodes 128 of the TLPM to be formed in the first p-well region 52, a drain electrode 357 and source electrodes 358 of the TLPM to be formed in the n-well region 54, and a drain electrode 227 and a source electrode 228 of the intended NMOS are formed at the same time. In this manner, a semiconductor device is completed in which the TLPM 100, the NMOS 200, and the TLPM 301 are integrated on the same semiconductor substrate 51 as shown in FIG. 71. Although in the example of FIG. 71 the p-well region 52 where the TLPM 100 is formed and the n-well region 54 where the TLPM 301 is formed are adjacent to each other, the semiconductor device can be manufactured in the same manner even where the TLPMs 100 and 301 are not adjacent to each other.

In the TLPM 100 shown in Fig. 71, even where the impurity concentration of the extended drain region 122 is increased to lower the on-resistance, the breakdown voltage can be kept high by making the first p-well region 52 deeper than the extended drain region 122.

In Fig. 71, in the case where a DC-DC converter having the n-type TLPM 100 and the p-type TLPM 301 is to be formed, the n-well region 54 is made deeper than the extended drain region 352 and the extended drain region 352 is formed in the n-well region 54, which provides the following advantage. To form a DC-DC converter, it is necessary to give the same potential to the drain electrodes 127 and 357 of the n-type TLPM 100 and the p-type TLPM 301. Therefore, if the extended drain region 352 were deeper than the n-well region 54, the extended drain region 352 would be connected to the p-type substrate 51 and they would have the same potential. On the other hand, since the source electrode 128 of the n-type TLPM 100 is at the same potential as the substrate 51, a short-circuit would develop between the source electrode 128 and the drain electrodes 127 and 357 via the substrate 51. The intended function of a DC-DC converter could not be attained. This problem can be avoided by making the n-well region 54 deeper than the extended drain region 352. That is, the extended drain region 352 can be isolated from the substrate 51 and hence a short-circuit does not develop between the source electrode 128 and the drain electrodes 127 and 357.

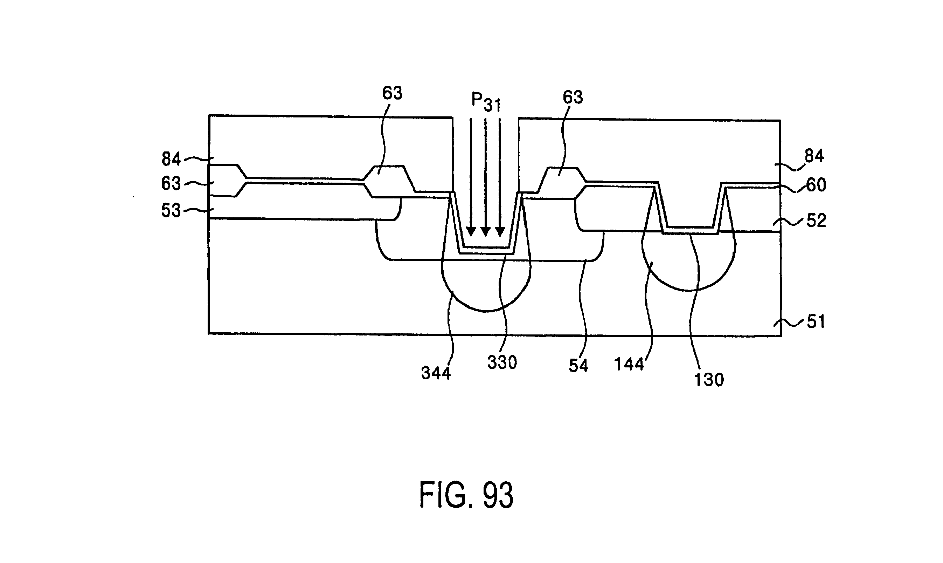

FIG. 91 shows another configuration that is provided with a TLPM 302 in which a n-type body region 354 is formed to surround the extended drain region 352. The TLPM 302 is formed in the following manner. After the field regions 144 and 344 and the selective oxidation films 63 for device isolation are formed, B₁₁ is ion-implanted into a region of the substrate 51 under the bottom surface of the trench 130 in the first p-well region 52 by using a mask 83 (see FIG. 92). After the mask 83 is removed, P₃₁ is ion-implanted into a region of the substrate 51 under the bottom surface of the trench 330 in the n-well region 54 by using a mask 84 (see FIG. 93). The operations of FIG. 92 and FIG. 93 may be reversed.

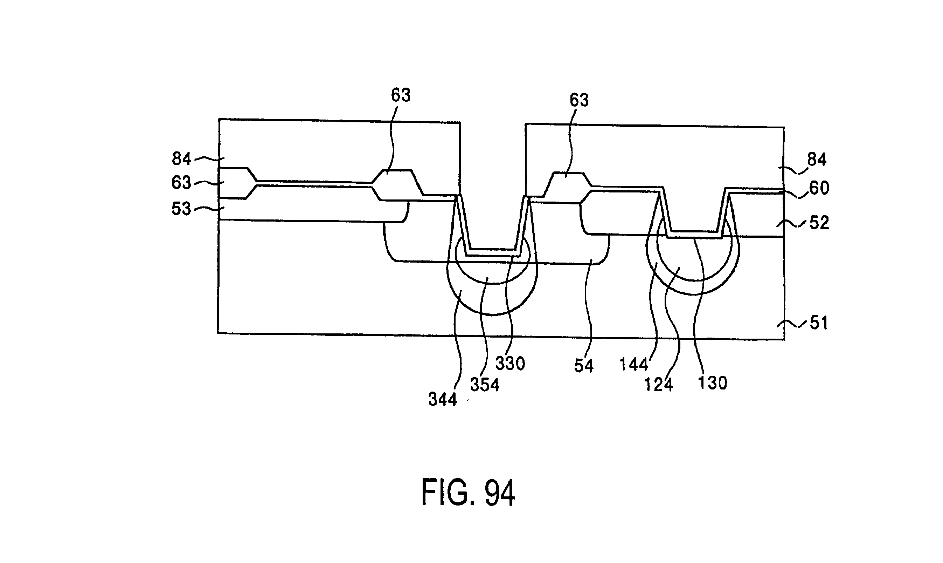

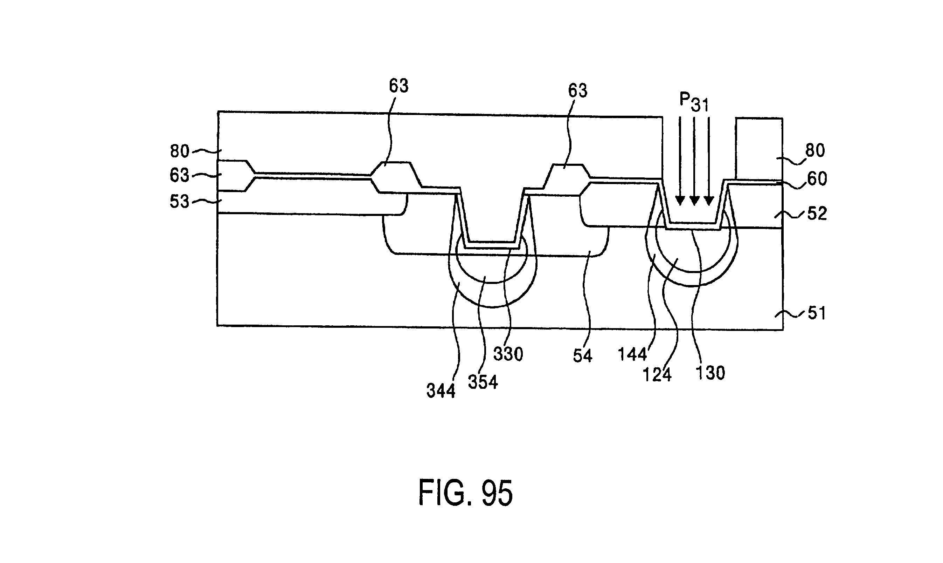

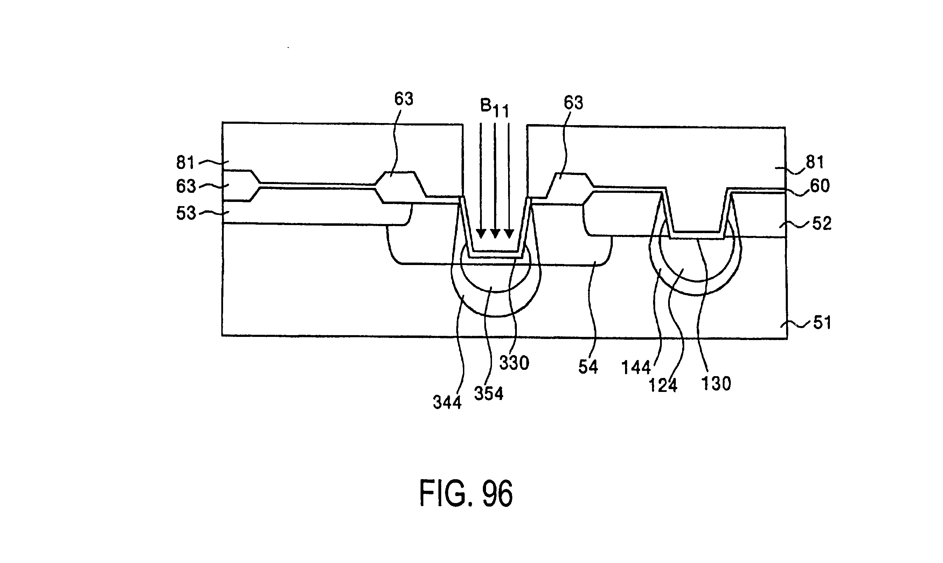

Then, thermal diffusion is performed to form body regions 124 and 354 for the respective trenches 130 and 330 (see FIG. 94). After the mask 84 is removed, P₃₁ is ion-implanted into a region of the substrate 51 under the bottom surface of the trench 130 in the first p-well region 52 by using a mask 80 (see FIG. 95). After the mask 80 is removed, B₁₁ is ion-implanted into a region of the substrate 51 under the bottom surface of the trench 330 in the n-well region 54 by using a mask 81 (see FIG. 96). The operations of FIG. 94 and FIG. 95 may be reversed.

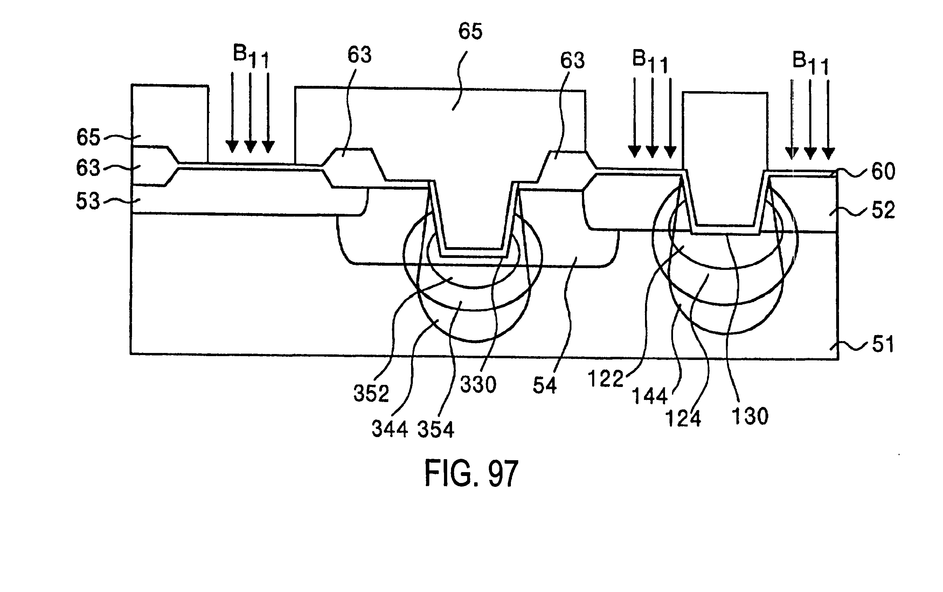

Then, extended drain regions 122 and 352 are formed for the respective trenches 130 and 330 by thermal diffusion. Then, B₁₁ is ion-implanted into channel forming regions of the TLPM to be formed in the first p-well region 52 and an NMOS forming region of the second p-well region 53 (see FIG. 97). The operations of FIGS. 80-90 are then executed in order and drain electrodes and source electrodes are formed.

The invention is not limited to the above embodiments and various modifications are possible. For example, in each of the above embodiments, the p-type regions may be replaced by n-type regions and vice versa. In some of the above embodiments, two p-well regions and one n-well region are employed. However, the numbers of p-well regions and n-well regions are not limited to two and one, respectively. The depth and the width of each trench may be determined as appropriate, whereby a TLPM of an arbitrary output stage can be obtained.

According to preferred embodiments of the invention, the gate electrodes of a TLPM and the gate electrodes of planar devices are formed by patterning the same polysilicon layer, and the drain electrode(s) and the source electrode(s) of the TLPM and the drain electrodes and the source electrodes of the planar devices are formed by patterning the same metal layer. Therefore, the TLPM and the planar devices can be connected electrically to each other by resulting metal wiring layers and polysilicon layers. Unlike conventional cases, it is not necessary to perform wire bonding on a printed circuit board. As a result, a small, low-cost one-chip power IC can be obtained low in on-resistance.

## Claims

1. A manufacturing method of a semiconductor device comprising at least one trench lateral power MOSFET (100; 101; 102; 103) on a semiconductor substrate (51), comprising a first gate oxide film (129) and first gate electrodes (126) that are positioned in a trench (130), a first drain region (123) positioned under a bottom surface of the trench (130), first source regions (125) positioned on both sides of the trench (130), an extended drain region (122) positioned between the first drain region (123) and the first source regions (125), a first drain electrode (127) connected electrically to the first drain region (123), and first source electrodes (128) connected electrically to the respective first source regions (125), and at least one planar MOSFET (200, 300) positioned on the semiconductor substrate (51), comprising a second gate oxide film (229, 329) and a second gate electrode (226, 326) that are positioned on a surface of the semiconductor substrate (51), a second drain region (223, 323) and a second source region (225, 325) that are positioned in a surface layer of the semiconductor substrate (51) on both sides of the second gate electrode (226, 326), a second drain electrode (227, 327) connected electrically to the second drain region (223, 323), and a second source electrode (228, 328) connected electrically to the second source region (225, 325), the manufacturing method comprising:
forming the trench (130) in the semiconductor substrate (51);
forming the extended drain region (122);
forming the first gate oxide film (129) and the second gate oxide film (229, 329);
forming first gate electrodes (126) and the second gate electrode (226, 326);
forming the first drain region (123), first source regions (125), the second drain region (223, 323), and the second source region (225, 325);
laying an interlayer insulating film (131) over the surface of the semiconductor substrate (51);
etching the interlayer insulating film (131) to expose the first drain region (123) under the bottom surface of the trench (130);
filling the inside of the trench (130) with a polysilicon layer (132) that is in contact with the first drain region (123);
laying a passivation film (71) over the surface of the semiconductor substrate (51);
etching the passivation film (71) and the interlayer insulating film (131) to expose the polysilicon layer (132), the first source regions (125), the second drain region (223, 323), and the second source region (225, 325); and
laying a metal layer on the passivation film (71) and patterning the metal layer to form the first drain electrode (127), first source electrodes (128), the second drain electrode (227, 327), and the second source electrode (228, 328) that are in contact with the polysilicon layer (132), the first source regions (125), the second drain region (223, 323), and the second source region (225, 325), respectively.

2. The manufacturing method according to claim 1, wherein the polysilicon layer (132) is laid over the surface of the semiconductor substrate (51) after the first gate oxide film (129) and the second gate oxide film (229, 329) have been formed, and then the polysilicon layer (132) is patterned to form the first gate electrodes (126) and the second gate electrode (226, 326) simultaneously.

3. The manufacturing method according to claim 1, wherein the first gate oxide film (129) and the second gate oxide film (229, 329) are formed simultaneously by forming an oxide film over the surface of the semiconductor substrate (51) after the extended drain region (122) has been formed.

4. The manufacturing method according to claim 1, wherein a well region (52) is formed in the semiconductor substrate (51), and then the trench (130) is formed in the well region (52).

5. The manufacturing method according to claim 1, wherein after the trench (130) is formed in the semiconductor substrate (51), impurity diffusion is performed through the trench (130) to form a well region that surrounds the trench (130).

6. The manufacturing method according to claim 1, wherein selective oxidation films (63) for device isolation are formed after the trench (130) has been formed in the semiconductor substrate (51).

7. The manufacturing method according to claim 1, wherein the trench (130) is formed after selective oxidation films for device isolation have been formed on the semiconductor substrate (51).

## Patentansprüche

1. Herstellungsverfahren für eine Halbleitervorrichtung, enthaltend mindestens einen Trench-lateral-Leistungs-MOSFET (100; 101; 102; 103) auf einem Halbleitersubstrat (51), enthaltend einen ersten Gate-Oxidfilm (129) und erste Gate-Elektroden (126), die in einem Trench (130) angeordnet sind, eine erste, unter einer Bodenfläche des Trench (130) angeordnete Drain-Region (123), erste Source-Regionen (125), die an beiden Seiten des Trench (130) angeordnet sind, eine erweiterte Drain-Region (122), die zwischen der ersten Drain-Region (123) und den ersten Source-Regionen (125) angeordnet ist, eine erste Drain-Elektrode (127), die mit der ersten Drain-Region (123) elektrisch verbunden ist, und erste Source-Elektroden (128), die mit den jeweiligen ersten Source-Regionen (125) elektrisch verbunden sind, sowie mindestens einen planaren MOSFET (200, 300), der auf dem Halbleitersubstrat (51) angeordnet ist, enthaltend einen zweiten Gate-Oxidfilm (229, 329) und eine zweite Gate-Elektrode (226, 326), die auf einer Oberfläche des Halbleitersubstrats (51) angeordnet sind, eine zweite Drain-Region (223, 323) und eine zweite Source-Region (225, 325), die in einer Oberflächenschicht des Halbleitersubstrats (51) auf beiden Seiten der zweiten Gate-Elektrode (226, 326) angeordnet sind, eine zweite Drain-Elektrode (227, 327), die mit der zweiten Drain-Region (223, 323) elektrisch verbunden ist, und eine zweite Source-Elektrode (228, 328), die mit der zweiten Source-Region (225, 325) elektrisch verbunden ist, welches Herstellungsverfahren enthält:
Bilden des Trench (130) in dem Halbleitersubstrat (51);
Bilden der erweiterten Drain-Region (122);
Bilden des ersten Gate-Oxidfilms (129) und das zweiten Gate-Oxidfilms (229, 329);
Bilden der ersten Gate-Elektroden (126) und der zweiten Gate-Elektrode (226, 326);
Bilden der ersten Drain-Region (123), erster Source-Regionen (125), der zweiten Drain-Region (223, 323) und der zweiten Source-Region (225, 325);
Aufbringen eines Zwischenschicht-Isolierfilms (131) über der Oberfläche des Halbleitersubstrats (51);
Ätzen des Zwischenschicht-Isolierfilms (131), um die erste Drain-Region (123) unter der Bodenfläche des Trench (130) freizulegen;
Füllen der Innenseite des Trench (130) mit einer Polysiliciumschicht (132), die mit der ersten Drain-Region (123) in Kontakt ist;
Aufbringen eines Passivierungsfilms (71) über der Oberfläche des Halbleitersubstrats (51);
Ätzen des Passivierungsfilms (71) und des Zwischenschicht-Isolierfilms (131), um die Polysiliciumschicht (132), die ersten Source-Regionen (125), die zweite Drain-Region (223, 323) und die zweite Source-Region (225, 325) freizulegen; und
Aufbringen einer Metallschicht auf dem Passivierungsfilm (71) und Musterbildung in der Metallschicht, um die erste Drain-Elektrode (127), die erste Source-Elektroden (128), die zweite Drain-Elektrode (227, 327) und die zweite Source-Elektrode (228, 328) zu bilden, die mit der Polysiliciumschicht (132), den ersten Source-Regionen (125), der zweiten Drain-Region (223, 323) beziehungsweise der zweiten Source-Region (225, 325) in Kontakt stehen.

2. Herstellungsverfahren nach Anspruch 1, bei welchem die Polysiliciumschicht (132) nach der Bildung des ersten Gate-Oxidfilms (129) und das zweiten Gate-Oxidfilms (229, 329) über die Oberfläche des Halbleitersubstrats (51) gelegt wird, wonach die Polysiliciumschicht (132) mit einem Muster versehen wird, um die ersten Gate-Elektroden (126) und die zweiten Gate-Elektroden (226, 326) gleichzeitig zu bilden.

3. Herstellungsverfahren nach Anspruch 1, bei welchem der erste Gate-Oxidfilm (129) und der zweite Gate-Oxidfilm (229, 329) gleichzeitig gebildet werden, indem ein Oxidfilm über der Oberfläche des Halbleitersubstrats (51) gebildet wird, nachdem die erweiterte Drain-Region (122) gebildet wurde.

4. Herstellungsverfahren nach Anspruch 1, bei welchem eine Wannenregion (52) in dem Halbleitersubstrat (51) gebildet wird und anschließend der Trench (130) in der Wannenregion (52) gebildet wird.

5. Herstellungsverfahren nach Anspruch 1, bei welchem nach der Bildung des Trench (130) in dem Halbleitersubstrat (51) eine Störstellendiffusion durch den Trench (130) durchgeführt wird, um eine den Trench (130) umgebende Wannenregion zu bilden.

6. Herstellungsverfahren nach Anspruch 1, bei welchem selektive Oxidationsfilme (63) zur Bauelementisolierung gebildet werden, nachdem der Trench (130) in dem Halbleitersubstrat (51) gebildet wurde.

7. Herstellungsverfahren nach Anspruch 1, bei welchem der Trench (130) gebildet wird, nachdem selektive Oxidationsfilme (63) zur Bauelementisolierung auf dem Halbleitersubstrat (51) gebildet wurden.

## Revendications

1. Procédé de production d'un dispositif à semi-conducteur comprenant au moins un MOSFET (100 ; 101 ; 102 ; 103) de puissance latérale à sillon sur un substrat (51) semi-conducteur, comprenant un premier film (129) d'oxyde de cuivre et de premières électrodes (126) de grille qui sont mises en position dans un sillon (130), une première région (123)de drain mise en position sous une surface de fond du sillon (130), de premières régions (125) de source mises en position des deux côtés du sillon (130), une région (122) prolongée de drain mise en position entre la première région (123) de drain et les premières régions (125) de source, une première électrode (127) de drain reliée électriquement à la première région (123) de drain et des premières électrodes (128) de source reliées électriquement aux premières régions (125) de source respectives et au moins un MOSFET (200, 300) planaire mis en position sur le substrat (51) semi-conducteur, comprenant un deuxième film (229, 329) d'oxyde de grille et une deuxième électrode (226, 326) de grille qui sont mis en position sur une surface du substrat (51) semi-conducteur, une deuxième région (223, 323) de drain et une deuxième région (225, 325) de source qui sont mises en position sur une couche de surface du substrat (51) semi-conducteur des deux côtés de la deuxième électrode (226, 326) de grille, une deuxième électrode (227, 327) de drain reliée électriquement à la deuxième région (223, 323) de drain et une deuxième électrode (228, 328) de source reliée électriquement à la deuxième région (225, 325) de source, le procédé de fabrication comprenant les stades dans lesquels :
on forme le sillon (130) dans le substrat (51) semi-conducteur ;
on forme la région (122) prolongée de drain ;
on forme le premier film (129) d'oxyde de grille et le deuxième film (229, 329) d'oxyde de grille ;
on forme les premières électrodes (126) de grille et la deuxième électrode (226, 326) de grille ;
on forme la première région (123) de drain, les premières régions (125) de source, la deuxième région (223, 323) de drain et la deuxième région 225, 325) de source ;
on met un film (131) isolant d'intercouche sur la surface du substrat (51) semi-conducteur ;
on attaque le film (131) isolant d'intercouche pour dégager la première région (123) de drain sous la surface de fond du sillon (130) ;
on remplit l'intérieur du sillon (130) d'une couche (132) de polysilicium qui est en contact avec la première région (123) de drain ;
on met un film (71) de passivation sur la surface du substrat (51) semi-conducteur ;
on attaque le film (71) de passivation et la couche (131) d'intercouche isolante pour dégager la couche (132) de polysilicium, les premières régions (125) de source, la deuxième région (223, 323) de drain et la deuxième région (225, 325) de source ; et
on met une couche métallique sur le film (71) de passivation et on structure la couche métallique pour former la première électrode (127) de drain, les premières électrodes (128) de source, la deuxième électrode (227, 327) de drain et la deuxième électrode (228, 328) de source qui sont en contact avec la couche (132) de polysilicium, avec les premières régions (125) de source, avec la deuxième région (223, 323) de drain et avec la deuxième région (225, 325) de source, respectivement.

2. Procédé de production suivant la revendication 1, dans lequel on met la couche (132) de polysilicium sur la surface du substrat (51) semi-conducteur après avoir formé le premier film (129) d'oxyde de grille et le deuxième film (229, 329) d'oxyde de grille, puis on structure la couche (132) de polysilicium pour former les premières électrodes (126) de grille et la deuxième électrode (226, 326) de grille simultanément.

3. Procédé de production suivant la revendication 1, dans lequel on forme en même temps le premier film (129) d'oxyde de grille et le deuxième film (229, 329) d'oxyde de grille en formant un film d'oxyde sur la surface du substrat (51) semi-conducteur après avoir formé la région (122) prolongée de drain.

4. Procédé de production suivant la revendication 1, dans lequel on forme une région (52) de puits dans le substrat (51) semi-conducteur, puis on forme le sillon (130) dans la région (52) de puits.

5. Procédé de production suivant la revendication 1, dans lequel après avoir formé le sillon (130) dans le substrat (51) semi-conducteur on effectue une diffusion d'impuretés à travers le sillon (130) pour former une région de puits qui entoure le sillon (130).

6. Procédé de production suivant la revendication 1, dans lequel on forme des films (63) sélectifs d'oxydation pour isoler le dispositif après que le sillon (130) a été formé dans le substrat (51) semi-conducteur.

7. Procédé de production suivant la revendication 1, dans lequel on forme le sillon (130) après avoir formé sur le substrat (51) semi-conducteur des films d'oxydation sélectifs pour isoler le dispositif.
